(19) Europäisches Patentamt / European Patent Office / Office européen des brevets

(11) **EP 3 922 456 A1**

(12) **EUROPEAN PATENT APPLICATION**
published in accordance with Art. 153(4) EPC


(43) Date of publication:
**15.12.2021 Bulletin 2021/50**

(21) Application number: **20752770.6**

(22) Date of filing: **22.01.2020**

(51) Int Cl.:
***B32B 27/06*** *(2006.01)*
***C08G 61/06*** *(2006.01)*
***G03F 7/11*** *(2006.01)*
***G03F 7/26*** *(2006.01)*
***H01L 21/027*** *(2006.01)*
***B32B 7/027*** *(2019.01)*
***B32B 3/30*** *(2006.01)*

(86) International application number:
**PCT/JP2020/002157**

(87) International publication number:
**WO 2020/162183 (13.08.2020 Gazette 2020/33)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.02.2019 JP 2019020570**
**11.09.2019 JP 2019165498**



(71) Applicant: **Mitsui Chemicals, Inc.**
**Tokyo 105-7122 (JP)**

(72) Inventors:
- **INOUE Koji**
  **Sodegaura-shi, Chiba 299-0265 (JP)**
- **KAWASHIMA Keisuke**
  **Sodegaura-shi, Chiba 299-0265 (JP)**
- **FUJII Kenichi**
  **Sodegaura-shi, Chiba 299-0265 (JP)**
- **ODA Takashi**
  **Sodegaura-shi, Chiba 299-0265 (JP)**

(74) Representative: **Hoffmann Eitle**
**Patent- und Rechtsanwälte PartmbB**
**Arabellastraße 30**
**81925 München (DE)**


(54) **MATERIAL FOR UNDERLAYER FILM FORMATION USE, RESIST UNDERLAYER FILM, AND LAMINATE**


(57) A material for forming an underlayer film used in a multi-layer resist process satisfies: (i) an elemental composition ratio Re defined by the following mathematical formula (1) is 1.5 to 2.8; (ii) a glass transition temperature is 30°C to 250°C; and (iii) the material contains at least one (preferably two or more) resin having a specific structural unit. In the mathematical formula (1), $N_H$ is the number of hydrogen atoms in the solid content of the material for forming an underlayer film, $N_C$ is the number of carbon atoms in the solid content of the material for forming an underlayer film, and $N_O$ is the number of oxygen atoms in the solid content of the material for forming an underlayer film.

$$Re = \frac{N_H + N_C + N_O}{N_C - N_O} \qquad (1)$$


Fig.1

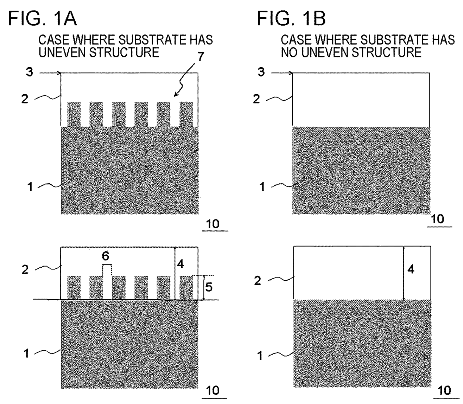


EP 3 922 456 A1

## Description

TECHNICAL FIELD

The present invention relates to a material for forming an underlayer film, a resist underlayer film, and a laminate.

BACKGROUND ART

In production of a semiconductor device, a multi-layer resist process has been used to achieve a high degree of integration. In this process, typically, a resist underlayer film is firstly formed on a substrate using a material for forming an underlayer film, a resist layer is formed on an upper surface side of the resist underlayer film, and then a resist pattern is formed. Next, a desired pattern is obtained by transferring the resist pattern to the resist underlayer film through etching and transferring the resist underlayer film pattern to the substrate.
As the substrate, not only a substrate having a flat shape but also a substrate having an uneven structure in a large circuit shape preliminarily formed in order to form a more complicated circuit may be used. That is, a multi-patterning method for forming a fine circuit by further processing a circuit shape having a large dimensional size has been introduced in the most advanced circuit forming process.
The resist underlayer film used in such a multi-layer resist process is required to have optical characteristics such as an embedding property for an uneven portion of a substrate having an uneven structure, the flatness of a surface on a side where a resist layer is formed, a moderate refractive index, and an extinction coefficient, and characteristics such as excellent etching resistance.
In recent years, pattern refinement has been further promoted in order to increase the degree of integration. In order to deal with such refinement, various examinations have been conducted on structures, functional groups, and the like of compounds used in materials for forming underlayer films (for example, see Patent Documents 2, 3, 4, and the like).

RELATED DOCUMENT

PATENT DOCUMENT

[Patent Document 1] Japanese Unexamined Patent Publication No. 2004-177668
[Patent Document 2] International Publication No. WO2009/008446
[Patent Document 3] International Publication No. WO2018/221575
[Patent Document 4] International Publication No. WO2017/183612

SUMMARY OF THE INVENTION

TECHNICAL PROBLEM

Recently, the number of cases of forming finer structures with multi-patterning according to a multi-layer resist method, using a substrate that has a fine uneven structure, has been increasing. Specifically, in some cases, a flat resist underlayer film is formed by filling the unevenness of a substrate having an uneven structure with a material for forming an underlayer film, and then an intermediate layer or a resist layer is provided on the resist underlayer film.
In multi-patterning by the multi-layer resist method, it is sometimes required that the resist underlayer film itself exhibits a performance as a hard mask having sufficient etching resistance.
Further, in a case where the substrate has a fine uneven structure, the material for forming an underlayer film is required to be able to embed the uneven structure and to generate few voids.
Furthermore, the surface of the resist underlayer film formed by embedding the uneven structure of the substrate is required to be flat regardless of the uneven structure (step) of the substrate. This is because an intermediate layer or a resist layer is formed on the upper layer of the resist underlayer film. In a case where the flatness is insufficient, the desired fine structure may not be finally obtained.
As the findings of the present inventors, there has been room for improvement in the conventional materials for forming an underlayer film from the viewpoints of etching resistance, embedding property of uneven structure, and flatness.
The present invention has been made in view of the above circumstances. In particular, an object of the present invention is to provide a material for forming an underlayer film, which has sufficient etching resistance, has good

embedding property of an uneven structure, and capable of forming a flat resist underlayer film.

SOLUTION TO PROBLEM

The present inventors have found that the material for forming an underlayer film can be improved by using a specific resin, using two or more specific resins in combination, and the like.

The present invention includes the following aspects.

1. A material for forming an underlayer film used in a multi-layer resist process, in which a solid content of the material for forming an underlayer film satisfies the following (i) to (iii):

(i) an elemental composition ratio Re defined by the following mathematical formula (1) is 1.5 to 2.8;
(ii) a glass transition temperature is 30°C to 250°C; and
(iii) the solid content contains a resin having a structural unit represented by the following general formula (A) and a resin having a structural unit represented by the following general formula (B),

$$\mathrm{Re} = \frac{N_H + N_C + N_O}{N_C - N_O} \qquad (1)$$

in the mathematical formula (1),

$N_H$ is the number of hydrogen atoms in the solid content of the material for forming an underlayer film,
$N_C$ is the number of carbon atoms in the solid content of the material for forming an underlayer film, and
$N_O$ is the number of oxygen atoms in the solid content of the material for forming an underlayer film,

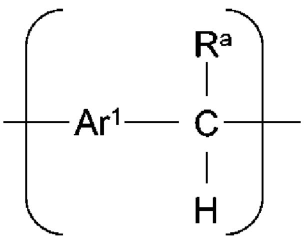

(A)

in the general formula (A),
$Ar^1$ represents a divalent aromatic group at least substituted with a hydroxy group and/or a glycidyloxy group, and
$R^a$ represents any substituent selected from a hydrogen atom, an alkyl group having 1 to 10 carbon atoms, an aryl group having 6 to 10 carbon atoms, an aralkyl group having 7 to 10 carbon atoms, an alkoxyalkyl group having 2 to 10 carbon atoms, and an aryloxyalkyl group having 7 to 10 carbon atoms,

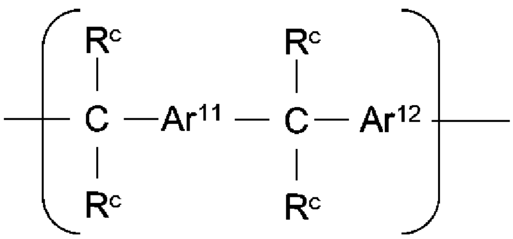

(B)

in the general formula (B),
each $R^c$ independently represents a hydrogen atom, an alkyl group having 1 to 10 carbon atoms, an aryl group having 6 to 10 carbon atoms, an aralkyl group having 7 to 10 carbon atoms, an alkoxyalkyl group having 2 to 10 carbon atoms, or an aryloxyalkyl group having 7 to 10 carbon atoms,
$Ar^{11}$ represents a divalent aromatic group which may be substituted or unsubstituted, and
$Ar^{12}$ represents any of structures represented by the following general formulas (B1) to (B3),

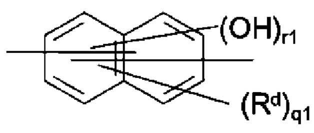
(B1)

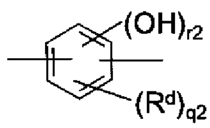
(B2)

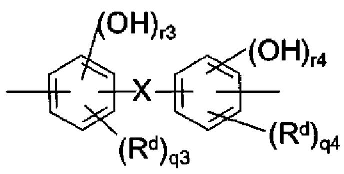
(B3)

in the general formulas (B1) to (B3),
in a case where a plurality of $R^d$ are present, each $R^d$ independently represents any selected from an alkyl group having 1 to 10 carbon atoms, an aryl group having 6 to 20 carbon atoms, an alkoxy group having 1 to 10 carbon atoms, an aryloxy group having 6 to 20 carbon atoms, an alkoxyalkyl group having 2 to 10 carbon atoms, an aryloxyalkyl group having 7 to 20 carbon atoms, an alkoxycarbonyl group having 2 to 20 carbon atoms, a dialkylaminocarbonyl group having 3 to 10 carbon atoms, an aryloxycarbonyl group having 7 to 20 carbon atoms, an alkylarylaminocarbonyl group having 8 to 20 carbon atoms, an alkoxycarbonylalkyl group having 3 to 20 carbon atoms, an alkoxycarbonylaryl group having 8 to 20 carbon atoms, an aryloxycarbonylalkyl group having 8 to 20 carbon atoms, an alkoxyalkyloxycarbonyl group having 3 to 20 carbon atoms, and an alkoxycarbonylalkyloxycarbonyl group having 4 to 20 carbon atoms,
r1 is 1 or more and (6-q1) or less,
q1 is 0 or more and 5 or less,
r2 is 1 or more and (4-q2) or less,
q2 is 0 or more and 3 or less,
r3 is 0 or more and 4 or less, r4 is 0 or more and 4 or less, provided that r3 + r4 is 1 or more,
q3 is 0 or more and 4 or less, q4 is 0 or more and 4 or less, provided that q3 + q4 is 7 or less, and
X represents a single bond or an alkylene group having 1 to 3 carbon atoms.

2. The material for forming an underlayer film according to 1., in which the elemental composition ratio Re' defined by the following mathematical formula (2) of the solid content of the material for forming an underlayer film is 1.5 to 2.8,

$$Re' = \frac{N_H + N_C + N_O + \frac{1}{2}N_N}{N_C - (N_O + \frac{1}{2}N_N)} \qquad (2)$$

in the mathematical formula (2),
$N_H$ is the number of hydrogen atoms in the solid content of the material for forming an underlayer film,
$N_C$ is the number of carbon atoms in the solid content of the material for forming an underlayer film,
$N_O$ is the number of oxygen atoms in the solid content of the material for forming an underlayer film, and
$N_N$ is the number of nitrogen atoms in the solid content of the material for forming an underlayer film.

3. The material for forming an underlayer film according to 1. or 2.,
in which the structural unit represented by the general formula (A) includes a structural unit represented by the following general formula (a1) or the general formula (a2):

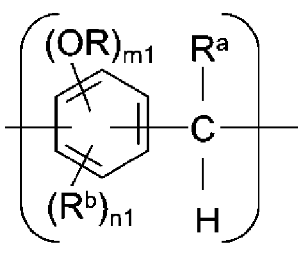
(a1)

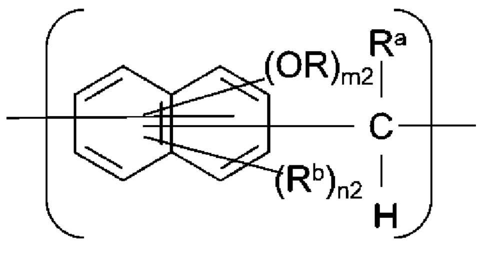
(a2)

in the general formulas (a1) and (a2),

m1 is 1 to 4, n1 is 0 to 3, provided that m1 + n1 is 1 or more and 4 or less,
m2 is 1 to 6, n2 is 0 to 5, provided that m2 + n2 is 1 or more and 6 or less,
in a case where a plurality of R are present, each R independently represents a hydrogen atom or a glycidyl group,
$R^a$ has the same definition as that in the formula (A),
in a case where a plurality of $R^b$ are present, each $R^b$ independently represents any selected from an alkyl group having 1 to 10 carbon atoms, an aryl group having 6 to 20 carbon atoms, an alkoxy group having 1 to 10 carbon atoms, an aryloxy group having 6 to 20 carbon atoms, an alkoxyalkyl group having 2 to 10 carbon atoms, an aryloxyalkyl group having 7 to 20 carbon atoms, an alkoxycarbonyl group having 2 to 20 carbon atoms, a dialkylaminocarbonyl group having 3 to 10 carbon atoms, an aryloxycarbonyl group having 7 to 20 carbon atoms, an alkylarylaminocarbonyl group having 8 to 20 carbon atoms, an alkoxycarbonylalkyl group having 3 to 20 carbon atoms, an alkoxycarbonylaryl group having 8 to 20 carbon atoms, an aryloxycarbonylalkyl group having 8 to 20 carbon atoms, an alkoxyalkyloxycarbonyl group having 3 to 20 carbon atoms, and an alkoxycarbonylalkyloxycarbonyl group having 4 to 20 carbon atoms, and
in a case where n is 2 or more, a plurality of $R^b$ may be bonded to each other to form a ring structure.

4. The material for forming an underlayer film according to any one of 1. to 3., in which the structural unit represented by the general formula (B) includes a structural unit represented by the following general formula (b):

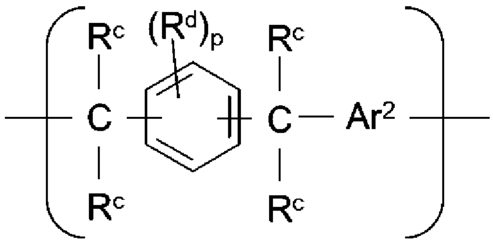
(b)

in the general formula (b),
$R^c$ has the same definition as $R^c$ in the general formula (B), in a case where a plurality of $R^d$ are present, each $R^d$ independently has the same definition as $R^d$ in the general formulas (B1) to (B3),
$Ar^2$ is a structure represented by the general formula (B1) or (B2), and
p is 0 to 4.

5. The material for forming an underlayer film according to any one of 1. to 4., in which the material for forming an underlayer film contains a resin having a structural unit represented by the following general formula (1) in addition to the resin having the structural unit represented by the general formula (A) and the resin having the structural unit represented by the general formula (B),

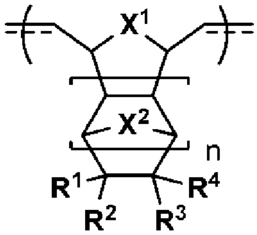
(1)

in the general formula (1),
$R^1$ to $R^4$ are each independently any group selected from the group consisting of a hydrogen atom, an aryl group having 6 to 20 carbon atoms, an aryloxy group having 6 to 20 carbon atoms, an aryloxyalkyl group having 7 to 20 carbon atoms, an aryloxycarbonyl group having 7 to 20 carbon atoms, an alkylarylaminocarbonyl group having 8 to 20 carbon atoms, an alkoxycarbonylaryl group having 8 to 30 carbon atoms, and an aryloxycarbonylalkyl group having 8 to 20 carbon atoms, at least one of $R^1$ to $R^4$ is a group other than a hydrogen atom, and $R^1$ to $R^4$ may be bonded to each other to form a ring structure,
n represents an integer of 0 to 2, and
$X^1$ and $X^2$ each independently represent $-CH_2-$ or -O-.

6. A material for forming an underlayer film used in a multi-layer resist process, in which a solid content of the material for forming an underlayer film satisfies the following (i) to (iii):

(i) an elemental composition ratio Re defined by the following mathematical formula (1) is 1.5 to 2.8;
(ii) a glass transition temperature is 30°C to 250°C; and
(iii) the solid content contains a resin having a structural unit represented by the following general formula (1),

$$\mathrm{Re} = \frac{N_H + N_C + N_O}{N_C - N_O} \qquad (1)$$

in the mathematical formula (1),

$N_H$ is the number of hydrogen atoms in the solid content of the material for forming an underlayer film,

$N_C$ is the number of carbon atoms in the solid content of the material for forming an underlayer film, and

$N_O$ is the number of oxygen atoms in the solid content of the material for forming an underlayer film,

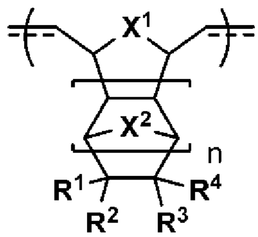

(1)

in the general formula (1),

$R^1$ to $R^4$ are each independently any group selected from the group consisting of a hydrogen atom, an aryl group having 6 to 20 carbon atoms, an aryloxy group having 6 to 20 carbon atoms, an aryloxyalkyl group having 7 to 20 carbon atoms, an aryloxycarbonyl group having 7 to 20 carbon atoms, an alkylarylaminocarbonyl group having 8 to 20 carbon atoms, an alkoxycarbonylaryl group having 8 to 30 carbon atoms, and an aryloxycarbonylalkyl group having 8 to 20 carbon atoms, at least one of $R^1$ to $R^4$ is a group other than a hydrogen atom, and $R^1$ to $R^4$ may be bonded to each other to form a ring structure,

n represents an integer of 0 to 2, and

$X^1$ and $X^2$ each independently represent $-CH_2-$ or -O-.

7. The material for forming an underlayer film according to 6., in which the elemental composition ratio Re' defined by the following mathematical formula (2) of the solid content of the material for forming an underlayer film is 1.5 to 2.8,

$$\mathrm{Re'} = \frac{N_H + N_C + N_O + \frac{1}{2}N_N}{N_C - (N_O + \frac{1}{2}N_N)} \qquad (2)$$

in the mathematical formula (2),
$N_H$ is the number of hydrogen atoms in the solid content of the material for forming an underlayer film,
$N_C$ is the number of carbon atoms in the solid content of the material for forming an underlayer film,
$N_O$ is the number of oxygen atoms in the solid content of the material for forming an underlayer film, and
$N_N$ is the number of nitrogen atoms in the solid content of the material for forming an underlayer film.

8. The material for forming an underlayer film according to 6. or 7.,
in which the material for forming an underlayer film contains a resin having a structural unit represented by the following general formula (B) in addition to the resin having the structural unit represented by the general formula (1),

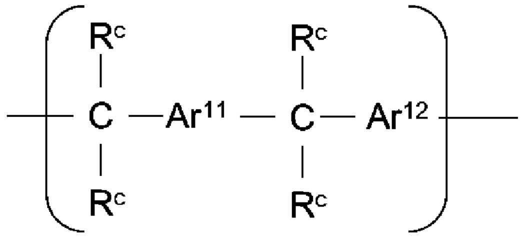

(B)

in the general formula (B),
each $R^c$ independently represents a hydrogen atom, an alkyl group having 1 to 10 carbon atoms, an aryl group having 6 to 10 carbon atoms, an aralkyl group having 7 to 10 carbon atoms, an alkoxyalkyl group having 2 to 10 carbon atoms, or an aryloxyalkyl group having 7 to 10 carbon atoms,
$Ar^{11}$ represents a divalent aromatic group which may be substituted or unsubstituted, and
$Ar^{12}$ represents any of structures represented by the following general formulas (B1) to (B3),

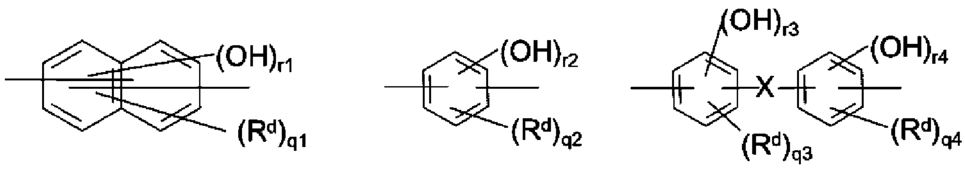

(B1) (B2) (B3)

in the general formulas (B1) to (B3),
in a case where a plurality of $R^d$ are present, each $R^d$ independently represents any selected from an alkyl group having 1 to 10 carbon atoms, an aryl group having 6 to 20 carbon atoms, an alkoxy group having 1 to 10 carbon atoms, an aryloxy group having 6 to 20 carbon atoms, an alkoxyalkyl group having 2 to 10 carbon atoms, an aryloxyalkyl group having 7 to 20 carbon atoms, an alkoxycarbonyl group having 2 to 20 carbon atoms, a dialkylaminocarbonyl group having 3 to 10 carbon atoms, an aryloxycarbonyl group having 7 to 20 carbon atoms, an alkylarylaminocarbonyl group having 8 to 20 carbon atoms, an alkoxycarbonylalkyl group having 3 to 20 carbon atoms, an alkoxycarbonylaryl group having 8 to 20 carbon atoms, an aryloxycarbonylalkyl group having 8 to 20 carbon atoms, an alkoxyalkyloxycarbonyl group having 3 to 20 carbon atoms, and an alkoxycarbonylalkyloxycarbonyl group having 4 to 20 carbon atoms,
r1 is 1 or more and (6-q1) or less,
q1 is 0 or more and 5 or less,
r2 is 1 or more and (4-q2) or less,
q2 is 0 or more and 3 or less,
r3 is 0 or more and 4 or less, r4 is 0 or more and 4 or less, provided that r3 + r4 is 1 or more,
q3 is 0 or more and 4 or less, q4 is 0 or more and 4 or less, provided that q3 + q4 is 7 or less, and
X represents a single bond or an alkylene group having 1 to 3 carbon atoms.

9. The material for forming an underlayer film according to 8.,
in which the structural unit (B) includes a structural unit represented by the following general formula (b):

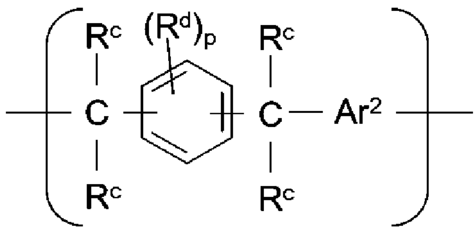

(b)

in the general formula (b),
$R^c$ has the same definition as $R^c$ in the general formula (B),
in a case where a plurality of $R^d$ are present, each $R^d$ independently has the same definition as $R^d$ in the general formulas (B1) to (B3),
$Ar^2$ is a structure represented by the general formula (B1) or (B2), and
p is 0 to 4.

10. The material for forming an underlayer film according to 6. or 7., in which the material for forming an underlayer film contains a resin having a structural unit represented by the following general formula (A) in addition to the resin having the structural unit represented by the general formula (1),

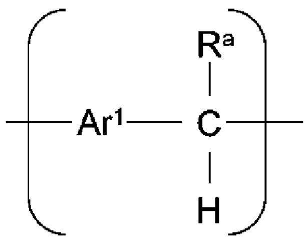
(A)

in the general formula (A),
$Ar^1$ represents a divalent aromatic group at least substituted with a hydroxy group and/or a glycidyloxy group, and
$R^a$ represents any substituent selected from a hydrogen atom, an alkyl group having 1 to 10 carbon atoms, an aryl group having 6 to 10 carbon atoms, an aralkyl group having 7 to 10 carbon atoms, an alkoxyalkyl group having 2 to 10 carbon atoms, and an aryloxyalkyl group having 7 to 10 carbon atoms.

11. The material for forming an underlayer film according to 10., in which the structural unit represented by the general formula (A) includes a structural unit represented by the following general formula (a1) or the general formula (a2):

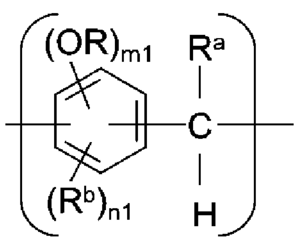
(a1)
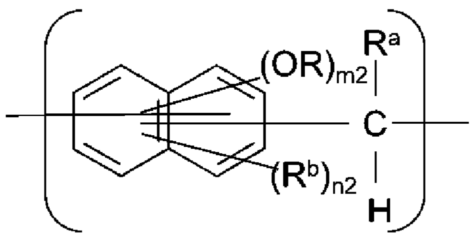
(a2)

in the general formulas (a1) and (a2),
m1 is 1 to 4, n1 is 0 to 3, provided that m1 + n1 is 1 or more and 4 or less,
m2 is 1 to 6, n2 is 0 to 5, provided that m2 + n2 is 1 or more and 6 or less,
in a case where a plurality of R are present, each R independently represents a hydrogen atom or a glycidyl group,
$R^a$ has the same definition as that in the formula (A),
in a case where a plurality of $R^b$ are present, each $R^b$ independently represents any selected from an alkyl group having 1 to 10 carbon atoms, an aryl group having 6 to 20 carbon atoms, an alkoxy group having 1 to 10 carbon atoms, an aryloxy group having 6 to 20 carbon atoms, an alkoxyalkyl group having 2 to 10 carbon atoms, an aryloxyalkyl group having 7 to 20 carbon atoms, an alkoxycarbonyl group having 2 to 20 carbon atoms, a dialkylaminocarbonyl group having 3 to 10 carbon atoms, an aryloxycarbonyl group having 7 to 20 carbon atoms, an alkylarylaminocarbonyl group having 8 to 20 carbon atoms, an alkoxycarbonylalkyl group having 3 to 20 carbon atoms, an alkoxycarbonylaryl group having 8 to 20 carbon atoms, an aryloxycarbonylalkyl group having 8 to 20 carbon atoms, an alkoxyalkyloxycarbonyl group having 3 to 20 carbon atoms, and an alkoxycarbonylalkyloxycarbonyl group having 4 to 20 carbon atoms, and
in a case where n is 2 or more, a plurality of $R^b$ may be bonded to each other to form a ring structure.

12. A resist underlayer film formed of the material for forming an underlayer film according to any one of 1. to 11.
13. A laminate comprising:

a substrate; and
a resist underlayer film formed of the material for forming an underlayer film according to any one of 1, to 11. on one surface of the substrate.

14. The laminate according to 13., in which a flatness ΔFT of a surface α of the resist underlayer film on a side opposite to the substrate which is calculated using the following mathematical formula is 0% to 5%,

$$\Delta FT = \{(H_{max} - H_{min})/H_{av}\} \times 100\ (\%)$$

in the mathematical formula
$H_{av}$ is, when a film thickness of the resist underlayer film is measured at any 10 locations on the surface α, an average value of the film thickness,
$H_{max}$ is a maximum value of the film thickness of the resist underlayer film, and
$H_{min}$ is a minimum value of the film thickness of the resist underlayer film.

15. The laminate according to 13. or 14.,
in which the average value of the film thickness $H_{av}$ when the film thickness of the resist underlayer film is measured at any 10 locations on the surface α of the resist underlayer film is 5 to 500 nm.
16. The laminate according to any one of 13. to 15.,

in which the substrate has an uneven structure on at least one surface thereof,
the resist underlayer film is formed on the uneven structure, and
the uneven structure has a height of 5 to 500 nm, and an interval between projections is 1 nm to 10 mm.

ADVANTAGEOUS EFFECTS OF INVENTION

By using the material for forming an underlayer film of the present invention, it is possible to produce a flat resist underlayer film having excellent etching resistance and good embedding property in an uneven structure.

BRIEF DESCRIPTION OF THE DRAWINGS

Fig. 1 shows schematic views for describing a structure of a laminate, the thickness of a resist underlayer film, the height of an uneven structure, the interval between projections of the uneven structure, and the like.

DESCRIPTION OF EMBODIMENTS

Hereinafter, embodiments of the present invention will be described.
Unless otherwise specified, the description of "x to y" regarding the numerical range represents that "x or more and y or less". For example, the description of "1 to 5%" means 1% or more and 5% or less.
In the notation of groups (atomic groups), the notation that does not indicate whether they are substituted or unsubstituted encompasses both those having a substituent and those having no substituent. For example, the "alkyl group" encompasses not only an alkyl group having no substituent (unsubstituted alkyl group) but also an alkyl group having a substituent (substituted alkyl group) .
The drawings are for illustration purposes only. The shape and dimensional ratio of each part in the drawing do not necessarily correspond to actual articles.
<First Embodiment>
A material for forming an underlayer film of the first embodiment is used for a multi-layer resist process.
The solid content of the material for forming an underlayer film satisfies the following (i) to (iii):

(i) an elemental composition ratio Re defined by the following mathematical formula (1) is 1.5 to 2.8;
(ii) a glass transition temperature is 30°C to 250°C; and
(iii) the solid content contains a resin having a structural unit represented by the following general formula (A) and a resin having a structural unit represented by the following general formula (B) .

$$Re = \frac{N_H + N_C + N_O}{N_C - N_O} \qquad (1)$$

In the mathematical formula (1),
$N_H$ is the number of hydrogen atoms in the solid content of the material for forming an underlayer film,
$N_C$ is the number of carbon atoms in the solid content of the material for forming an underlayer film, and
$N_O$ is the number of oxygen atoms in the solid content of the material for forming an underlayer film.

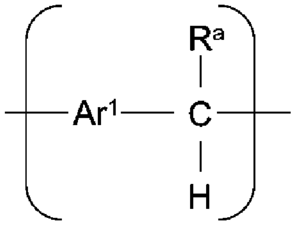
(A)

In the general formula (A),
$Ar^1$ represents a divalent aromatic group at least substituted with a hydroxy group and/or a glycidyloxy group, and
$R^a$ represents any substituent selected from a hydrogen atom, an alkyl group having 1 to 10 carbon atoms, an aryl group having 6 to 10 carbon atoms, an aralkyl group having 7 to 10 carbon atoms, an alkoxyalkyl group having 2 to 10 carbon atoms, and an aryloxyalkyl group having 7 to 10 carbon atoms.

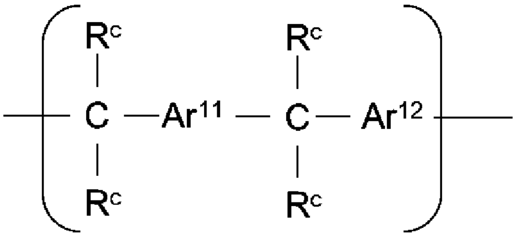
(B)

In the general formula (B),
each $R^c$ independently represents a hydrogen atom, an alkyl group having 1 to 10 carbon atoms, an aryl group having 6 to 10 carbon atoms, an aralkyl group having 7 to 10 carbon atoms, an alkoxyalkyl group having 2 to 10 carbon atoms, or an aryloxyalkyl group having 7 to 10 carbon atoms,
$Ar^{11}$ represents a divalent aromatic group which may be substituted or unsubstituted, and
$Ar^{12}$ represents any of structures represented by the following general formulas (B1) to (B3).

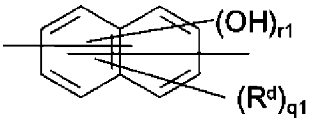
(B1)

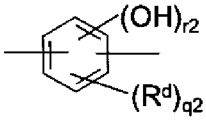
(B2)

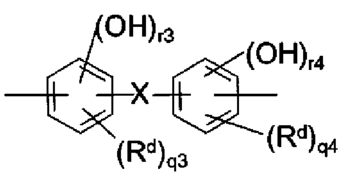
(B3)

In the general formulas (B1) to (B3),

in a case where a plurality of $R^d$ are present, each $R^d$ independently represents any selected from an alkyl group having 1 to 10 carbon atoms, an aryl group having 6 to 20 carbon atoms, an alkoxy group having 1 to 10 carbon atoms, an aryloxy group having 6 to 20 carbon atoms, an alkoxyalkyl group having 2 to 10 carbon atoms, an aryloxyalkyl group having 7 to 20 carbon atoms, an alkoxycarbonyl group having 2 to 20 carbon atoms, a dialkylaminocarbonyl group having 3 to 10 carbon atoms, an aryloxycarbonyl group having 7 to 20 carbon atoms, an alkylarylaminocarbonyl group having 8 to 20 carbon atoms, an alkoxycarbonylalkyl group having 3 to 20 carbon atoms, an alkoxycarbonylaryl group having 8 to 20 carbon atoms, an aryloxycarbonylalkyl group having 8 to 20 carbon atoms, an alkoxyalkyloxycarbonyl group having 3 to 20 carbon atoms, and an alkoxycarbonylalkyloxycarbonyl group having 4 to 20 carbon atoms,

r1 is 1 or more and (6-q1) or less,

q1 is 0 or more and 5 or less,

r2 is 1 or more and (4-q2) or less,

q2 is 0 or more and 3 or less,

r3 is 0 or more and 4 or less, r4 is 0 or more and 4 or less, provided that r3 + r4 is 1 or more,

q3 is 0 or more and 4 or less, q4 is 0 or more and 4 or less, provided that q3 + q4 is 7 or less, and

X represents a single bond or an alkylene group having 1 to 3 carbon atoms.

Here, the "solid content" is a component (nonvolatile component) that does not volatilize and remains on the substrate in a case where the material for forming an underlayer film is applied onto the substrate to form a film.

Generally, the "solid content" can be regarded as all the components other than the solvent in the material for forming an underlayer film.

The material for forming an underlayer film of the first embodiment is a material for forming a "resist underlayer film" to be disposed between a resist layer and a substrate (including a substrate having an uneven structure) in a step of producing a semiconductor device. Here, an intermediate layer such as a hard mask layer or an anti-reflective layer may be disposed between the resist underlayer film and the resist layer.

It can be understood that the elemental composition ratio Re substantially represents the ratio of carbon elements constituting the material.

For example, unsaturated compounds such as aromatic compounds have fewer hydrogen atoms than saturated hydrocarbon structures with similar carbon skeletons. Therefore, the value of the numerator in the formula of Re becomes small, and Re becomes small.

For example, in polyhydroxystyrene (hereinafter abbreviated as PHS), which is an unsaturated compound having relatively high etching resistance as an organic material, $N_C = 8$, $N_H = 8$, and $N_O = 1$, per structural unit, and Re is 2.4. Further, in the form in which all the carbons of the aromatic ring of PHS are hydrogenated, $N_C = 8$, $N_H = 14$, and $N_O = 1$, and Re is 3.3.

The present inventors have found that in the etching of both materials under oxygen gas, the etching rate of PHS is about 0.75 times lower than that of a material obtained by hydrogenating all of the carbon atoms of the aromatic ring of PHS (etching is difficult), and a material having a small Re exhibits good etching resistance.

Incidentally, in the past, the results for examining the relationship between the parameters related to the elemental composition of a material and its etching resistance for various materials have been disclosed (for example, H. Gokan, S. Esho and Y. Ohnishi, J. Electrochem. Soc.: SOLID-STATE SCIENCE AND TECHNOLOGY pp. 143-146, 1983). In this article, it has been reported as an empirical parameter that a material having a small elemental composition ratio has high etching resistance in dry etching with oxygen gas or argon gas. However, the constituent elements are limited to carbon, hydrogen and oxygen.

As a result of studies, the present inventors have found that it is preferable to design a material for forming a layer film using, as a design guideline, a new parameter Re' (mathematical formula below) in which nitrogen is also multiplied by a factor of 1/2 and taken into consideration in addition to the aforementioned parameter Re (in which carbon, hydrogen and oxygen are taken into consideration) . In particular, in a case where the solid content of the material for forming an underlayer film contains a nitrogen atom, a material for forming an underlayer film having higher etching resistance can be obtained by appropriately adjusting Re' in addition to Re.

$$Re' = \frac{N_H + N_C + N_O + \frac{1}{2}N_N}{N_C - (N_O + \frac{1}{2}N_N)} \qquad (2)$$

in the mathematical formula (2),

$N_H$ is the number of hydrogen atoms in the solid content of the material for forming an underlayer film,
$N_C$ is the number of carbon atoms in the solid content of the material for forming an underlayer film,
$N_O$ is the number of oxygen atoms in the solid content of the material for forming an underlayer film, and
$N_N$ is the number of nitrogen atoms in the solid content of the material for forming an underlayer film.

Specifically, Re and Re' are 1.5 to 2.8, preferably 1.5 to 2.6, and more preferably 1.5 to 2.5. By appropriately adjusting Re, a material for forming an underlayer film having higher etching resistance can be obtained.
Re can be obtained, for example, by subjecting a sample obtained by applying an underlayer film forming material to a substrate and heating the material to elemental analysis, using a commercially available elemental analyzer or the like, and calculating the number of each constituent element from the elemental analysis value obtained by the analysis. By doing so, even in a case where the material is subjected to a reaction such as crosslinking due to heating after application, Re can be calculated by reflecting the actual condition of the resist underlayer film at the time of actual dry etching.
The glass transition temperature of the solid content of the material for forming an underlayer film of the first embodiment is 30°C to 250°C, preferably 40°C to 230°C, more preferably 50°C to 200°C, and particularly preferably 50°C to 190°C. As a result, in the baking step after applying the material for forming an underlayer film to the substrate, the solid content in the material for forming an underlayer film appropriately flows to improve the embedding property with respect to the uneven structure of the substrate, and the flatness of the resist underlayer film can be improved. Furthermore, in a case where two or more materials are mixed and used, a uniform resist underlayer film having good compatibility with the resin can be formed in the substrate heating step.
In a case where the glass transition temperature of the solid content is more than 250°C, the flow may not be developed even in a case where heating (baking) is performed, and the flatness may be deteriorated. Further, in a case where the glass transition temperature of the solid content is less than 30°C, the resist underlayer film after baking may flow without maintaining the properties as a solid, and the flatness may be deteriorated.
The glass transition temperature can be measured by a commonly used device such as a differential scanning calorimeter (DSC) or a solid viscoelasticity measuring device. In the case of using DSC, the midpoint of the heat curve representing the phase transition from the solid state to the glass state is used as the normal glass transition temperature, and in the case of a solid viscoelastic measuring device, the peak top of the loss tangent (tan $\delta$), which is the ratio of the storage elastic modulus to the loss elastic modulus, is used as the normal glass transition temperature. Measurement by DSC is preferable because it is easy to measure and can measure even a small amount of sample.
Further, the underlayer film forming material of the first embodiment contains two kinds of resins, a resin having a structural unit represented by the general formula (A) and a resin having a structural unit represented by the general formula (B), so that the underlayer film forming material exhibits good performance. Although the details are unknown, as shown in Comparative Example 3 described below, in a case where only a resin having a structural unit represented by general formula (B) is used as the resin, uniform coating is difficult.
Hereinafter, the material for forming an underlayer film of the first embodiment will be described more specifically.
The structural unit represented by the general formula (A) preferably includes a structural unit represented by the following general formula (a1) or the general formula (a2). In particular, in terms of synthesis/availability and cost, the structural unit represented by the general formula (A) preferably includes the structural unit represented by the following general formula (a1).

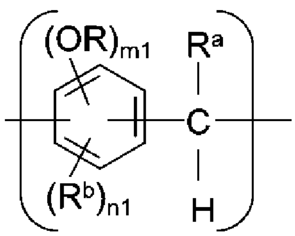 (a1) 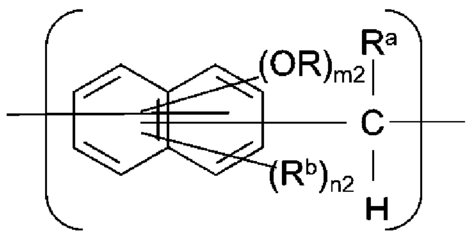 (a2)

In the general formulas (a1) and (a2),

m1 is 1 to 4, n1 is 0 to 3, provided that m1 + n1 is 1 or more and 4 or less,
m2 is 1 to 6, n2 is 0 to 5, provided that m2 + n2 is 1 or more and 6 or less,
in a case where a plurality of R are present, each R independently represents a hydrogen atom or a glycidyl group,
$R^a$ has the same definition as that in the formula (A),
in a case where a plurality of $R^b$ are present, each $R^b$ independently represents any selected from an alkyl group

having 1 to 10 carbon atoms, an aryl group having 6 to 20 carbon atoms, an alkoxy group having 1 to 10 carbon atoms, an aryloxy group having 6 to 20 carbon atoms, an alkoxyalkyl group having 2 to 10 carbon atoms, an aryloxyalkyl group having 7 to 20 carbon atoms, an alkoxycarbonyl group having 2 to 20 carbon atoms, a dialkylaminocarbonyl group having 3 to 10 carbon atoms, an aryloxycarbonyl group having 7 to 20 carbon atoms, an alkylarylaminocarbonyl group having 8 to 20 carbon atoms, an alkoxycarbonylalkyl group having 3 to 20 carbon atoms, an alkoxycarbonylaryl group having 8 to 20 carbon atoms, an aryloxycarbonylalkyl group having 8 to 20 carbon atoms, an alkoxyalkyloxycarbonyl group having 3 to 20 carbon atoms, and an alkoxycarbonylalkyloxycarbonyl group having 4 to 20 carbon atoms, and

in a case where n is 2 or more, a plurality of $R^b$ may be bonded to each other to form a ring structure.

The structural unit represented by the general formula (B) preferably includes a structural unit represented by the following general formula (b).

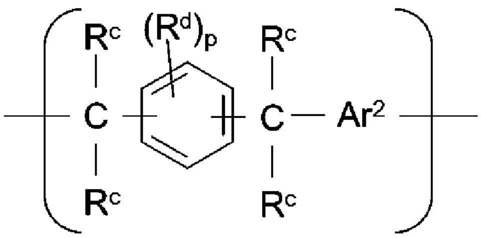

(b)

In the general formula (b),

$R^c$ has the same definition as $R^c$ in the general formula (B), in a case where a plurality of $R^d$ are present, each $R^d$ independently has the same definition as $R^d$ in the general formulas (B1) to (B3),

$Ar^2$ is a structure represented by the general formula (B1) or (B2), and

p is 0 to 4.

Specific examples of the resin having the structural unit represented by the general formula (A) include so-called novolac resin and novolac-type epoxy resin. Examples of the novolac resin include phenol novolac resin, cresol novolac resin, naphthol novolac resin, and the like, but there are no particular restrictions, and various resins used as a resist or an underlayer film can be used. Further, the novolac-type epoxy resin can be produced by converting the hydrogen atom of the phenolic hydroxyl group of the novolac resin into a glycidyl group.

The novolac resin can be produced by a method generally used for producing the novolac resin. For example, it can be obtained by addition-condensing an aromatic compound having a phenolic hydroxyl group and aldehydes under an acid catalyst.

Examples of phenols include phenol, o-cresol, m-cresol, p-cresol, o-ethylphenol, m-ethylphenol, p-ethylphenol, o-butylphenol, m-butylphenol, p-butylphenol, 2,3-xylenol, 2,4-xylenol, 2,5-xylenol, 2,6-xylenol, 3,4-xylenol, 3,5-xylenol, 2,3,5-trimethylphenol, 3,4,5-trimethylphenol, p-phenylphenol, resorcinol, hydroquinone, hydroquinone monomethyl ether, pyrogallol, fluoroglycinol, hydroxydiphenyl, bisphenol A, $\alpha$-naphthol, and $\beta$-naphthol.

Examples of aldehydes include formaldehyde, furfural, benzaldehyde, nitrobenzaldehyde, and acetaldehyde.

The catalyst at the time of the addition condensation reaction is not particularly limited, but for example, hydrochloric acid, nitric acid, sulfuric acid, formic acid, oxalic acid, acetic acid and the like are used as the acid catalyst.

In the first embodiment, a generally commercially available novolac resin or novolac-type epoxy resin may be used.

A specific example of the structural unit represented by the general formula (A) is shown below. In the following, "Gly" represents a glycidyl group.

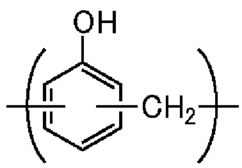
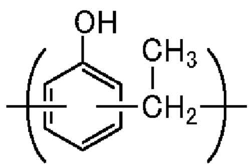
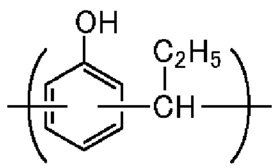

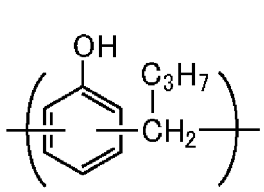
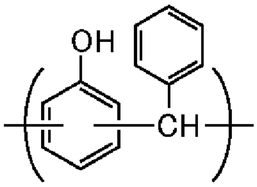
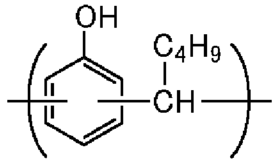

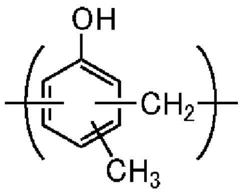
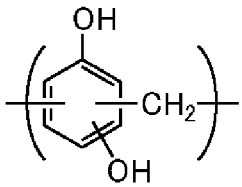
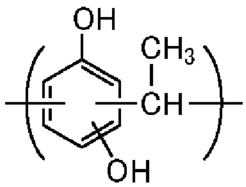

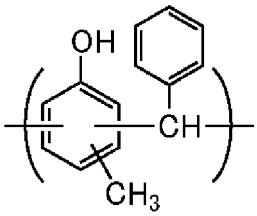
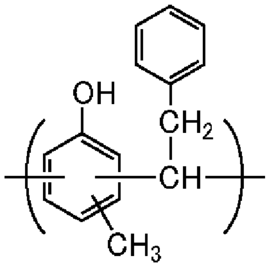
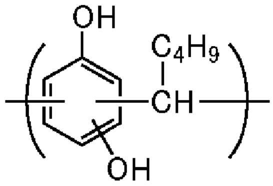

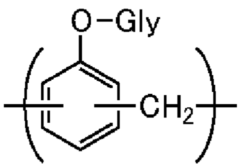
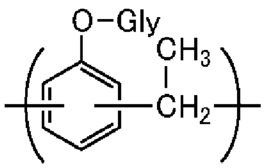
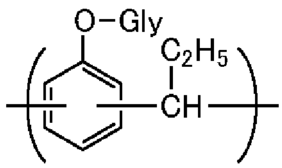

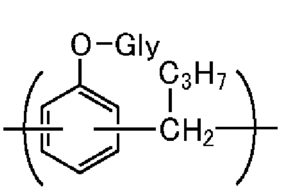
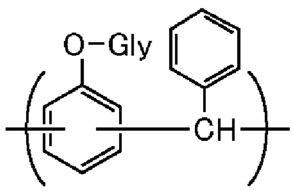
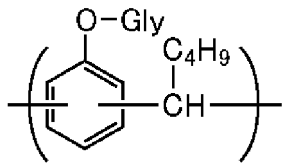

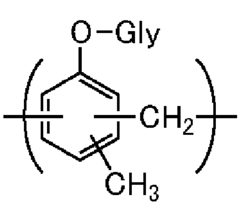
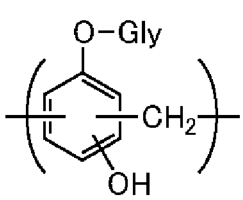
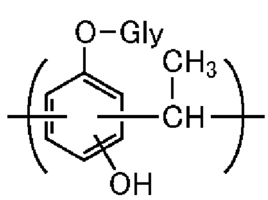

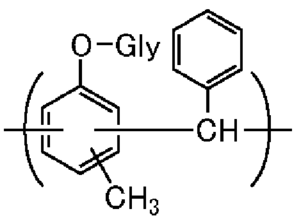
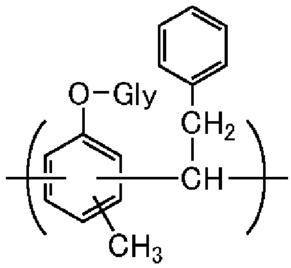
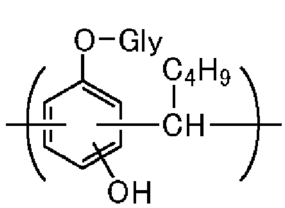

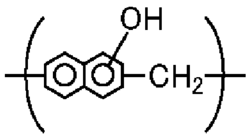
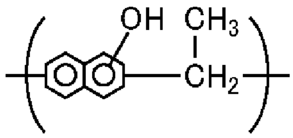
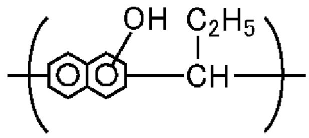

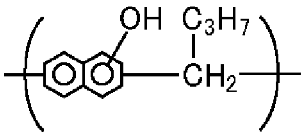
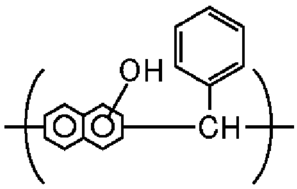
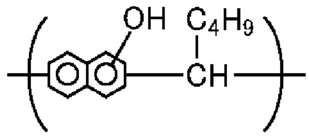

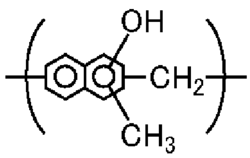
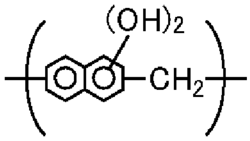
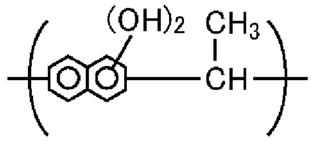

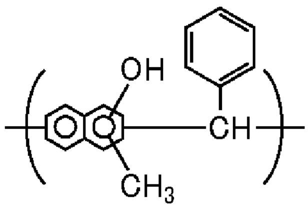
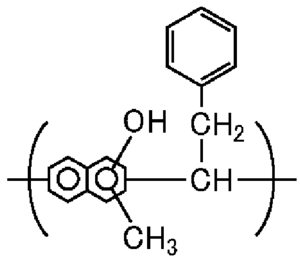
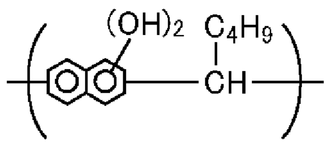

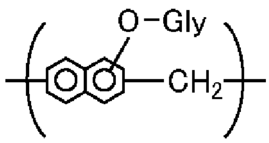
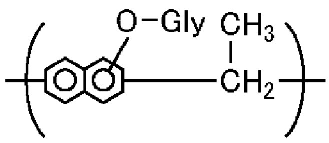
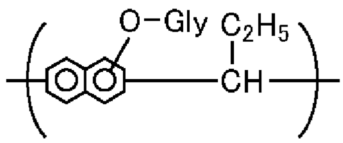

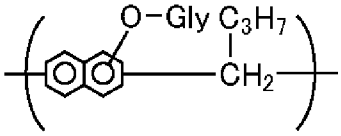
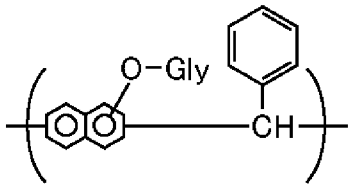
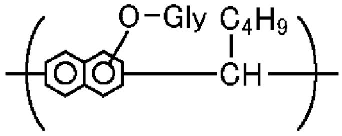

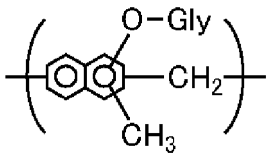
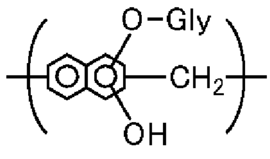
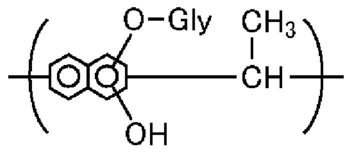

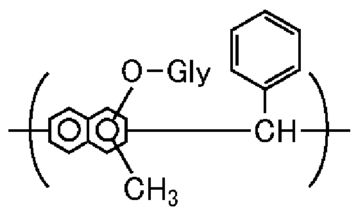

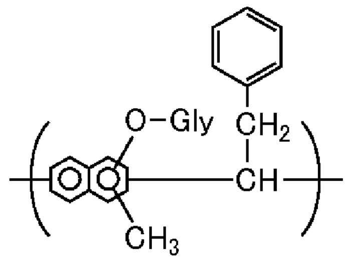

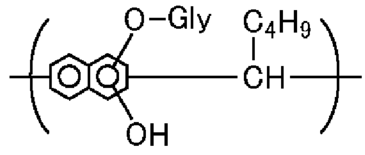

Specific examples of the resin having the structural unit represented by the general formula (B) include so-called naphthol aralkyl resin. In other words, in the general formula (B), $Ar^{12}$ preferably has a structure represented by the general formula (B1) (containing a naphthol skeleton). This makes the flatness particularly good. It is considered that the presence of a flat naphthalene ring in the resin facilitates the alignment of the molecules. Therefore, it is considered that the free volume is reduced as compared with the case where the resin represented by the general formula (A) is used alone, so that the shrinkage in the cooling process after the heating step is suppressed and the flatness is further improved.

On the other hand, naphthol aralkyl resin is poor in polarity because of its high carbon density, and in the case of being used alone, it is not compatible with solvents commonly used in semiconductor processes, and it is often impossible to prepare a uniform solution. Further, even in a case where a uniform solution can be prepared, the compatibility with the surface of the substrate which has been subjected to the hydrophilic treatment is usually poor, and a uniform coating film may not be obtained. That is, the use of the naphthol aralkyl resin alone is industrially limited in the type of solvent and the application of the substrate.

As a result of intensive examination, the present inventors have found that, only in a case where a novolac resin and/or a novolac-type epoxy resin as a specific example represented by the general formula (A) and a naphthol aralkyl resin as a specific example represented by the general formula (B) are blended at a ratio [(A)/(B)] to be described later, good solubility is exhibited in semiconductor process solvents such as propylene glycol-1-monomethyl ether-2-acetate (PGMEA) and propylene glycol monomethyl ether (PGME), and that a coating film having good coating properties on a substrate and good flatness after heating can be obtained.

In addition, according to SPIE Vol. 469 Advances in Resist Technology (1984) pp. 72 to 79, it is known that the crosslinking reaction of novolac resin occurs at 180° or higher, and it is assumed that the same reaction also occurs in naphthol aralkyl resin. It is also conceivable that, as a result of the crosslinking reaction occurring in the state of flattening in the heating step and the structure being fixed, the shrinkage in the cooling process is suppressed and the flatness is improved.

The naphthol aralkyl resin can be produced by a method generally used for producing the naphthol aralkyl resin. For example, it can be obtained by reacting naphthol with p-xylylene glycol dimethyl ether in the presence of a catalyst. Examples of naphthol include $\alpha$-naphthol and $\beta$-naphthol, which can be used alone or in combination. As the naphthol aralkyl resin, commercially available resins such as SN-485 (trade name) and SN-495V (trade name) manufactured by NIPPON STEEL Chemical & Material Co., Ltd. may be used.

A specific example of the structural unit represented by the general formula (B) is shown below.

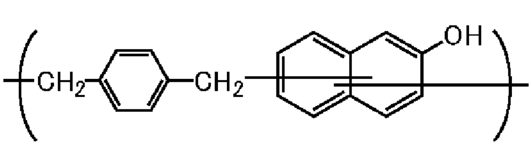

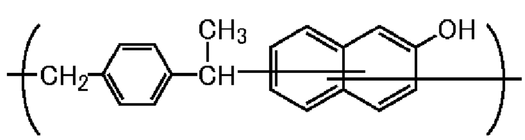

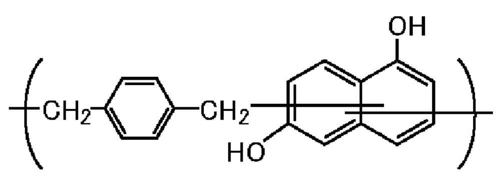

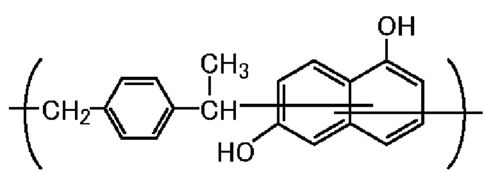

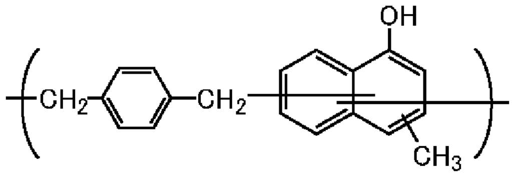
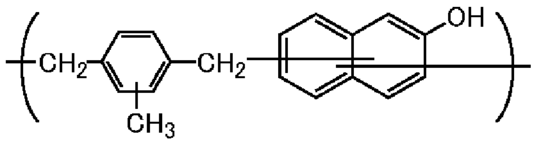

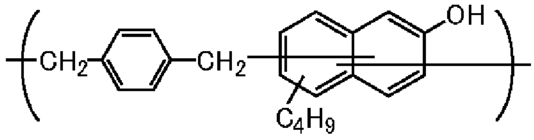
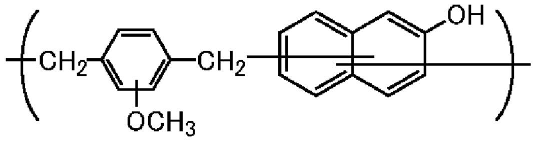

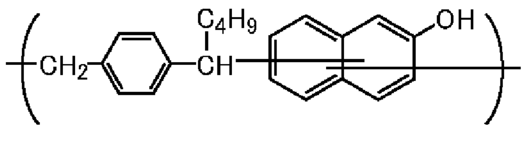
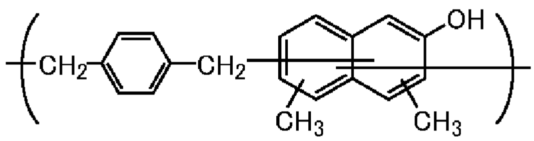

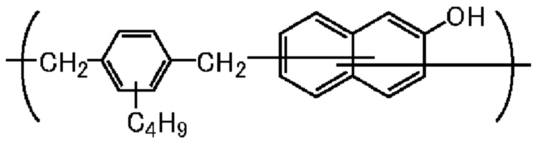
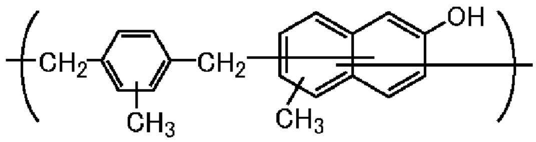

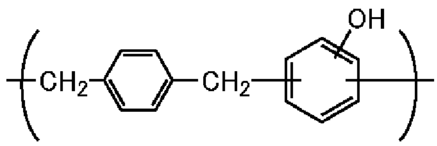
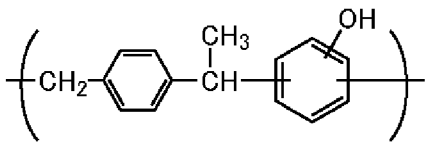

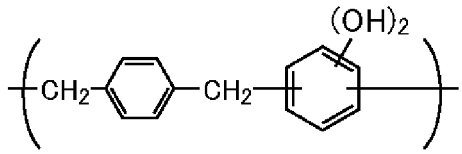
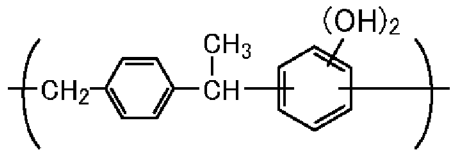

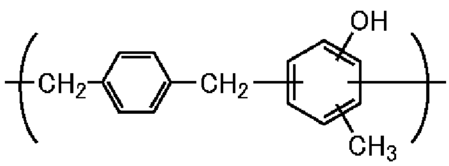
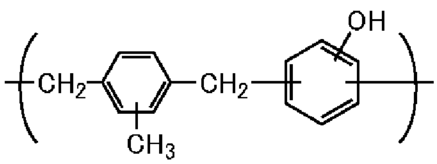

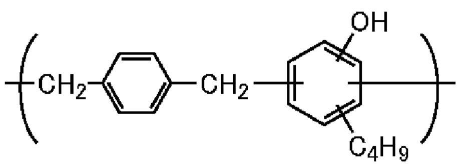
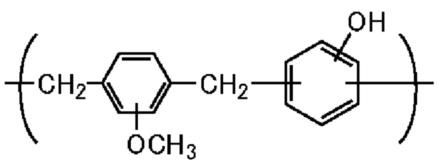

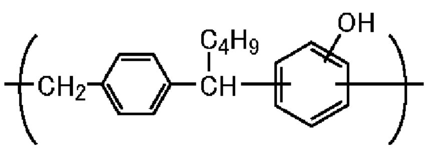
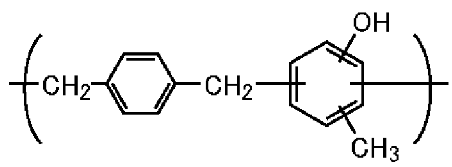

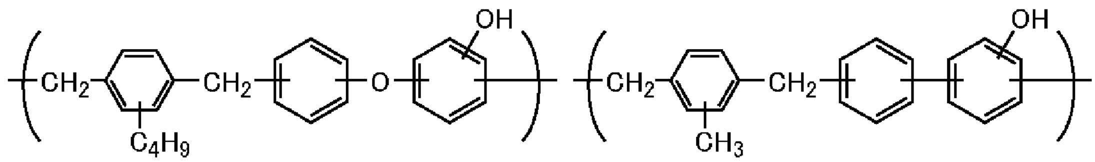

(Additional resin)

The material for forming an underlayer film of the first embodiment preferably further contains a resin having a structural unit represented by the following general formula (1) in addition to the resin having the structural unit represented by the general formula (A) and the resin having the structural unit represented by the general formula (B).

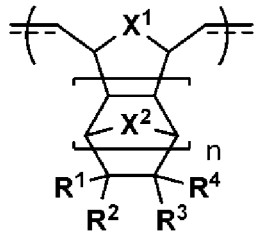

(1)

In the general formula (1),

$R^1$ to $R^4$ are each independently any group selected from the group consisting of a hydrogen atom, an aryl group having 6 to 20 carbon atoms, an aryloxy group having 6 to 20 carbon atoms, an aryloxyalkyl group having 7 to 20 carbon atoms, an aryloxycarbonyl group having 7 to 20 carbon atoms, an alkylarylaminocarbonyl group having 8 to 20 carbon atoms, an alkoxycarbonylaryl group having 8 to 30 carbon atoms, and an aryloxycarbonylalkyl group having 8 to 20 carbon atoms, at least one of $R^1$ to $R^4$ is a group other than a hydrogen atom, and $R^1$ to $R^4$ may be bonded to each other to form a ring structure,

n represents an integer of 0 to 2, and

$X^1$ and $X^2$ each independently represent $-CH_2-$ or -O-.

Examples of the aryl group having 6 to 20 carbon atoms include a phenyl group, a naphthyl group, an anthracenyl group, an o-tolyl group, an m-tolyl group, a p-tolyl group, a 2, 3-dimethylphenyl group, a 2,4-dimethylphenyl group, a 2,6-dimethylphenyl group, a 2,4,6-trimethylphenyl group, a 2-ethylphenyl group, a 3-ethylphenyl group, a 4-ethylphenyl group, a 4-i-propylphenyl group, a 4-tert-butylphenyl group, a biphenyl group, a 2-phenalenyl group, a 4-pyrenyl group, a 9-fluorenyl group, a 9-phenanthrenyl group, a 1-chrysenyl group, a 4-triphenylmethylphenyl group, and a phenol group.

Examples of the aryloxy group having 6 to 20 carbon atoms include a phenyloxy group, a naphthyloxy group, an anthracenyloxy group, an o-tolyloxy group, an m-tolyloxy group, a p-tolyloxy group, a 4-oxy-1,1'-biphenyl group, and a 4-hydroxyphenyloxy group.

Examples of the aryloxyalkyl group having 7 to 20 carbon atoms include a phenyloxymethyl group, a naphthyloxymethyl group, an anthracenyloxymethyl group, an o-tolyloxymethyl group, an m-tolyloxymethyl group, a p-tolyloxymethyl group, a 4-oxy-1,1'-biphenylmethyl group, and a 4-hydroxyphenyloxymethyl group.

Examples of the aryloxycarbonyl group having 7 to 20 carbon atoms include a phenoxycarbonyl group, a benzyloxycarbonyl group, a 4-methylphenoxycarbonyl group, a 3,4-dimethylphenoxycarbonyl group, a 1-naphthoxycarbonyl group, a 2-naphthoxycarbonyl group, and a 1-anthracenoxycarbonyl group.

Examples of the alkylarylaminocarbonyl group having 8 to 20 carbon atoms include a methylphenylaminocarbonyl group, an ethylphenylaminocarbonyl group, a butylphenylaminocarbonyl group, and a cyclohexylphenylaminocarbonyl group.

Examples of the alkoxycarbonylaryl group having 8 to 30 carbon atoms include a methoxycarbonylphenyl group, a methoxycarbonyl-o-tolyl group, a methoxycarbonyl-m-tolyl group, a methoxycarbonyl-p-tolyl group, a methoxycarbonylsilyl group, a methoxycarbonyl-α-naphthyl group, a methoxycarbonyl-p-naphthyl group, an ethoxycarbonylphenyl group, an n-propoxycarbonylphenyl group, an i-propoxycarbonylphenyl group, an n-butoxycarbonylphenyl group, a tert-butoxycarbonylphenyl group, an n-pentyloxycarbonylphenyl group, a cyclopentyloxycarbonylphenyl group, an n-hexyloxycarbonylphenyl group, a cyclohexyloxycarbonylphenyl group, an n-octyloxycarbonylphenyl group, a cyclooctyloxycarbonylphenyl group, a 1-ethylcyclopentyloxycarbonylphenyl group, a 1-methylcyclohexyloxycarbonylphenyl group, a methoxycarbonylnaphthyl group, a methoxycarbonylethyl group, an ethoxycarbonylnaphthyl group, an n-propoxycarbonylnaphthyl group, an i-propoxycarbonylnaphthyl group, an n-butoxycarbonylnaphthyl group, a tert-butoxycarbonylnaphthyl group, an n-pentyloxycarbonylnaphthyl group, a cyclopentyloxycarbonylnaphthyl group, an n-hexyloxycarbonylnaphthyl group, a cyclohexyloxycarbonylnaphthyl group, an n-octyloxycarbonylnaphthyl group, a cyclooctyloxycarbonylnaphthyl group, a 1-ethylcyclopentyloxycarbonylnaphthyl group, and a 1-methylcyclohexyloxycarbonylnaphthyl group.

Examples of the aryloxycarbonylalkyl group having 8 to 20 carbon atoms include a phenoxycarbonylmethyl group, a benzyloxycarbonylmethyl group, a 4-methylphenoxycarbonylmethyl group, a 3,4-dimethylphenoxycarbonylmethyl group, a 1-naphthoxycarbonylmethyl group, a 2-naphthoxycarbonylmethyl group, and a 1-anthracenoxycarbonylmethyl group.

$R^1$ to $R^4$ may form a ring structure. Specifically, at least two of $R^1$ to $R^4$ may be bonded to each other.

Examples of the structure in which at least two of $R^1$ to $R^4$ are bonded to each other include structures represented by the following general formulas (2) to (7).

$R^1$ to $R^4$ form a ring structure to form a bond chain in the unit structure, and even in a case where a part of the ring structure is broken by etching, the other bond remains and does not volatilize, and it is expected that substantially good etching resistance is exhibited.

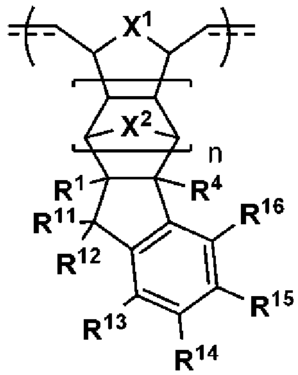

(2)

In the general formula (2),

$R^1$, $R^4$, $X^1$, $X^2$, and n have the same definition as that in the general formula (1).

$R^{11}$ to $R^{16}$ are each independently a hydrogen atom, an alkyl group having 1 to 10 carbon atoms, an aryl group having 6 to 20 carbon atoms, an alkoxy group having 1 to 10 carbon atoms, an aryloxy group having 6 to 20 carbon atoms, an alkoxyalkyl group having 2 to 10 carbon atoms, and an aryloxyalkyl group having 7 to 20 carbon atoms, and two or more of $R^{13}$ to $R^{16}$ may be bonded to each other to form a ring structure.

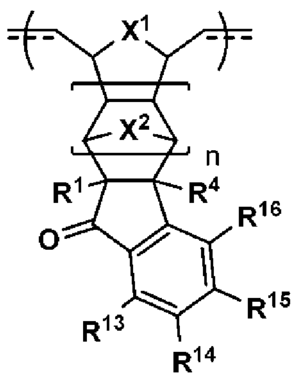

(3)

In the general formula (3),

$R^1$, $R^4$, $X^1$, $X^2$, and n have the same definition as that in the general formula (1).

$R^{13}$ to $R^{16}$ have the same definition as that in the general formula (2) .

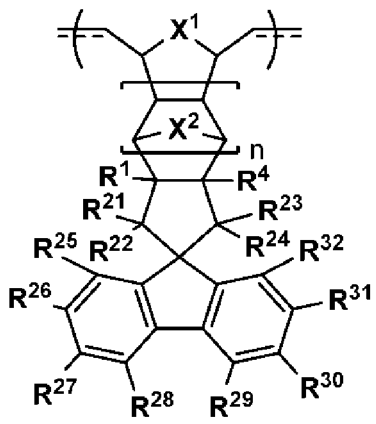

(4)

In the general formula (4),

$R^1$, $R^4$, $X^1$, $X^2$, and n have the same definition as that in the general formula (1).
$R^{21}$ to $R^{32}$ are each independently selected from a hydrogen atom, an alkyl group having 1 to 10 carbon atoms, an aryl group having 6 to 20 carbon atoms, an alkoxy group having 1 to 10 carbon atoms, an aryloxy group having 6 to 20 carbon atoms, an alkoxyalkyl group having 2 to 10 carbon atoms, and an aryloxyalkyl group having 7 to 20 carbon atoms, and two or more of $R^{25}$ to $R^{32}$ may be bonded to each other to form a ring structure.

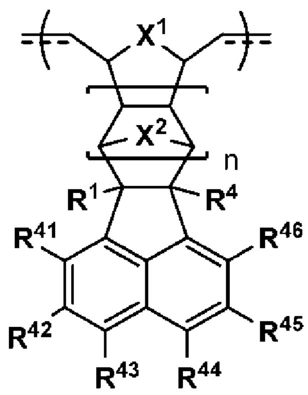

(5)

In the general formula (5),

$R^1$, $R^4$, $X^1$, $X^2$, and n have the same definition as that in the general formula (1).
$R^{41}$ to $R^{46}$ are each independently selected from a hydrogen atom, an alkyl group having 1 to 10 carbon atoms, an aryl group having 6 to 20 carbon atoms, an alkoxy group having 1 to 10 carbon atoms, an aryloxy group having 6 to 20 carbon atoms, an alkoxyalkyl group having 2 to 10 carbon atoms, and an aryloxyalkyl group having 7 to 20 carbon atoms, and two or more of $R^{41}$ to $R^{46}$ may be bonded to each other to form a ring structure.

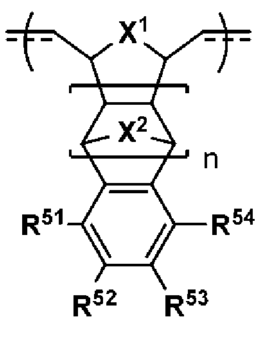

(6)

In the general formula (6),

$X^1$, $X^2$, and n have the same definition as that in the general formula (1).

$R^{51}$ to $R^{54}$ are each independently selected from a hydrogen atom, an alkyl group having 1 to 10 carbon atoms, an aryl group having 6 to 20 carbon atoms, an alkoxy group having 1 to 10 carbon atoms, an aryloxy group having 6 to 20 carbon atoms, an alkoxyalkyl group having 2 to 10 carbon atoms, and an aryloxyalkyl group having 7 to 20 carbon atoms, and two or more of $R^{51}$ to $R^{54}$ may be bonded to each other to form a ring structure.

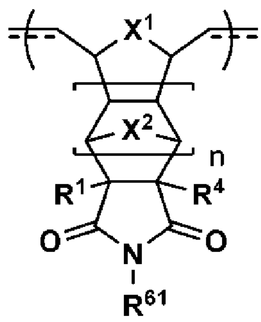
(7)

In the general formula (7),

$R^1$, $R^4$, $X^1$, $X^2$, and n have the same definition as that in the general formula (1).

$R^{61}$ is hydrogen or an aryl group having 6 to 20 carbon atoms, and may have an alkoxy group or an ester group as a substituent.

The following can be shown as an example of the structural unit represented by the general formula (2).

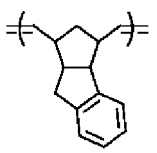 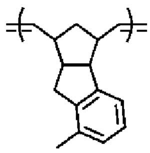 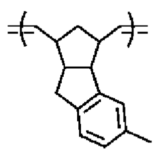 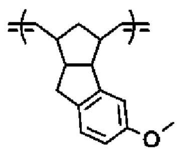

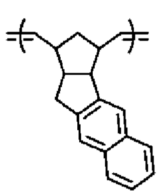 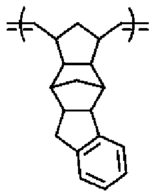 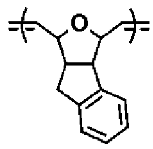

The following can be shown as an example of the structural unit represented by the general formula (3).

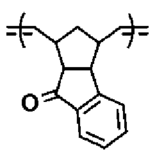 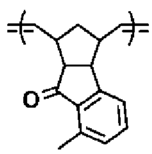 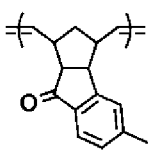 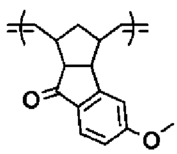 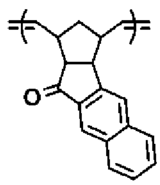

The following can be shown as an example of the structural unit represented by the general formula (4).

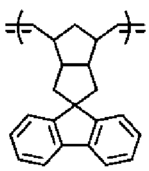 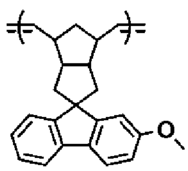 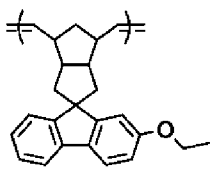 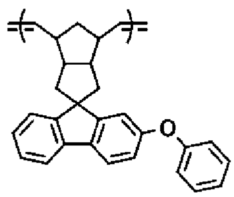

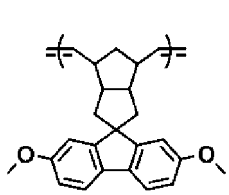
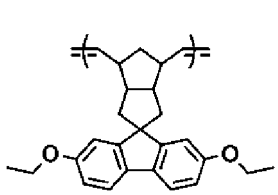
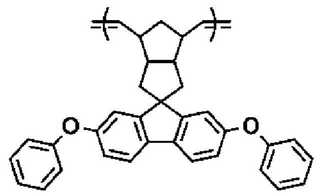

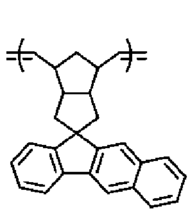
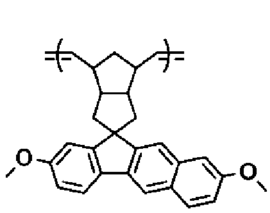
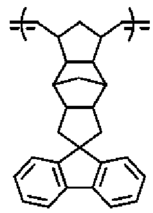
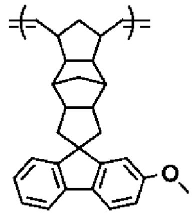

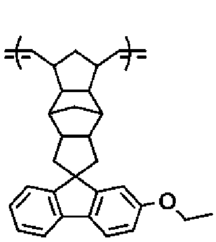
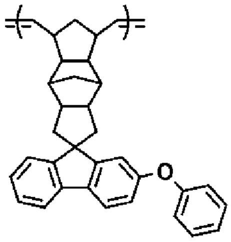
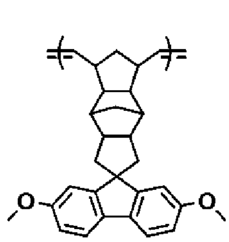
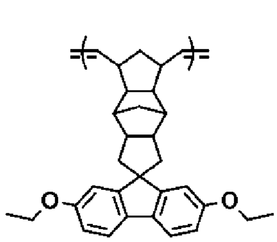

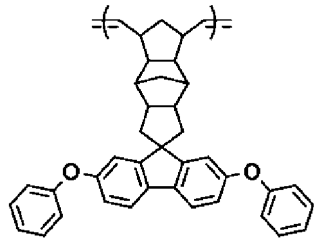

The following can be shown as an example of the structural unit represented by the general formula (5).

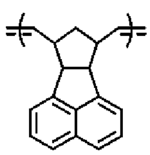
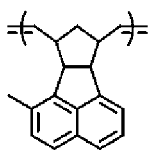
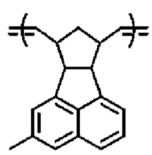
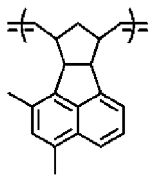
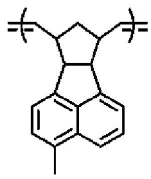
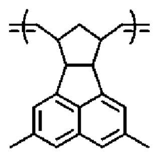

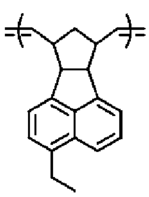
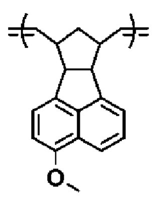
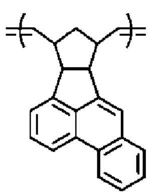
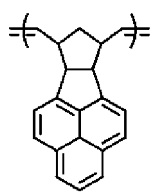
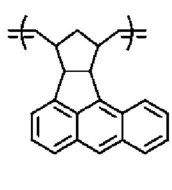
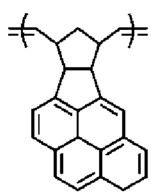

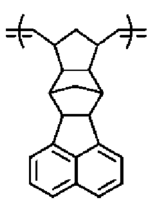
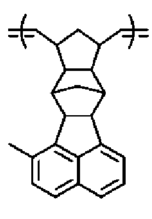
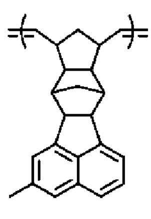
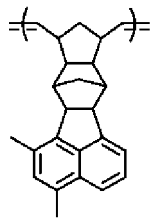
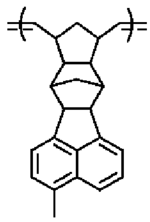
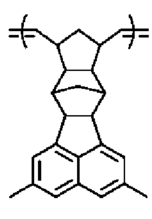

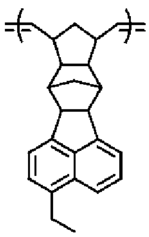
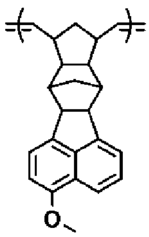
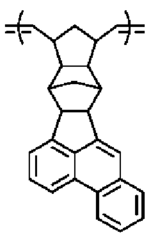
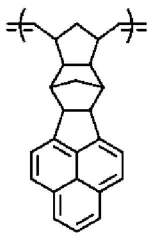
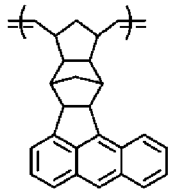
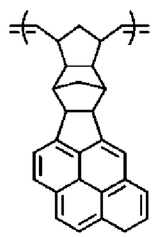

The following can be shown as an example of the structural unit represented by the general formula (6).

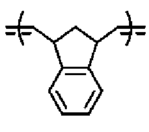
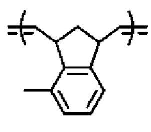
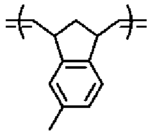
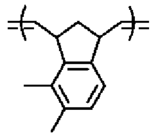
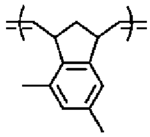
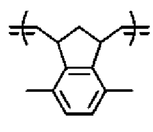

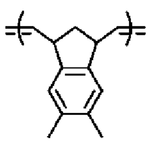
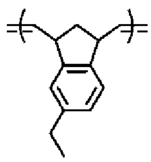
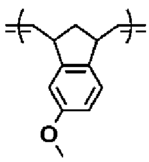
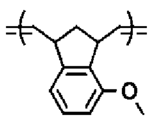
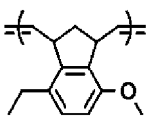
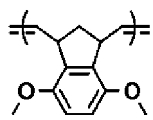

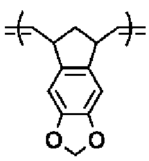
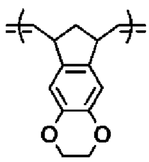
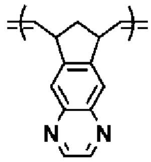
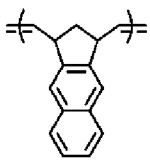
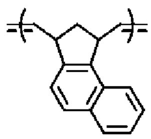
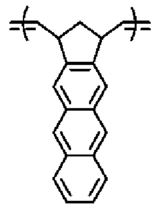

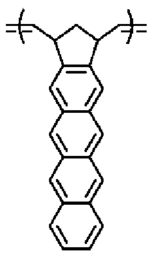
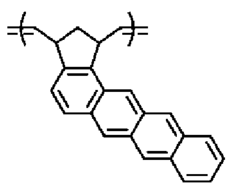
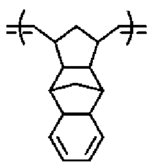
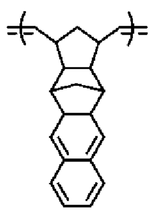
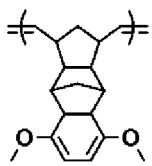

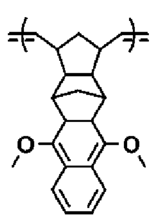
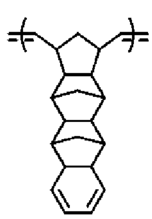
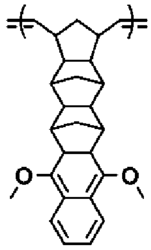

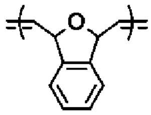
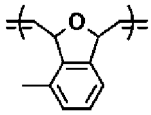
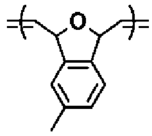
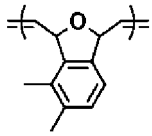
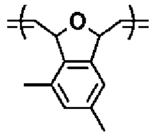
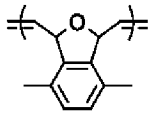

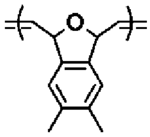
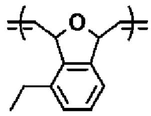
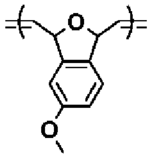
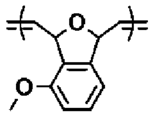
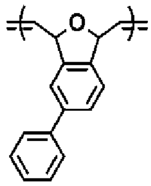
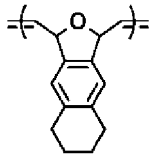

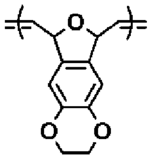
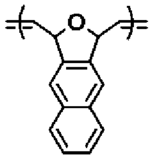
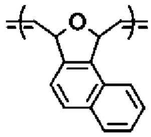
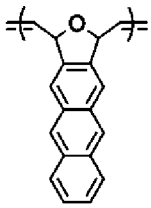
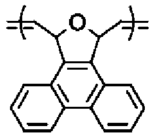
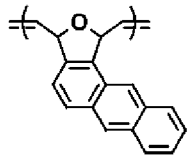

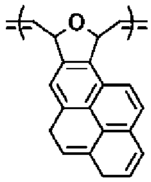
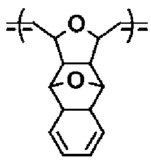
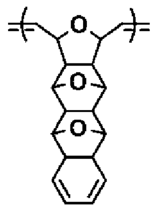

The following can be shown as an example of the structural unit represented by the general formula (7).

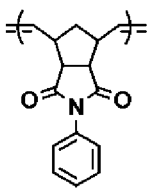
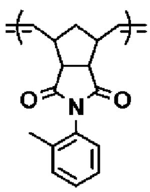
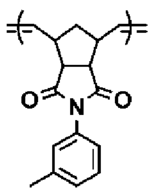
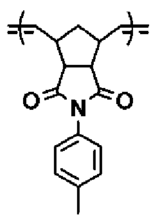
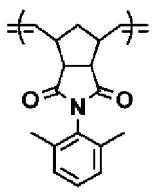
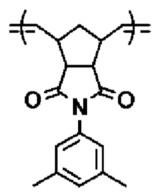

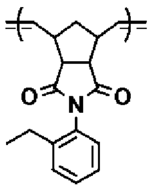
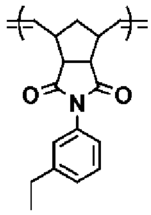
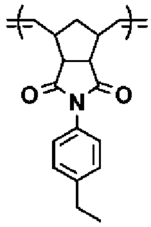
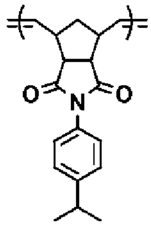

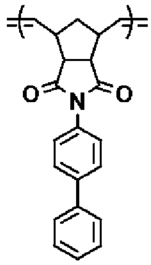 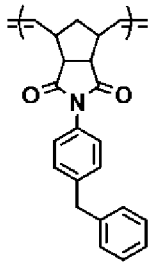 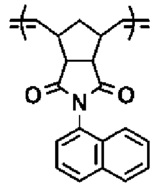 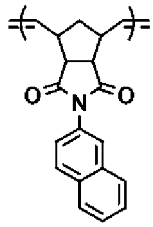 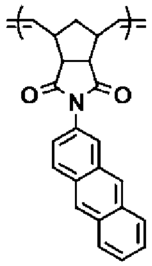 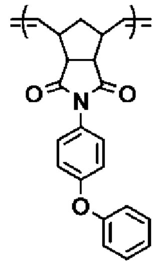

The resin having the structural unit represented by the general formula (1) may contain a structural unit other than the above for various physical property adjustments and the like. For example, the resin may contain a cyclic olefin structural unit such as the structural unit [A] represented by the general formula (1) and/or the structural unit [B] represented by the general formula (2) described in Patent Document 3.

In a case where the resin having the structural unit represented by the general formula (1) contain a structural unit other than those described above, the amount thereof is, for example, 1% to 50% by mol, preferably 1% to 40% by mol, and more preferably 1% to 30% by mol, based on the total structural unit of the resin having the structural unit represented by the general formula (1).

The resin having the structural unit represented by the general formula (1) can be obtained, for example, by polymerizing a cyclic olefin monomer represented by the following general formula (8) by ring opening metathesis polymerization. In the general formula (8), $R^1$ to $R^4$, $X^1$, $X^2$, and n have the same definition as that in the general formula (1).

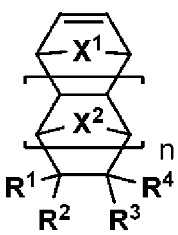

(8)

The cyclic olefin monomer as a polymerization raw material may contain two or more monomers in which at least one of $R^1$ to $R^4$ in the structure represented by the general formula (8) is different from the rest. Further, the polymerization raw material may contain the cyclic olefin monomer represented by the general formula (8) and a monomer other than the cyclic olefin monomer (for example, the monomer described in Patent Document 3).

The catalyst used in the polymerization of a resin having a structural unit represented by general formula (1) is not particularly limited as long as it is a catalyst capable of ring opening metathesis polymerization of a cyclic olefin monomer (for example, one represented by the general formula (8)).

Examples thereof include organic transition metal alkylidene complex catalysts such as molybdenum (Mo), tungsten (W), and ruthenium (Ru); and ring opening metathesis catalysts obtained by combining an organic transition metal complex with a Lewis acid as a promoter. Preferably, an organic transition metal alkylidene complex catalyst such as molybdenum (Mo), tungsten (W) or ruthenium (Ru) is used.

In the present embodiment, a catalyst capable of copolymerizing a highly polar cyclic olefin monomer containing a heteroatom is preferable. For example, a highly polar cyclic olefin monomer can be efficiently copolymerized in a case where an organic transition metal alkylidene complex such as molybdenum (Mo), tungsten (W), or ruthenium (Ru) is used for a ring opening metathesis polymerization catalyst.

Examples of the ring opening metathesis polymerization catalyst of the organic transition metal alkylidene complex include a tungsten-based alkylidene catalyst such as $W(N\text{-}2, 6\text{-}Pr^i_2C_6H_3)(CHBu^t)(OBu^t)_2$, $W(N\text{-}2, 6\text{-}Pr^i_2C_6H_3)(CHBu^t)(OCMe_2CF_3)_2$, $W(N\text{-}2, 6\text{-}Pr^i_2C_6H_3)(CHBu^t)(OCMe (CF_3)_2)_2$, $W(N\text{-}2, 6\text{-}Pr^i_2C_6H_3)(CHCMe_2Ph)(OBu^t)_2$, $W(N\text{-}2, 6\text{-}Pr^i_2C_6H_3)(CHCMe_2Ph)(OCMe_2CF_3)_2$, $W(N\text{-}2, 6\text{-}Pr^i_2C_6H_3)(CHCMe_2Ph)(OCMe (CF_3)_2)_2$, $W(N\text{-}2, 6\text{-}Pr^i_2C_6H_3)(CHCMe_2Ph)(OC(CF_3)_3)_2$, or $W(N\text{-}2, 6\text{-}Me_2C_6H_3)(CHCMe_2Ph)(OC (CF_3)_3)_2$ (in the formulae, $Pr^i$ represents an iso-propyl group, $Bu^t$ represents a tert-butyl group, Me represents a methyl group, and Ph represents a phenyl group); a tungsten-based alkylidene catalyst such as $W(N\text{-}2,6\text{-}Me_2C_6H_3)(CHCHCMePh)(OBu^t)_2(PMe_3)$, $W(N\text{-}2, 6\text{-}Me_2C_6H_3)(CHCHCMe_2)(OBu^t)_2(PMe_3)$, $W(N\text{-}2, 6\text{-}Me_2C_6H_3)(CHCHCPh_2)(OBu^t)_2(PMe_2)$, $W (N\text{-}2, 6\text{-}Me_2C_6H_3)(CHCHCMePh)(OCMe_2(CF_3))_2(PMe_3)$, $W (N\text{-}2, 6\text{-}Me_2C_6H_3)(CHCHCMe_2)(OCMe_2(CF_3))_2(PMe_3)$, $W (N\text{-}2, 6\text{-}Me_2C_6H_3)(CHCHCPh_2)(OCMe_2(CF_3))_2(PMe_3)$, $W (N\text{-}2, 6\text{-}Me_2C_6H_3)(CHCHCMe_2)(OCMe(CF_3)_2)_2(PMe_3)$, $W (N\text{-}2, 6\text{-}Me_2C_6H_3)(CHCHCMe_2)(OCMe(CF_3)_2)_2(PMe_3)$, $W (N\text{-}2, 6\text{-}Me_2C_6H_3)(CHCHCPh_2)(OCMe(CF_3)_2)_2(PMe_3)$, $W(N\text{-}2, 6\text{-}Pr^i_2C_6H_3)(CHCHCMePh)(OCMe_2(CF_3))_2(PMe_3)$, $W(N\text{-}2, 6\text{-}Pr^i_2C_6H_3)(CHCHCMePh)(OCMe(CF_3)_2)_2(PMe_3)$, or W(N-2,

6-$Pr^i_2C_6H_3$)(CHCHCMePh)$(OPh)_2(PMe_3)$ (in the formulae, $Pr^i$ represents an iso-propyl group, $Bu^t$ represents a tert-butyl group, Me represents a methyl group, and Ph represents a phenyl group); a molybdenum-based alkylidene catalyst such as Mo(N-2, 6-$Pr^i_2C_6H_3$)($CHBu^t$)$(OBu^t)_2$, Mo(N-2, 6-$Pr^i_2C_6H_3$)($CHBu^t$)$(OCMe_2CF_3)_2$, Mo(N-2, 6-$Pr^i_2C_6H_3$)(CH-$Bu^t$)$(OCMe(CF_3)_2)_2$, Mo(N-2, 6-$Pr^i_2C_6H_3$)($CHBu^t$)$(OC(CF_3)_3)_2$, Mo(N-2, 6-$Pr^i_2C_6H_3$)($CHCMe_2Ph$)$(OBu^t)_2$, Mo(N-2, 6-$Pr^i_2C_6H_3$)($CHCMe_2Ph$)$(OCMe_2CF_3)_2$, Mo(N-2, 6-$Pr^i_2C_6H_3$)($CHCMe_2Ph$)$(OCMe(CF_3)_2)_2$, Mo(N-2, 6-$Pr^i_2C_6H_3$)($CHCMe_2Ph$)$(OC(CF_3)_3)_2$, Mo(N-2, 6-$Me_2C_6H_3$)($CHCMe_2Ph$)$(OBu^t)_2$, Mo(N-2, 6-$Me_2C_6H_3$)($CHCMe_2Ph$)$(OCMe_2CF_3)_2$, Mo(N-2, 6-$Me_2C_6H_3$)($CHCMe_2Ph$)$(OCMe(CF_3)_2)_2$, or Mo(N-2, 6-$Me_2C_6H_3$)($CHCMe_2Ph$)$(OC(CF_3)_3)_2$ (in the formulae, $Pr^i$ represents an iso-propyl group, $Bu^t$ represents a tert-butyl group, Me represents a methyl group, and Ph represents a phenyl group); and a ruthenium-based alkylidene catalyst such as $Ru(P(C_6H_{11})_3)_2(CHPh)Cl_2$ (in the formula, Ph represents a phenyl group).

The ring opening metathesis polymerization catalyst may be used alone or in combination of two or more kinds thereof.

Examples of the polymerization catalyst metal component at the time of polymerizing a resin having a structural unit represented by the general formula (1) include transition metals such as molybdenum, tungsten, rhenium, iridium, tantalum, ruthenium, vanadium, titanium, palladium, and rhodium. Among these, molybdenum, tungsten, ruthenium, or rhodium is preferable, and molybdenum or tungsten is more preferable.

The molar ratio of the cyclic olefin monomer to the ring opening metathesis polymerization catalyst of the organic transition metal alkylidene complex in the polymerization reaction is in a range of 10 equivalents to 50000 equivalents, preferably in a range of 50 equivalents to 30000 equivalents, and more preferably in a range of 100 equivalents to 20000 equivalents with respect to 1 mol of the ring opening metathesis polymerization catalyst.

The polymerization reaction may be carried out with or without a solvent.

Examples of the solvent include ethers such as tetrahydrofuran, diethyl ether, dibutyl ether, dimethoxyethane, and dioxane; an aromatic hydrocarbon such as benzene, toluene, xylene, or ethylbenzene; an aliphatic hydrocarbon such as pentane, hexane, or heptane; an aliphatic cyclic hydrocarbon such as cyclopentane, cyclohexane, methyl cyclohexane, dimethyl cyclohexane, or decalin; a halogenated hydrocarbon such as methylene dichloride, dichloroethane, dichloroethylene, tetrachloroethane, chlorobenzene, or trichlorobenzene; and an ester such as methyl acetate or ethyl acetate.

The solvents may be used alone or in combination of two or more kinds thereof.

Further, the polymerization reaction may be carried out in the presence of a chain transfer agent such as olefins or dienes.

Examples of the olefins used as a chain transfer agent include $\alpha$-olefin such as ethylene, propylene, butane, pentene, hexene, or octene; and silicon-containing olefin such as vinyl trimethylsilane, allyl trimethylsilane, allyl triethylsilane, or allyl triisopropylsilane. Further, examples of the dienes include non-conjugated diene such as 1,4-pentadiene, 1,5-hexadiene, or 1,6-heptadiene.

The chain transfer agent may be used alone or in combination of two or more kinds thereof.

The amount of the chain transfer agent to be used is preferably in a range of 0.001 to 1000 equivalents and more preferably in a range of 0.01 to 100 equivalents with respect to 1 mol of the cyclic olefin monomer.

From another viewpoint, the amount of the chain transfer agent to be used is more preferably in a range of 0.1 to 2000 equivalents and more preferably in a range of 1 to 1000 equivalents with respect to 1 mol of the ring opening metathesis polymerization catalyst.

The size of the molecular weight can be adjusted by optionally setting these ratios.

The monomer concentration in the polymerization reaction may be appropriately adjusted depending on the reactivity of the cyclic olefin monomer, the solubility in the polymerization solvent, and the like, and is not particularly limited. As an example, the amount of cyclic olefin monomer per 1 kg of solvent is, for example, in a range of 0.001 to 3 kg, preferably in a range of 0.01 to 2 kg, and more preferably in a range of 0.02 to 1 kg.

The reaction temperature may be appropriately adjusted depending on the type and amount of the cyclic olefin monomer and the ring opening metathesis catalyst, and is not particularly limited. As an example, the reaction temperature is -30°C to 150°C, preferably 0°C to 120°C, and more preferably 15°C to 100°C.

The reaction time is, for example, 1 minute to 10 hours, preferably 5 minutes to 8 hours, and more preferably 10 minutes to 6 hours.

After the polymerization reaction, a solution of the resin having the structural unit represented by general formula (1) can be obtained by stopping the reaction using aldehydes such as butyl aldehyde; ketones such as acetone; or alcohols such as methanol.

From the viewpoint of further suppressing generation of volatile components (outgas) by reducing the amount of unpolymerized monomers in the resin having the structural unit represented by general formula (1) to be obtained, the polymerization rate of the cyclic olefin monomer is preferably 90% or more, more preferably 95% or more, and still more preferably 100%.

The method for obtaining the polymer from the obtained solution of the resin having the structural unit represented by the general formula (1) is not particularly limited, and a known method can be appropriately applied. Examples thereof include a method of discharging the reaction solution to a poor solvent being stirred; a method of precipitating a polymer using a steam stripping method of blowing steam into the reaction solution; and a method of evaporating and removing a solvent from the reaction solution through heating.

The resin having the structural unit represented by the general formula (1) may be in a form in which the double bond of the main chain is hydrogenated (also referred to as hydrogenation). This makes it easier to obtain good fluidity during heating (baking) by removing the constraint that restricts the movement of the polymer chain by the double bond in the main chain, for example, by appropriately lowering the glass transition temperature of the polymer. That is, it is possible to form a resist underlayer film in which the embedding property into the uneven structure of the substrate is improved and the flatness is improved.

The hydrogenation ratio in the hydrogenation reaction is preferably 0.1% to 100% by mole, more preferably 1.0% to 95% by mole, and still more preferably 5% to 90% by mole based on the entire double bond of the main chain.

The catalyst for hydrogenation may be either a homogeneous metal complex catalyst or a heterogeneous metal-supported catalyst. Preferably, the catalyst is a heterogeneous metal-supported catalyst which can be easily separated. Preferred examples thereof include activated carbon-supported palladium, alumina-supported palladium, activated carbon-supported rhodium, alumina-supported rhodium, activated carbon-supported ruthenium, and alumina-supported ruthenium.

The catalysts may be used alone or in combination of two or more kinds thereof.

The solvent used at the time of hydrogenation is not particularly limited as long as it dissolves the polymer and the solvent itself is not hydrogenated. Examples of the solvent include ethers such as tetrahydrofuran, diethyl ether, dibutyl ether, dimethoxyethane, and dioxane; an aromatic hydrocarbon such as benzene, toluene, xylene, or ethylbenzene; an aliphatic hydrocarbon such as pentane, hexane, or heptane; an aliphatic cyclic hydrocarbon such as cyclopentane, cyclohexane, methyl cyclohexane, dimethyl cyclohexane, or decalin; a halogenated hydrocarbon such as methylene dichloride, dichloroethane, dichloroethylene, tetrachloroethane, chlorobenzene, or trichlorobenzene; and an ester such as methyl acetate or ethyl acetate.

At the time of the hydrogenation, these solvents may be used alone or in combination of two or more kinds thereof. Further, it is preferable that a step which is suitable for productivity can be employed without carrying out a solvent substitution step by means of using the same kind of solvent as the solvent used in the polymerization reaction described above.

In the hydrogenation reaction, the hydrogen pressure is preferably the normal pressure to 10 MPa, more preferably 0.5 to 8 MPa, and particularly preferably 2 to 5 MPa. Further, the reaction temperature is preferably 0°C to 200°C, more preferably room temperature to 150°C, and particularly preferably 50°C to 100°C. The mode in which the hydrogenation reaction is carried out is not particularly limited, and examples of the method of carrying out the hydrogenation reaction include a method of carrying out the reaction by dispersing or dissolving a catalyst in a solvent; and a method of carrying out the reaction by filling a column or the like with a catalyst and circulating a polymer solution as a stationary phase.

Further, the hydrogenation treatment may be performed after the polymerization solution of the polymer before the hydrogenation treatment is precipitated in a poor solvent, the polymer is isolated, and the polymer is dissolved in a solvent again or the hydrogenation treatment may be performed using the above-described hydrogenation catalyst without isolating the polymer from the polymerization solution.

After the hydrogenation, the method of obtaining a polymer from a polymer solution is not particularly limited. Examples thereof include a method of obtaining a polymer solution which does not contain a catalyst using a method of filtration, centrifugation, or decantation and discharging the reaction solution to a poor solvent being stirred; a method of precipitating a polymer using a steam stripping method of blowing steam into the reaction solution; and a method of evaporating and removing a solvent from the reaction solution through heating. These methods are particularly preferably applied in the case of using a heterogeneous metal-supported catalyst such as activated carbon-supported rhodium or activated carbon-supported ruthenium after the hydrogenation.

Further, in a case where the hydrogenation reaction is carried out using a heterogeneous metal-supported catalyst, the polymer can be obtained according to the above-described method after a synthetic solution is filtered and the metal-supported catalyst is separated by filtration. In order to obtain a polymer solution having a small amount of metal impurities desired in a semiconductor device production step, the polymer may be obtained according to the above-described method after a solution obtained by roughly removing a catalyst component is filtered.

In particular, it is preferable to microfilter the catalyst component. In this case, the opening diameter of the filtration filter is preferably 0.05 to 10 $\mu$m, more preferably0.10 to 10 $\mu$m, and still more preferably 0.10 to 5 $\mu$m.

The weight-average molecular weight (Mw) of the resin having the structural unit represented by the general formula (1) as measured by gel permeation chromatography (GPC) using standard polystyrene as a reference material is preferably 1000 to 20000, more preferably 1500 to 19000, and still more preferably 2000 to 18000. Here, the sample concentration at the time of GPC measurement can be, for example, 3.0 to 9.0 mg/ml.

In a case where the weight-average molecular weight (Mw) is set to be in the above-described range, further excellent heat melt fluidity can be exhibited at the time of heating the surface of the uneven structure of the substrate at a temperature of 200°C to 250°C, which is applied in a typical semiconductor device production step, in a baking step after the surface thereof is coated with the material for forming an underlayer film of the present embodiment. As the result, an underlayer film in which defects such as voids are further suppressed and which has excellent flatness and exhibits an excellent embedding property can be formed.

The molecular weight distribution (Mw/Mn), which is a ratio between the weight-average molecular weight (Mw) and the number-average molecular weight (Mn), of the resin having the structural unit represented by the general formula (1) is preferably 1.3 to 5.0, more preferably 1.3 to 4.0, and still more preferably 1.3 to 3.0. In a case where the molecular weight distribution (Mw/Mn) is set to be in an appropriate range, the melt unevenness with respect to the heating during the baking step can be further suppressed, and the resin is further uniformly melted. As the result, an underlayer film in which defects such as voids are further suppressed and which has excellent flatness and has an excellent embedding property can be formed.

Performance can be improved by appropriately adjusting the usage ratio of a plurality of resins.

The mass ratio of the resin having the structural unit represented by the general formula (A) to the resin having the structural unit represented by the general formula (B) is usually resin having the structural unit represented by the general formula (A)/resin having the structural unit represented by the general formula (B) = 5/95 to 95/5, preferably 10/90 to 90/10, more preferably 20/80 to 80/20, and still more preferably 40/60 to 60/40.

In a case where the underlayer film forming material of the first embodiment further contains a resin having a structural unit represented by the general formula (1), the mass ratio is (the resin having the structural unit represented by the general formula (A) + the resin having the structural unit represented by the general formula (1))/(the resin having the structural unit represented by the general formula (B)) = 5/95 to 95/5, preferably 10/90 to 90/10, more preferably 20/80 to 80/20, and still more preferably 40/60 to 60/40.

It should be noted that the underlayer film forming material of the first embodiment may contain a resin other than the above-described resin (other resin) as long as the solid content satisfies the above (i) and (ii).

The material for forming an underlayer film can be prepared by dissolving or dispersing the above-described resin in an organic solvent and, as necessary, removing foreign substances through a filter. The material for forming an underlayer film thus prepared is usually in the form of a varnish suitable for application on a substrate.

The organic solvent that can be used at this time is not particularly limited as long as it is a solvent that can dissolve or disperse the above-described resin.

Examples of the organic solvent include an alcohol-based solvent, an ether-based solvent, a ketone-based solvent, an amide-based solvent, an ester-based solvent, and a hydrocarbon-based solvent.

Examples of the alcohol-based solvent include an aliphatic monoalcohol-based solvent having 1 to 18 carbon atoms such as 4-methyl-2-pentanol, or n-hexanol; an alicyclic monoalcohol-based solvent having 3 to 18 carbon atoms such as cyclohexanol; a polyhydric alcohol-based solvent having 2 to 18 carbon atoms such as 1,2-propylene glycol; and a polyhydric alcohol partial ether-based solvent having 3 to 19 carbon atoms such as propylene glycol monomethyl ether.

Examples of the ether-based solvent include a dialkyl ether-based solvent such as diethyl ether, dipropyl ether, or dibutyl ether; a cyclic ether-based solvent such as tetrahydrofuran or tetrahydropyran; and an aromatic ring-containing ether-based solvent such as diphenyl ether or anisole.

Examples of the ketone-based solvent include a chain-like ketone-based solvent such as acetone, methyl ethyl ketone, methyl-n-propyl ketone, methyl-n-butyl ketone, diethyl ketone, methyl-iso-butyl ketone, 2-heptanone, ethyl-n-butyl ketone, methyl-n-hexyl ketone, di-iso-butyl ketone, or trimethyl nonanone; a cyclic ketone-based solvent such as cyclopentanone, cyclohexanone, cycloheptanone, cyclooctanone, or methyl cyclohexanone; and 2,4-pentanedione, acetonyl acetone, or acetophenone.

Examples of the amide-based solvent include a cyclic amide-based solvent such as N,N'-dimethylimidazolidinone or N-methylpyrrolidone; and a chain-like amide-based solvent such as N-methylformamide, N,N-dimethylformamide, N,N-diethylformamide, acetamide, N-methylacetamide, N,N-dimethylacetamide, or N-methylpropionamide.

Examples of the ester-based solvent include a monocarboxylic acid ester-based solvent such as n-butyl acetate; a polyhydric alcohol monocarboxylate-based solvent such as propylene glycol acetate; a polyhydric alcohol partial ether carboxylate-based solvent such as a polyhydric alcohol partial alkyl ether acetate such as propylene glycol monomethyl ether acetate; a polycarboxylic acid diester-based solvent such as diethyl oxalate; a lactone-based solvent such as γ-butyrolactone or δ-valerolactone; and a carbonate-based solvent such as diethyl carbonate, ethylene carbonate, or propylene carbonate.

Examples of the hydrocarbon-based solvent include a linear or branched hydrocarbon having 5 to 10 carbon atoms, an alicyclic hydrocarbon having 5 to 12 carbon atoms, and an aromatic hydrocarbon having 6 to 18 carbon atoms. Some or all hydrogen atoms on a ring of the alicyclic hydrocarbon and the aromatic hydrocarbon may be substituted with a linear or branched alkyl group having 1 to 5 carbon atoms.

The solvent may be appropriately selected in consideration of the volatilization rate at the time of coating, adaptability to the process, productivity and the like.

Preferably, an oxygen-containing solvent such as an alcohol-based solvent, a chain-like ketone-based solvent, a cyclic ketone-based solvent, a chain-like ether solvent, a cyclic ether solvent, or an ester-based solvent is selected.

The material for forming an underlayer film may contain one or two or more kinds of solvents.

Further, for example, in the step of synthesizing the resin having a structural unit represented by the general formula (1) described above, for example, in a case where there is no alteration such as the hydrogenation of the solvent in the hydrogenation step, the same kind of solvent may be used as the synthetic solvent and the preparation solvent of the material for forming an underlayer film.

Further, in the material for forming an underlayer film of the present embodiment, the concentration of the resin (in a case where two or more kinds of resins are used, the sum of the respective concentrations) is preferably 0.01% to 50.0% by mass, more preferably 0.1% to 45.0% by mass, and still more preferably 1.0% to 40.0% by mass. The concentration of the resin can be selected in consideration of the solubility of the resin, the adaptability to the filtration process, the film forming property, the thickness of the underlayer film, and the like.

Furthermore, for the purpose of adjusting the physical properties of the resist underlayer film, the material for forming an underlayer film may contain a resin such as an acrylic resin, an epoxy resin, a styrene resin, a hydroxystyrene resin, a hydroxynaphthylene resin, or a silicone resin; a combination of a polymerizable monomer or oligomer and a polymerization initiator (light or heat); and an oxide of a metal such as zirconium, hafnium, ruthenium, or titanium, to the extent that etching resistance, embedding property and flatness are not excessively impaired.

Next, the prepared varnish-like material for forming an underlayer film is filtered by being allowed to pass through a filter. As a result, polymer insoluble matter, gel, foreign substance and the like can be removed from the varnish-like material for forming an underlayer film. By reducing these components, the flatness at the time of application becomes better.

The opening diameter of the filtration filter is preferably 0.001 to 1 μm, more preferably 0.001 to 0.5 μm, and still more preferably 0.001 to 0.1 μm. Examples of the material of the filter include organic materials such as polytetrafluoroethylene (PTFE), polypropylene (PP), polyether sulfone (PES), and cellulose; and inorganic materials such as glass fibers and metals. Any material can be selected in consideration of the varnish characteristics and the process adaptability as long as the material does not affect the function as the resist underlayer film.

The filtration process may be carried out by performing a multi-stage process of sending the varnish from a filter having a large pore diameter to a filter having a small pore diameter. Of course, the filtration process may be a single process of directly sending the varnish to a filter having a small pore diameter.

Examples of the method of sending the varnish to the filter include a method of using a pressure difference and a method of sending the varnish to the filter using mechanical drive through a screw or the like.

The temperature for the filtration may be selected in consideration of the filter performance, the solution viscosity, and the solubility of the polymer. The temperature thereof is preferably in a range of -10°C to 200°C, more preferably in a range of 0°C to 150°C, and still more preferably in a range of room temperature to 100°C.

<Second embodiment>

A material for forming an underlayer film of the second embodiment is used for a multi-layer resist process.

The solid content of the material for forming an underlayer film satisfies the following (i) to (iii):

(i) an elemental composition ratio Re defined by the following mathematical formula (1) is 1.5 to 2.8;
(ii) a glass transition temperature is 30°C to 250°C; and
(iii) the solid content contains a resin having a structural unit represented by the following general formula (1).

$$Re = \frac{N_H + N_C + N_O}{N_C - N_O} \qquad (1)$$

In the mathematical formula (1),

$N_H$ is the number of hydrogen atoms in the solid content of the material for forming an underlayer film,
$N_C$ is the number of carbon atoms in the solid content of the material for forming an underlayer film, and
$N_O$ is the number of oxygen atoms in the solid content of the material for forming an underlayer film.

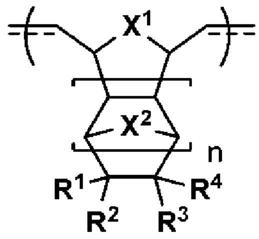

(1)

In the general formula (1),

$R^1$ to $R^4$ are each independently any group selected from the group consisting of a hydrogen atom, an aryl group having 6 to 20 carbon atoms, an aryloxy group having 6 to 20 carbon atoms, an aryloxyalkyl group having 7 to 20 carbon atoms, an aryloxycarbonyl group having 7 to 20 carbon atoms, an alkylarylaminocarbonyl group having 8 to 20 carbon atoms, an alkoxycarbonylaryl group having 8 to 30 carbon atoms, and an aryloxycarbonylalkyl group having 8 to 20 carbon atoms, at least one of $R^1$ to $R^4$ is a group other than a hydrogen atom, and $R^1$ to $R^4$ may be bonded to each other to form a ring structure,
n represents an integer of 0 to 2, and
$X^1$ and $X^2$ each independently represent $-CH_2-$ or -O-.

In the second embodiment, the technical significance that the elemental composition ratio Re of the solid content is 1.5 to 2.8 and the glass transition temperature of the solid content is 30 to 250°C is the same as in the first embodiment. Therefore, the description thereof will not be repeated. Incidentally, in the second embodiment, Re is preferably 1.8 to 2.5, and more preferably 1.8 to 2.4.

In the second embodiment, preferred modes of the resin itself having the structural unit represented by the general formula (1) are the same as those in the first embodiment. Therefore, the description thereof will not be repeated.

Also in the second embodiment, the elemental composition ratio Re' defined by the mathematical formula (2) is preferably 1.5 to 2.8.

As an example, the underlayer film forming material of the second embodiment preferably further contains a resin having a structural unit represented by the general formula (B) in addition to the resin having the structural unit represented by the general formula (1). More preferably, in the second embodiment, the underlayer film forming material of the second embodiment preferably contains a resin having a structural unit represented by the general formula (b) in addition to the resin having the structural unit represented by the general formula (1).

The general formula (B) and the general formula (b) are as described in the first embodiment.

In a case where the resin having the structural unit represented by the general formula (1) and the resin having the structural unit represented by the general formula (B) are used in combination, the mass ratio thereof is usually resin having the structural unit represented by the general formula (1)/resin having the structural unit represented by the general formula (B) = 5/95 to 95/5, preferably 10/90 to 90/10, more preferably 20/80 to 80/20, and still more preferably 40/60 to 60/40.

As another example, the underlayer film forming material of the second embodiment preferably further contains a resin having a structural unit represented by the general formula (A) in addition to the resin having the structural unit represented by the general formula (1). More preferably, in the second embodiment, the underlayer film forming material of the second embodiment preferably contains a resin having a structural unit represented by the general formula (a1) or (a2) in addition to the resin having the structural unit represented by the general formula (1).

The general formula (A) and the general formulas (a1) and (a2) are as described in the first embodiment.

The mass ratio of the resin having the structural unit represented by the general formula (1) to the resin having the structural unit represented by the general formula (A) is usually resin having the structural unit represented by the general formula (1)/resin having the structural unit represented by the general formula (A) = 100/0 to 5/95, preferably 100/0 to 15/85, more preferably 100/0 to 30/70, and still more preferably 100/0 to 45/55.

It should be noted that the underlayer film forming material of the second embodiment may contain a resin which is neither the resin having the structural unit represented by the general formula (A) nor the resin having the structural unit represented by the general formula (B), as long as the solid content satisfies the above (i) to (iii) . For example, the underlayer film forming material of the second embodiment may contain polyhydroxystyrene as another resin.

The mass ratio of the resin having the structural unit represented by the general formula (1) to the other resin is usually resin having the structural unit represented by the general formula (1)/the other resin = 100/0 to 55/45, preferably 100/0 to 60/40, and more preferably 100/0 to 70/30.

The method for preparing the underlayer film forming material of the second embodiment, the solvent that can

be used, and the like are the same as those of the first embodiment. Therefore, the description thereof will not be repeated.

<Resist underlayer film>

A resist underlayer film can be produced (formed) by using a material for forming an underlayer film.

The method of producing the resist underlayer film includes a step of forming a coating film containing the material for forming an underlayer film on the substrate (hereinafter, also referred to as a "coating film forming step").

Further, the method may perform a step of heating the coating film (hereinafter, also referred to as a "heating step") as necessary.

By using the above-described material for forming an underlayer film (first embodiment or second embodiment), it is possible to produce a resist underlayer film having good etching resistance and excellent embedding property and flatness.

In particular, the material for forming an underlayer film of the first embodiment or the second embodiment is excellent in embedding property with respect to a substrate having a complicated shape. Therefore, on a substrate having a complicated shape such as a substrate having a step or a substrate having a plurality of kinds of trenches, a resist underlayer film satisfying etching resistance and excellent in embedding property and flatness can be formed.

Incidentally, the etching resistance can be calculated by, for example, the formula of "etching rate of resist underlayer film for reference obtained by using polyhydroxystyrene/etching rate of target underlayer film" when oxygen plasma etching is performed. The value obtained by this formula is preferably 1.03 to 3.00, more preferably 1.05 to 2.00.

For details of oxygen plasma etching, refer to Examples below.

Hereinafter, each step will be described, but the present invention is not limited thereto.

[Coating film forming step]

The underlayer film forming material of the first embodiment or the second embodiment contains a specific resin, or contains two or more specific resins, so that the underlayer film forming material can be cleanly applied to a substrate and a coating film having a uniform film thickness can be obtained.

In the coating film forming step, a coating film is formed on the substrate by using the material for forming an underlayer film.

Examples of the substrate include a silicon wafer, an aluminum wafer, and a nickel wafer.

An uneven structure may be provided on a surface of the substrate . The uneven structure may be a structure in which a coating film is formed of a low dielectric material such as a silica ($SiO_2$) film, a SiCN film, a SiOC film obtained by doping silica ($SiO_2$) with carbon (C), a methylsiloxane-based organic film (SOG), or a silica insulating film in which minute holes having a diameter of several nanometers or less are uniformly distributed.

By using the material for forming an underlayer film of the first embodiment or the second embodiment, the embedding property in the uneven structure is improved. Further, a resist underlayer film having excellent flatness can be formed. In particular, even in a case where a substrate having a complicated shape such as a substrate having a step or a substrate having a plurality of types of trenches is used, good embedding property and flatness can be easily obtained.

Examples of the substrate having a plurality of trenches include a substrate having different aspect ratios. A substrate having various aspect ratios can be used. For example, in the trenches of the substrate, the ratio between the maximum value and the minimum value among the aspect ratios is preferably in a range of 1 to 30, more preferably in a range of 1 to 25, and still more preferably in a range of 1 to 20.

The method for forming the coating film (coating method) is not particularly limited. Examples thereof include a method of coating the substrate with the above-described varnish-like material for forming an underlayer film using a method such as spin coating, solution cast coating, roll coating, slit coating, or ink jet coating.

At this time, the film thickness of the resist underlayer film formed from the bottom of the recess portion on the substrate to the atmospheric surface is not particularly limited. For example, the average value $H_{av}$ described later is preferably 5 to 2000 nm, more preferably 5 to 1000 nm, and still more preferably 5 to 500 nm.

[Heating step]

In the heating step, the coating film formed in the coating film forming step is heated. The temperature of heating the coating film is preferably 100°C to 400°C, more preferably 150°C to 300°C, and still more preferably 180°C to 250°C. The heating time is preferably 5 seconds to 60 minutes, more preferably 10 seconds to 10 minutes, and still more preferably 30 seconds to 3 minutes. The coating film may be heated in an air atmosphere or an inert gas atmosphere such as nitrogen gas or argon gas; and the like.

Examples of the heating mode include a mode in which the coating film is heated for the purpose of removing

a solvent in the coating film and allowed to flow by being heated thereafter to be embedded in the uneven structure of the substrate; a mode in which a foreign substance such as a thermosetting material mixed for the purpose of compensating for the function within the range where the effects of the present invention are not impaired is cured and allowed to flow by being heated thereafter to be embedded in the uneven structure of the substrate; and a mode in which the coating film is heated for the purpose of separating a leaving group in the material for forming an underlayer film and allowed to flow by being heated thereafter to be embedded in the uneven structure of the substrate.

The coating film may be heated by performing a multi-stage process of increasing the temperature in a stepwise manner.

The resist underlayer film thus obtained can be used as a step member for forming a pattern using photolithography.

It is preferable that the solvent resistance of the underlayer film obtained by using the material for forming an underlayer film of the first embodiment or the second embodiment is good. This makes it more difficult to cause intermixing in a case where another layer (for example, resist layer) is placed on top of the resist underlayer film.

For example, the residual film rate measured in the following procedures (1) to (3) is preferably 50% or more, more preferably 50% to 100%, still more preferably 60% to 100%, particularly preferably 70% to 100%, and particularly preferably 80% to 100%.

[Procedure]

(1) The material for forming an underlayer film is applied onto a substrate, dried at 120°C for 1 minute, cooled to room temperature, and then heated at 300°C for 1 minute to form a film. The film thickness at this time is denoted by a. a is typically adjusted to 300 to 400 nm, preferably 350 nm.

(2)The film formed in (1) is immersed in a mixed solvent of propylene glycol monomethyl ether (PGME)/propylene glycol-1-monomethyl ether-2-acetate (PGMEA) in a mass ratio of 7/3 at 23°C for 5 minutes.

(3) The film after immersion in (2) is heated at 150°C for 3 minutes to dry the solvent. The film thickness at this time is denoted by b. Then, the residual film rate is calculated by the formula (b/a) $\times$ 100 (%).

In the material for forming an underlayer film of the first embodiment or the second embodiment, the residual film rate tends to be high, especially when a specific resin is used in combination.

The reason why a mixed solvent having a mass ratio of PGME/PGMEA of 7/3 is used in (2) of the above procedure is that PGME or PGMEA is often used as a solvent for a material used for forming an intermediate layer or a resist layer provided on an upper layer of a resist underlayer film.

By setting the residual film rate to 50% or more, in a case where an intermediate layer such as a hard mask or a resist layer is formed on the resist underlayer film, dissolution of the resist underlayer film or intermixing of the resist underlayer film and the intermediate layer and/or the resist layer more than necessary can be suppressed. As a result, the adhesion between the intermediate layer and the resist underlayer film becomes appropriate, and a laminate having more excellent flatness can be realized.

<Laminate>

The laminate includes a substrate and a resist underlayer film formed using a material for forming an underlayer film on one surface of the substrate.

It is preferable that the laminate has a structure in which the substrate is in contact with the resist underlayer film.

Here, since the resist underlayer film and the method of producing the resist underlayer film have already been described in the above <Resist underlayer film> section, the description thereof will not be repeated.

Fig. 1 shows schematic views for describing a structure of the laminate. More specifically, Fig. 1 shows schematic views for describing the film thickness 4 of the resist underlayer film 2, the height 5 of the uneven structure 7, and the interval 6 between projections of the uneven structure 7 in the laminate 10.

Of the four laminates 10 shown in Fig. 1, the upper left and lower left views are schematic views in a case where (a) the substrate 1 has an uneven structure. The upper right and lower right views are schematic views (b) in a case where the substrate 1 has no uneven structure. The upper left view and the lower left view basically show the same laminate. Similarly, the upper right view and the lower right view basically show the same laminate. However, for the sake of explanation, the symbols, auxiliary lines, and the like are changed in the upper views and the lower views.

The substrate 1 may have a structure having a flat surface as in (b), but it is preferable that the substrate 1 has an uneven structure 7 on one side or both sides thereof as in (a). The height of the unevenness in the uneven structure 7 is preferably in a range of 5 to 500 nm, more preferably 7 to 450 nm, and still more preferably 10 to 400 nm.

Here, the "height" of the unevenness indicates the height 5 of the uneven structure 7 shown in Fig. 1. In a case where it is desired to obtain the "average height" of the entire substrate 1, for example, the height 5 of the uneven structure 7 may be arbitrarily measured at 10 points, and the average value thereof may be adopted.

Further, the interval between projections in the uneven structure 7 is preferably 1 nm to 10 mm. The lower limit value of the interval between projections in the uneven structure 7 is more preferably 3 nm or more, more preferably 5 nm or more, and particularly preferably 10 nm or more.

Here, the interval between projections in the uneven structure 7 means the interval between projections 6 in the uneven structure 7 shown in Fig. 1. In a case where it is desired to obtain the "average interval between projections" of the entire substrate 1, for example, the interval between projections 6 of the uneven structure 7 may be arbitrarily measured at 10 points, and the average value thereof may be adopted.

The upper limit value of the interval between projections in the uneven structure 7 is more preferably 5 mm or less, more preferably 1 mm or less, and particularly preferably 0.5 mm or less.

In a case where the substrate 1 has a fine uneven structure as described above, the effect of the resist underlayer film 2 tends to be more remarkably exhibited.

The thickness of the substrate 1 is preferably 0.01 to 10000 μm. The lower limit value of the thickness of the substrate 1 is more preferably 0.03 μm or more, still more preferably 0.05 μm or more, and particularly preferably 0.10 μm or more.

The upper limit value of the thickness of the substrate 1 is more preferably 5000 μm or less, still more preferably 3000 μm or less, and particularly preferably 1000 μm or less.

Here, in a case where the substrate 1 has the uneven structure 7, it is preferable that the thickness of the thinnest portion and the thickness of the thickest portion of the substrate 1 are within the above numerical ranges.

In the resist underlayer film 2, the flatness (ΔFT) of the surface 3 on the side opposite to the substrate, which is calculated by the following mathematical formula, is preferably 0% to 5%, more preferably 0% to 3%, still more preferably 0% to 1.5%, and particularly preferably 0% to 1%.

$$\Delta FT = \{(H_{max} - H_{min})/H_{av}\} \times 100\ (\%)$$

In the mathematical formula,

$H_{av}$ is, when a film thickness of the resist underlayer film is measured at any 10 locations on the surface 3, an average value of the film thickness,
$H_{max}$ is a maximum value of the film thickness of the resist underlayer film, and
$H_{min}$ is a minimum value of the film thickness of the resist underlayer film.

In a case where the substrate is uneven, the $H_{av}$, $H_{max}$, and $H_{min}$ are obtained by measuring the distance (the film thickness 4 shown in the lower left laminate 10 in Fig. 1) from the bottom surface of the recess portion to the upper surface of the resist underlayer film (the interface with the atmosphere) . In other words, in a case where the substrate is uneven, a portion having a recess portion is selectively measured at 10 locations, and $H_{av}$, $H_{max}$, and $H_{min}$ are obtained.

As described above, by using the material for forming an underlayer film of the present embodiment, it is possible to obtain a resist underlayer film having good flatness.

By obtaining a resist underlayer film having good flatness, the thickness of the resist layer can be made more uniform regardless of the presence or absence of the intermediate layer. As a result, a desired pattern can be obtained with good reproducibility in lithography.

In summary, the laminate obtained by using the underlayer film forming material of the first embodiment or the second embodiment has good (i) residual film rate, (ii) flatness, (iii) etching resistance, and the like. From these viewpoints, the laminate can also be expressed as follows. Such a laminate having a balance of residual film rate, flatness and etching resistance is extremely useful for producing an advanced semiconductor device.

A laminate including:

a substrate; and
a resist underlayer film formed of the material for forming an underlayer film on one surface of the substrate,
in which the laminate has at least the following characteristics (i) to (iii):

(i) The residual film rate of the material for forming an underlayer film, which is measured by the following procedures (1) to (3), is 80% or more.

<Procedure>

(1) The material for forming an underlayer film is applied onto a substrate, dried at 120°C for 1 minute, cooled to room temperature, and then heated at 300°C for 1 minute to form a film. The film thickness at this time is denoted by a.
(2)The film formed in (1) is immersed in a mixed solvent of propylene glycol monomethyl ether/propylene glycol-1-monomethyl ether-2-acetate in a mass ratio of 7/3 at 23°C for 5 minutes.
(3) The film after immersion in (2) is heated at 150°C for 3 minutes to dry the solvent. The film thickness at this time is denoted by b. Then, the residual film rate is calculated by the formula (b/a) × 100 (%).

(ii) The flatness $\Delta FT$ of a surface $\alpha$ of the resist underlayer film on a side opposite to the substrate which is calculated using the following mathematical formula is 0% to 1.5%.

$$\Delta FT = \{(H_{max} - H_{min})/H_{av}\} \times 100\ (\%)$$

In the mathematical formula,
$H_{av}$ is, when a film thickness of the resist underlayer film is measured at any 10 locations on the surface $\alpha$, an average value of the film thickness,
$H_{max}$ is a maximum value of the film thickness of the resist underlayer film, and
$H_{min}$ is a minimum value of the film thickness of the resist underlayer film.

(iii) The value of the etching resistance calculated by the formula of "etching rate of the resist underlayer film for reference obtained by using polyhydroxystyrene/etching rate of the target underlayer film" is 1.03 to 3.00.

<Pattern forming method>

A pattern forming method includes (i) a step of forming a resist pattern on an upper surface side of the resist underlayer film as described above (hereinafter, also referred to as a "resist pattern forming step"); and (ii) a step of sequentially etching the resist underlayer film and the substrate using the resist pattern as a mask (hereinafter, also referred to as an "etching step").

Further, the pattern forming method may be performed by forming an intermediate layer on an upper surface side of the resist underlayer film to form a resist pattern on an upper surface side of the intermediate layer in the resist pattern forming step and etching the intermediate layer in the etching step.

The material for forming an underlayer film of the first embodiment or the second embodiment preferably contains two or more specific resins. For example, in a case where the resin having the structural unit represented by the general formula (1) alone has low etching resistance, etching resistance can be enhanced by combining the resin having the structural unit represented by the general formula (A) and/or the resin having the structural unit represented by the general formula (B) with an appropriate composition. By using the material for forming an underlayer film of the first embodiment or the second embodiment, it is possible to produce a resist underlayer film having good etching resistance and good flatness. Thus, a good pattern can be formed.

Further, in particular, in a case where the material for forming an underlayer film contains the resin having the structural unit represented by the general formula (1) described above, intermixing due to the solvent contained in the material for forming the intermediate layer and the material for forming the resist pattern can be suppressed. The flatness of the resist underlayer film is further improved, and a better pattern is easily formed.

Hereinafter, each step will be described, but the present invention is not limited thereto.

[Resist pattern forming step]

In the present step, a resist pattern is formed on the upper surface side of the resist underlayer film. Alternatively, an intermediate layer may be formed on the upper surface side of the resist underlayer film, and a resist pattern may be formed on the upper surface side of this intermediate layer.

The intermediate layer indicates a layer that compensates for the functions of the resist underlayer film and/or the resist film or has these functions for imparting the functions that the resist underlayer film and/or the resist film does not have in the formation of the resist pattern or the like. For example, in a case where an anti-reflective layer (also referred to as an anti-reflection layer) is formed as an intermediate layer, the intermediate layer can compensate for the anti-reflection function of the resist underlayer film. As another example, in a case where a hard mask layer is formed

as an intermediate layer, the influence on the resist underlayer film at the time of using an alkali developer is suppressed and/or the insufficient etching resistance of the resist pattern formation layer at the time of etching the substrate formed of silicon, aluminum, nickel, and the like of the lower layer after the resist underlayer film is etched can be compensated.

Furthermore, the intermediate layer may be provided with either or both functions of the anti-reflective layer and the hard mask layer. In the layer structure, the anti-reflective layer or the hard mask layer may be formed directly above the resist underlayer film. The material and physical properties of the intermediate layer may be appropriately selected in consideration of the characteristics and productivity of the resist material, the material such as the processed substrate, and the like.

The intermediate layer can be formed of an organic compound, an inorganic oxide, or the like. Examples of the organic compound include DUV-42, DUV-44, ARC-28, and ARC-29 (manufactured by Brewer Science, Inc.); and AR-3 and AR-19 (manufactured by Rohm and Haas Company). Further, examples of the inorganic oxide include NFC SOG Series (manufactured by JSR Corporation), and polysiloxane, titanium oxide, alumina oxide, and tungsten oxide formed using a CVD method.

The method of forming the intermediate layer is not particularly limited. Examples thereof include a coating method and a CVD method. Among these, a coating method is preferable. In a case of using the coating method, the intermediate layer can be continuously formed after formation of the resist underlayer film.

The film thickness of the intermediate layer is not particularly limited. The film thickness may be appropriately selected according to the function required for the intermediate layer and the like. Typically, the film thickness is 1 nm to 5 $\mu$m, preferably 5 nm to 3 $\mu$m, and more preferably 10 nm to 0.3 $\mu$m.

Examples of the method of forming the resist pattern on the upper surface side of the resist underlayer film or the intermediate layer include a method of using photolithography.

The method of using photolithography may include a step of forming a resist film on the upper surface side of the resist underlayer film using a resist composition or the like (hereinafter, also referred to as a "resist film forming step") ; a step of exposing the resist film (hereinafter, also referred to as an "exposing step"), and a step of developing the exposed resist film (hereinafter, also referred to as a "developing step").

Hereinafter, these steps will be described.

(Resist film forming step)

In the present step, the resist film is formed on the upper surface side of the resist underlayer film using the resist composition. Specifically, the resist film is formed by coating the surface with the resist composition such that the resist film to be obtained has a predetermined film thickness and then allowing the solvent in the coating film to volatilize by performing pre-baking.

Examples of the resist composition include a positive type or negative type chemically amplified resist composition containing a resin a photoacid generator; a positive type resist composition formed of an alkali-soluble resin and a quinone diazide-based photosensitive agent; and a negative type resist composition formed of an alkali-soluble resin and a crosslinking agent.

The solid content concentration of the resist composition may be selected within an appropriate range in consideration of the target film thickness and productivity. The solid content concentration is preferably in a range of 0.1% to 50% by mass, more preferably 0.5% to 50% by mass, and still more preferably 1.0% to 50% by mass.

It is preferable that the resist composition is prepared by being filtered through a filter having a pore diameter of approximately 0.1 $\mu$m.

As the resist composition, a commercially available resist composition can be used as it is.

The method of coating using the resist composition is not particularly limited. The method can be performed using a spin coating method, a cast coating method, or a roll coating method.

The prebake temperature may be appropriately selected depending on the kind of resist composition used and the like. Typically, the prebake temperature is 30°C to 200°C, preferably 50°C to 150°C.

(Exposing step)

In the present step, the resist film formed in the resist film forming step is exposed. The resist film is exposed through, for example, a predetermined mask pattern and liquid immersion as necessary.

The exposure light is appropriately selected from electromagnetic waves such as visible light, ultraviolet rays, far ultraviolet rays, X rays, and $\gamma$ rays; and particle beams such as electron beams, molecular beams, ion beams, and $\alpha$ rays depending on the kind of the photoacid generator used in the resist composition. Among these, far ultraviolet rays are preferable; KrF excimer laser light (248 nm), ArF excimer laser light (193 nm), $F_2$ excimer laser light (wavelength of 157 nm), $Kr_2$ excimer laser light (wavelength of 147 nm), ArKr excimer laser light (wavelength of 134 nm), or extreme ultraviolet rays (wavelength of 13 nm and the like) are more preferable, and ArF excimer laser light is still more preferable.

After the exposure, post-baking can be performed in order to improve the resolution, the pattern profile, and the developability of the resist pattern to be formed (post exposure bake). The temperature at this time may be appropriately adjusted depending on the kind of resist composition used and the like. Typically, the temperature is 50°C to 200°C, preferably 70°C to 150°C.

(Developing step)

In the present step, the resist film exposed in the exposing step is developed.

The developer used in the development may be appropriately selected depending on the kind of the resist composition to be used. In a case of alkali development, examples of the developer include an alkaline aqueous solution such as sodium hydroxide, potassium hydroxide, sodium carbonate, sodium silicate, sodium metasilicate, ammonia, ethylamine, n-propylamine, diethylamine, di-n-propylamine, trimethylamine, methyl diethylamine, dimethyl ethanolamine, triethanolamine, tetramethyl ammonium hydroxide, tetraethyl ammonium hydroxide, pyrrole, piperidine, choline, 1,8-diazabicyclo[5.4.0]-7-undecene, or 1,5-diazabicyclo[4.3.0]-5-nonene.

An appropriate amount of a surfactant or a water-soluble organic solvent of alcohols such as methanol or ethanol can be added to these alkaline aqueous solutions.

Further, a developer containing an organic solvent can be used as the developer. Examples of the organic solvent include esters, ketones, ethers, alcohols, amides, and hydrocarbons. The solvent used in the organic solvent development is appropriately selected depending on the characteristics of the resist underlayer film.

By forming the intermediate layer as described above, the influence of the developer on the resist underlayer film can be suppressed.

After the development using the developer, a predetermined resist pattern is formed by performing washing and drying on the resist film.

Further, the method of performing the resist pattern forming step may also be a method of using a nanoimprint method or a method of using a self-assembled composition in addition to the method of using photolithography described above.

[Etching step]

In the present step, the resist underlayer film and the substrate are sequentially etched using the obtained resist pattern as a mask. In this manner, the pattern is formed on the substrate. Further, in a case of forming an intermediate layer, the intermediate layer is also etched.

The above-described etching may be dry etching or wet etching. The dry etching can be performed using a known dry etching device. In addition, examples of the source gas at the time of dry etching include gas containing an oxygen atom such as $O_2$, CO, or $CO_2$; inert gas such as $H_e$, $N_2$, or Ar; chlorine-based gas such as $Cl_2$ or $BCl_3$; fluorine-based gas such as $CHF_3$ or $CF_4$; and gas such as $H_2$ or $NH_3$. Further, these gases can be used by being mixed. The composition of the source gas may be appropriately selected depending on the elemental composition of the object to be etched and the like.

[Step of removing unnecessary resist underlayer film and the like]

In the present step, an unnecessary resist underlayer film and the like is removed after the resist pattern is transferred to the substrate and formed thereon in the etching step. The removal method may be a dry method, a wet method using a solvent or the like, or a combination thereof. The removal method may be appropriately selected in consideration of the physical properties of the material and the process adaptability.

In a case of the dry method, a dry etching device used in the etching step can be used. Therefore, there is no need to change the production line from the etching step to the removing step. That is, the dry method is preferably used from the viewpoint of productivity.

In the removing step, examples of the gas source in the case of using a dry etching apparatus include gas containing an oxygen atom such as $O_2$, CO, or $CO_2$; inert gas such as $H_e$, $N_2$, or Ar; chlorine-based gas such as $Cl_2$ or $BCl_3$; fluorine-based gas such as $CHF_3$ or $CF_4$; and gas such as $H_2$ or $NH_3$. Further, these gases may be used in the form of a mixture of two or more kinds thereof. The composition of the gas source is appropriately selected depending on the elemental composition of the object to be etched or the like.

Although the embodiments of the present invention have been described above, these are examples of the present invention, and various configurations other than the above can be adopted. Further, the present invention is not limited to the embodiments described above, and modifications, improvements, and the like within the range in which the object of the present invention can be achieved are included in the present invention.

EXAMPLES

Hereinafter, the present embodiment will be described in detail with reference to examples and comparative examples. The present embodiment is not limited to the description of these examples.
First, various measurement/evaluation methods will be described.

[Measurement of weight-average molecular weight (Mw) and molecular weight distribution (Mw/Mn) of polymer]

The weight-average molecular weight (Mw) and the number-average molecular weight (Mn) of the polymer dissolved in tetrahydrofuran (THF) were measured using gel permeation chromatography (GPC) under the following conditions. Then, the molecular weight was calibrated based on polystyrene standard.

- RI-2031 and 875-UV (manufactured by JASCO Corporation) or Model 270 (manufactured by Viscotec GmbH.)
- Serially connected column: Shodex K-806M, 804, 803, 802.5
- Column temperature: 40°C
- Flow rate: 1.0 ml/min
- Sample concentration: 3.0 to 9.0 mg/ml

[Glass transition temperature]

The glass transition temperature was measured by heating a measurement sample at a heating rate of 10°C/min in a nitrogen atmosphere using a differential scanning calorimeter DSC-50 manufactured by Shimadzu Corporation. The midpoint of the heat curve representing the phase transition from the solid state to the glass state was used as the glass transition temperature.

[Elemental analysis]

The carbon atom, hydrogen atom and nitrogen atom were measured using an apparatus "CHN coder MT-6 type" manufactured by Yanaco Analytical Systems, Inc. The oxygen atom was measured using an apparatus "vario EL III type" manufactured by Elementar.

[Calculation of elemental composition ratio (Re and Re')]

Using the above elemental analysis values, the elemental composition ratios (Re and Re') were calculated according to the above formula.

[Uneven substrate used for evaluating embedding property/flatness]

Substrate A: A silicon substrate having a size of 3 cm × 3 cm, in which a line and space pattern with a height of 200 nm, a projection width of 40 to 150 nm, and a width between projections of 40 to 150 nm was formed on the surface of the substrate was used.
Hereinafter, this substrate will also be referred to as an "uneven substrate for evaluation".

[Evaluation of embedding property]

A sample in which a resist underlayer film was formed on the uneven surface of the uneven substrate for evaluation was cracked and surfaced for cross-sectional observation. Thereafter, the embedding property was evaluated by observing the cross section of the substrate at a portion having a width between projections of 40 nm using a scanning electron microscope JSM-6701F manufactured by JASCO Corporation (hereinafter, also noted as a SEM) . Incidentally, regarding the method for forming a resist underlayer film, please refer to the examples and comparative examples.

[Evaluation of flatness]

In the above-mentioned substrate cross section evaluated for embedding property, the height from the bottom surface of the recess to the atmospheric surface in the area of the projection width of 40 nm and the width between projections of 120 nm was measured at 10 points, and the average value was taken as $H_{av}$.
Next, the flatness showing the index of the flatness was calculated using the following equation based on each of the maximum height ($H_{max}$) and the minimum height ($H_{min}$) from the ten measured heights.

$$\text{Flatness } (\Delta FT) = \{(H_{max} - H_{min})/H_{av}\} \times 100 \ (\%)$$

[Measurement of residual film rate]

The material for forming an underlayer film was spin-coated on a 4-inch silicon wafer, dried at 120°C for 1 minute, cooled to room temperature, and then heated at 300°C for 1 minute. As a result, a coat film having a thickness of 300 to 400 nm was formed. After cooling at room temperature, the coating film was cut out to a size of 20 mm × 10 mm.
The cut out coat film was immersed in an organic solvent (mixed solvent of propylene glycol monomethyl ether (PGME)/propylene glycol-1-monomethyl ether-2-acetate (PGMEA) in a mass ratio PGME/PGMEA = 7/3 at 23°C for 5 minutes.
Then, the coat film was heated at 150°C for 3 minutes to dry and remove the residual solvent in the coat film. The thickness b of the coating film at this time was measured, and the residual film rate film ratio ((b/a) × 100 (%)) was calculated.

[Evaluation of plasma etching characteristics]

The resist underlayer film formed on the silicon wafer was placed in the chamber, and the inside of the chamber was evacuated to $5 \times 10^{-6}$ Torr ($6.7 \times 10^{-4}$ Pa). Then, oxygen was flowed into the chamber at 50 sccm (about 8.3 × 10-7 $m^3$/s), and the pressure inside the chamber was adjusted to 0.15 Torr (20 Pa).
Then, 100 W of oxygen plasma was irradiated.

[Method of measuring etching rate]

Using a spectroscopic ellipsometer GES5E manufactured by Semilab Inc., the film thickness of the surface of the substrate was measured before etching (0 seconds), after 60 seconds etching, after 180 seconds etching, and after 300 seconds etching. The measurement was performed at any three points in the film, and the average value was adopted as the film thickness. As a result, film thickness data was obtained at etching times of 0 seconds, 60 seconds, 180 seconds, and 300 seconds.
These film thickness data were plotted with time (seconds) on the horizontal axis and reduced film thickness (nm) on the vertical axis, and approximated by a straight line (linear function). The etching rate (nm/sec) was calculated from the inclination of the obtained graph.

[Example 1]

(Synthesis of cyclic olefin polymer)

In a 125 mL glass autoclave provided with a magnetic stirrer in a nitrogen atmosphere, 12.9 g (0.071 mol) of 1,4,4a,9a-tetrahydro-1,4-methanofluorene and 0.65 g (0.008 mol) of 1,5-hexadiene were dissolved in 50.9 g of tetrahydrofuran (hereinafter, referred to as THF), and the solution was stirred.
As a ring opening metathesis polymerization catalyst, 10.8 mg (0.014 mmol) of $Mo(N\text{-}2,6\text{-}Pr^i{}_2C_6H_3)(CHCMe_2Ph)(OCMe(CF_3)_2)_2$ was added thereto to cause a reaction at 60°C for 1 hour. Then, 3.06 mg (0.04 mmol) of n-butyraldehyde was added, and the mixture was further heated at 60°C for 30 minutes.
Then, the mixture was cooled to obtain 63.8 g of a ring opening metathesis polymer solution. The obtained polymer had a polymerization rate of 100%, Mw = 5800, and Mw/Mn = 2.54.
Next, the cyclic olefin polymer was precipitated from the obtained ring opening metathesis polymer solution using methanol and dried at 80°C under reduced pressure, thereby obtaining a white powder solid (polymer 1).
The polymer 1 contains the structural unit represented by the general formula (2) described above.
The glass transition temperature of the polymer 1 was 121°C.

(Preparation of material for forming underlayer film)

The obtained polymer 1 was dissolved in a mixed solvent of propylene glycol-1-monomethyl ether-2-acetate (hereinafter also referred to as PGMEA) and cyclohexanone (hereinafter also referred to as CH) in a mass ratio of PGMEA/CH = 5/5 to prepare a solution having a concentration of 10% by mass. As a result, a material for forming an underlayer film was obtained.
The obtained material for forming an underlayer film was spin-coated on a silicon substrate without a pattern under the conditions of 1000 rpm and 10 sec, and heated at 300°C for 1 minute in a nitrogen atmosphere to form a film.

Elemental analysis was performed using a white powder obtained by scraping a part of this film with a spatula as a sample. The elemental analysis values were C = 92.1% by mass and H = 8.1% by mass, and the elemental composition ratio (Re and Re') calculated from the elemental analysis value was 2.1.

(Evaluation)

The obtained material for forming an underlayer film was applied to the surface of the above-mentioned uneven substrate for evaluation under the conditions of 1000 rpm and 10 sec. Thereafter, the surfaces were heated at 300°C for 1 minute in a nitrogen atmosphere. As a result, a resist underlayer film was formed.

The cross section of the substrate was observed by SEM as described in the above [Evaluation of embedding property] and [Evaluation of flatness] described above. As a result, the polymer 1 in the material for forming an underlayer film was uniformly embedded in the groove having a narrow line width of 40 nm (height 200 nm) between the projections without defects such as voids. $H_{av}$ was 278 nm, $H_{max}$ was 278 nm, $H_{min}$ was 278 nm, and the flatness (ΔFT) was 0.0%. That is, the embedding property and flatness were very good.

Further, the residual film rate measured as described in the above [Measurement of residual film rate] using the obtained material for forming an underlayer film was 100%. That is, the residual film rate was very good.

[Example 2]

(Synthesis of cyclic olefin polymer)

In a 125 mL glass autoclave provided with a magnetic stirrer in a nitrogen atmosphere, 10.1 g (0.071 mol) of 1,4-dihydro-1,4-methanonaphthalene and 0.65 g (0.008 mol) of 1, 5-hexadiene were dissolved in 50.9 g of THF, and the solution was stirred.

As a ring opening metathesis polymerization catalyst, 10.8 mg (0.014 mmol) of $Mo(N-2,6-Pr^i_2C_6H_3)(CHCMe_2Ph)(OCMe(CF_3)_2)_2$ was added thereto to cause a reaction at 60°C for 1 hour. Then, 3.06 mg (0.04 mmol) of n-butyraldehyde was added, and the mixture was further heated at 60°C for 30 minutes.

Then, the mixture was cooled to obtain 61.0 g of a ring opening metathesis polymer solution. The obtained polymer had a polymerization rate of 100%, Mw = 6000, and Mw/Mn = 2.51.

Next, the cyclic olefin polymer was precipitated from the obtained ring opening metathesis polymer solution using methanol and dried at 80°C under reduced pressure, thereby obtaining a white powder solid (polymer 2).

The polymer 2 contains the structural unit represented by the general formula (6) described above.

The glass transition temperature of the polymer 2 was 140°C.

(Preparation of material for forming underlayer film)

The obtained polymer 2 was dissolved in a mixed solvent having a mass ratio of PGMEA and CH of PGMEA/CH = 5/5 to prepare a solution having a concentration of 10% by mass. As a result, a material for forming an underlayer film was obtained.

The obtained material for forming an underlayer film was spin-coated on a silicon substrate without a pattern under the conditions of 1000 rpm and 10 sec, and heated at 300°C for 1 minute in a nitrogen atmosphere to form a film. Elemental analysis was performed using a white powder obtained by scraping a part of this film with a spatula as a sample. The elemental analysis values were C = 92.7% by mass and H = 7.4% by mass, and the elemental composition ratio (Re and Re') calculated from the elemental analysis value was 2.0.

(Evaluation)

The obtained material for forming an underlayer film was applied to the surface of the above-mentioned uneven substrate for evaluation under the conditions of 1000 rpm and 10 sec. Thereafter, the surfaces were heated at 300°C for 1 minute in a nitrogen atmosphere. As a result, a resist underlayer film was formed.

The cross section of the substrate was observed by SEM as described in the above [Evaluation of embedding property] and [Evaluation of flatness] described above. As a result, the polymer 2 in the material for forming an underlayer film was uniformly embedded in the groove having a narrow line width of 40 nm (height 200 nm) between the projections without defects such as voids. $H_{av}$ was 253 nm, $H_{max}$ was 254 nm, $H_{min}$ was 253 nm, and the flatness (ΔFT) was 0.4%. That is, the embedding property and flatness were very good.

Further, the residual film rate measured as described in the above [Measurement of residual film rate] using the obtained material for forming an underlayer film was 99%. That is, the residual film rate was very good.

[Example 3]

(Synthesis of cyclic olefin polymer)

In a 125 mL glass autoclave provided with a magnetic stirrer in a nitrogen atmosphere, 15.5 g (0.071 mol) of 6b,7,10,10a-tetrahydro-7,10-methanofluorantene and 0.65 g (0.008 mol) of 1, 5-hexadiene were dissolved in 50.9 g of THF, and the solution was stirred.

As a ring opening metathesis polymerization catalyst, 10.8 mg (0.014 mmol) of Mo(N-2,6-$Pr^i_2C_6H_3$)($CHCMe_2Ph$)($OCMe(CF_3)_2$)$_2$ was added thereto to cause a reaction at 60°C for 1 hour. Then, 3.06 mg (0.04 mmol) of n-butyraldehyde was added, and the mixture was further heated at 60°C for 30 minutes.

Then, the mixture was cooled to obtain 66.3 g of a ring opening metathesis polymer solution. The obtained polymer had a polymerization rate of 100%, Mw = 5400, and Mw/Mn = 2.55.

Next, the cyclic olefin polymer was precipitated from the obtained ring opening metathesis polymer solution using methanol and dried at 80°C under reduced pressure, thereby obtaining a white powder solid (polymer 3).

The polymer 3 contains the structural unit represented by the general formula (5) described above.

The glass transition temperature of the polymer 3 was 138°C.

(Preparation of material for forming underlayer film)

The obtained polymer 3 was dissolved in a mixed solvent having a mass ratio of PGMEA and CH of PGMEA/CH = 5/5 to prepare a solution having a concentration of 10% by mass. As a result, a material for forming an underlayer film was obtained.

The obtained material for forming an underlayer film was spin-coated on a silicon substrate without a pattern under the conditions of 1000 rpm and 10 sec, and heated at 300°C for 1 minute in a nitrogen atmosphere to form a film. Elemental analysis was performed using a white powder obtained by scraping a part of this film with a spatula as a sample. The elemental analysis values were C = 93.7% by mass and H = 6.6% by mass, and the elemental composition ratio (Re and Re') calculated from the elemental analysis value was 1.8.

(Evaluation)

The obtained material for forming an underlayer film was applied to the surface of the above-mentioned uneven substrate for evaluation under the conditions of 1000 rpm and 10 sec. Thereafter, the surfaces were heated at 300°C for 1 minute in a nitrogen atmosphere. As a result, a resist underlayer film was formed.

The cross section of the substrate was observed by SEM as described in the above [Evaluation of embedding property] and [Evaluation of flatness] described above. As a result, the polymer 3 in the material for forming an underlayer film was uniformly embedded in the groove having a narrow line width of 40 nm (height 200 nm) between the projections without defects such as voids. $H_{av}$ was 261 nm, $H_{max}$ was 261 nm, $H_{min}$ was 260 nm, and the flatness (ΔFT) was 0.4%. That is, the embedding property and flatness were very good.

Further, the residual film rate measured as described in the above [Measurement of residual film rate] using the obtained material for forming an underlayer film was 100%. That is, the residual film rate was very good.

[Example 4]

(Synthesis of cyclic olefin polymer)

In a 125 mL glass autoclave provided with a magnetic stirrer in a nitrogen atmosphere, 18.3 g (0.101 mol) of 1,4,4a,9a-tetrahydro-1,4-methanofluorene (monomer A), 1.7 g (0.011 mol) of 4,10-dioxy-tricyclo[5.2.1.0$^{2,6}$]-8-decen-3-one (monomer B), and 1.0 g (0.012 mol) of 1,5-hexadiene were dissolved in 44.4 g of THF, and the solution was stirred.

As a ring opening metathesis polymerization catalyst, 17.1 mg (0.02 mmol) of Mo(N-2, 6-$Pr^i_2C_6H_3$)($CHCMe_2Ph$)($OCMe(CF_3)_2$)$_2$ was added thereto to cause a reaction at 60°C for 1 hour. Then, 4.8 mg (0.07 mmol) of n-butyraldehyde was added, and the mixture was further heated at 60°C for 30 minutes.

Then, the mixture was cooled to obtain 64.4 g of a ring opening metathesis polymer solution. The obtained polymer had a polymerization rate of 100%, Mw = 6100, and Mw/Mn = 2.48. The molar ratio of the structural unit derived from monomer A to the structural unit derived from monomer B analyzed by $^1$H-NMR was A/B = 90/10.

Next, the cyclic olefin polymer was precipitated from the obtained ring opening metathesis polymer solution using methanol and dried at 80°C under reduced pressure, thereby obtaining a white powder solid (polymer 4).

The polymer 4 contains the structural unit represented by the general formula (2) described above.

The glass transition temperature of the polymer 4 was 119°C.

(Preparation of material for forming underlayer film)

The obtained polymer 4 was dissolved in a mixed solvent having a mass ratio of PGMEA and CH of PGMEA/CH = 5/5 to prepare a solution having a concentration of 10% by mass. As a result, a material for forming an underlayer film was obtained.

The obtained material for forming an underlayer film was spin-coated on a silicon substrate without a pattern under the conditions of 1000 rpm and 10 sec, and heated at 300°C for 1 minute in a nitrogen atmosphere to form a film. Elemental analysis was performed using a white powder obtained by scraping a part of this film with a spatula as a sample. The elemental analysis values were C = 89.6% by mass, H = 7.7% by mass, and O = 2.5% by mass, and the elemental composition ratio (Re and Re') calculated from the elemental analysis values was 2.1.

(Evaluation)

The obtained material for forming an underlayer film was applied to the surface of the above-mentioned uneven substrate for evaluation under the conditions of 1000 rpm and 10 sec. Thereafter, the surfaces were heated at 300°C for 1 minute in a nitrogen atmosphere. As a result, a resist underlayer film was formed.

The cross section of the substrate was observed by SEM as described in the above [Evaluation of embedding property] and [Evaluation of flatness] described above. As a result, the polymer 4 in the material for forming an underlayer film was uniformly embedded in the groove having a narrow line width of 40 nm (height 200 nm) between the projections without defects such as voids. $H_{av}$ was 208 nm, $H_{max}$ was 208 nm, $H_{min}$ was 208 nm, and the flatness (ΔFT) was 0.0%. That is, the embedding property and flatness were very good.

Further, the residual film rate measured as described in the above [Measurement of residual film rate] using the obtained material for forming an underlayer film was 94%. That is, the residual film rate was good.

[Example 5]

(Preparation of material for forming underlayer film)

The polymer 1 synthesized in Example 1 and polyhydroxystyrene (hereinafter referred to as PHS; manufactured by Polysciences, Inc., Mw = 5300, Mw / Mn = 1.48) were dissolved in PGMEA/CH = 5/5 at a mass ratio of polymer 1/PHS of 90/10 to prepare a solution. The amount of PGMEA/CH = 5/5 was adjusted so that the concentration was 10% by mass. As a result, a material for forming an underlayer film was obtained.

The obtained material for forming an underlayer film was spin-coated on a silicon substrate without a pattern under the conditions of 1000 rpm and 10 sec, and dried at 120°C for 1 minute in a nitrogen atmosphere to form a film. The glass transition temperature was measured using a white powder obtained by scraping a part of this film with a spatula as a sample. The glass transition temperature was 122°C.

The obtained material for forming an underlayer film was spin-coated on a silicon substrate without a pattern under the conditions of 1000 rpm and 10 sec, and heated at 300°C for 1 minute in a nitrogen atmosphere to form a film. Elemental analysis was performed using a white powder obtained by scraping a part of this film with a spatula as a sample.

The elemental analysis values were C = 91.2% by mass, H = 7.4% by mass, O = 1.1% by mass, and the elemental composition ratio (Re and Re') calculated from the elemental analysis values was 2.0.

(Evaluation)

The obtained material for forming an underlayer film was applied to the surface of the above-mentioned uneven substrate for evaluation under the conditions of 1000 rpm and 10 sec. Thereafter, the surfaces were heated at 300°C for 1 minute in a nitrogen atmosphere. As a result, a resist underlayer film was formed.

The cross section of the substrate was observed by SEM as described in the above [Evaluation of embedding property] and [Evaluation of flatness] described above. As a result, the mixture of polymer 1 and PHS in the material for forming an underlayer film was uniformly embedded in the groove having a narrow line width of 40 nm (height 200 nm) between the projections without defects such as voids. Further, $H_{av}$ was 210 nm, $H_{max}$ was 210 nm, $H_{min}$ was 210 nm, and the flatness (ΔFT) was 0.0%. That is, the embedding property and flatness were very good.

Further, the residual film rate measured as described in the above [Measurement of residual film rate] using the obtained material for forming an underlayer film was 91%. That is, the residual film rate was good.

[Example 6]

(Preparation of material for forming underlayer film)

Novolac resin (manufactured by MEIWA PLASTIC INDUSTRIES, LTD., trade name MER-44S, Mw = 5100, Mw/Mn = 3.55) and naphthol aralkyl resin (manufactured by NIPPON STEEL Chemical & Material Co., Ltd., trade name SN-485, Mw = 480, Mw/Mn = 1.84) were dissolved in PGMEA/CH = 5/5 at a mass ratio of 58/42 of novolac resin/naphthol aralkyl resin to prepare a solution. The amount of PGMEA/CH = 5/5 was adjusted so that the concentration was 10% by mass. As a result, a material for forming an underlayer film was obtained.

The obtained material for forming an underlayer film was spin-coated on a silicon substrate without a pattern under the conditions of 1000 rpm and 10 sec, and dried at 120°C for 1 minute in a nitrogen atmosphere to form a film. The glass transition temperature was measured using a white powder obtained by scraping a part of this film with a spatula as a sample. The glass transition temperature was 110°C.

The obtained material for forming an underlayer film was spin-coated on a silicon substrate without a pattern under the conditions of 1000 rpm and 10 sec, and heated at 300°C for 1 minute in a nitrogen atmosphere to form a film. Elemental analysis was performed using a white powder obtained by scraping a part of this film with a spatula as a sample.

The elemental analysis values were C = 83.0% by mass, H = 6.2% by mass, O = 10.4% by mass, and the elemental composition ratio (Re and Re') calculated from the elemental analysis values was 2.2.

(Evaluation)

The obtained material for forming an underlayer film was applied to the surface of the above-mentioned uneven substrate for evaluation under the conditions of 1000 rpm and 10 sec. Thereafter, the surfaces were heated at 300°C for 1 minute in a nitrogen atmosphere. As a result, a resist underlayer film was formed.

The cross section of the substrate was observed by SEM as described in the above [Evaluation of embedding property] and [Evaluation of flatness] described above. As a result, the mixture of the novolac resin and the naphthol aralkyl resin in the material for forming an underlayer film was uniformly embedded in the groove having a narrow line width of 40 nm (height 200 nm) between the projections without defects such as voids. Further, $H_{av}$ was 195 nm, $H_{max}$ was 195 nm, $H_{min}$ was 195 nm, and the flatness ($\Delta$FT) was 0.0%. That is, the embedding property and flatness were very good.

Further, the residual film rate measured as described in the above [Measurement of residual film rate] using the obtained material for forming an underlayer film was 100%. That is, the residual film rate was good.

[Example 7]

(Synthesis of cyclic olefin polymer)

In a 250 mL glass autoclave provided with a magnetic stirrer in a nitrogen atmosphere, 7.7 g (0.817 mol) of norbornene (monomer A), 12.4 g (0.817 mol) of 4,10-dioxy-tricyclo [5.2.1.$0^{2,6}$]-8-decen-3-one (monomer B), and 1.49 g (0.018 mol) of 1,5-hexadiene were dissolved in 114.0 g of THF, and the solution was stirred.

As a ring opening metathesis polymerization catalyst, 25.0 mg (0.03 mmol) of Mo(N-2,6-$Pr^i_2C_6H_3$)($CHCMe_2Ph$)(OCMe $(CF_3)_2)_2$ was added thereto to cause a reaction at 60°C for 1 hour. Then, 6.5 mg (0.09 mmol) of n-butyraldehyde was added, and the mixture was further heated at 60°C for 30 minutes.

Then, the mixture was cooled to obtain 134 g of a ring opening metathesis polymer solution. The obtained polymer had a polymerization rate of 100%, Mw = 7500, and Mw/Mn = 2.80. The molar ratio of the structural unit derived from monomer A to the structural unit derived from monomer B analyzed by $^1$H-NMR was A/B = 50/50.

Next, the cyclic olefin polymer was precipitated from the obtained ring opening metathesis polymer solution using water and dried at 70°C under reduced pressure, thereby obtaining a white powder solid (polymer 5).

The glass transition temperature of the polymer 5 was 72°C.

(Preparation of material for forming underlayer film)

Polymer 5, novolac resin (manufactured by MEIWA PLASTIC INDUSTRIES, LTD., trade name MER-44S, Mw = 5100, Mw/Mn = 3.55), and naphthol aralkyl resin (manufactured by NIPPON STEEL Chemical & Material Co., Ltd., trade name SN-485, Mw = 480, Mw/Mn = 1.84) were dissolved in PGMEA/CH = 5/5 at a mass ratio of 19/13/68 of polymer 5/novolac resin/naphthol aralkyl resin to prepare a solution. The amount of PGMEA/CH = 5/5 was adjusted so that the concentration was 10% by mass. As a result, a material for forming an underlayer film was obtained.

The obtained material for forming an underlayer film was spin-coated on a silicon substrate without a pattern

under the conditions of 1000 rpm and 10 sec, and dried at 120°C for 1 minute in a nitrogen atmosphere to form a film. The glass transition temperature was measured using a white powder obtained by scraping a part of this film with a spatula as a sample. The glass transition temperature was 98°C.

The obtained material for forming an underlayer film was spin-coated on a silicon substrate without a pattern under the conditions of 1000 rpm and 10 sec, and heated at 300°C for 1 minute in a nitrogen atmosphere to form a film. Elemental analysis was performed using a white powder obtained by scraping a part of this film with a spatula as a sample.

The elemental analysis values were C = 84.3% by mass, H = 6.2% by mass, O = 9.8% by mass, and the elemental composition ratio (Re and Re') calculated from the elemental analysis values was 2.2.

(Evaluation)

The obtained material for forming an underlayer film was applied to the surface of the above-mentioned uneven substrate for evaluation under the conditions of 1000 rpm and 10 sec. Thereafter, the surfaces were heated at 300°C for 1 minute in a nitrogen atmosphere. As a result, a resist underlayer film was formed.

The cross section of the substrate was observed by SEM as described in the above [Evaluation of embedding property] and [Evaluation of flatness] described above. As a result, the mixture of the novolac resin and the naphthol aralkyl resin in the material for forming an underlayer film was uniformly embedded in the groove having a narrow line width of 40 nm (height 200 nm) between the projections without defects such as voids. Further, $H_{av}$ was 234 nm, $H_{max}$ was 234 nm, $H_{min}$ was 233 nm, and the flatness (ΔFT) was 0.4%. That is, the embedding property and flatness were very good.

Further, the residual film rate measured as described in the above [Measurement of residual film rate] using the obtained material for forming an underlayer film was 100%. That is, the residual film rate was good.

[Example 8]

(Preparation of material for forming underlayer film)

Polymer 5 (cyclic olefin polymer synthesized in Example 7) and naphthol aralkyl resin (manufactured by NIPPON STEEL Chemical & Material Co., Ltd., trade names SN-485, Mw = 480, Mw/Mn = 1.84) were dissolved in a mixed solvent of PGMEA/CH = 5/5 (mass ratio) at a mass ratio of polymer 5/naphthol aralkyl resin of 12/88 to prepare a solution. The amount of PGMEA/CH = 5/5 was adjusted so that the concentration was 10% by mass. As a result, a material for forming an underlayer film was obtained.

The obtained material for forming an underlayer film was spin-coated on a silicon substrate without a pattern under the conditions of 1000 rpm and 10 sec, and dried at 120°C for 1 minute in a nitrogen atmosphere to form a film. The glass transition temperature was measured using a white powder obtained by scraping a part of this film with a spatula as a sample. The glass transition temperature was 141°C.

The obtained material for forming an underlayer film was spin-coated on a silicon substrate without a pattern under the conditions of 1000 rpm and 10 sec, and heated at 300°C for 1 minute in a nitrogen atmosphere to form a film. Elemental analysis was performed using a white powder obtained by scraping a part of this film with a spatula as a sample. The elemental analysis values were C = 86.3% by mass, H = 5.6% by mass, O = 7.9% by mass, and the elemental composition ratio (Re and Re') calculated from the elemental analysis values was 2.0.

(Evaluation)

The obtained material for forming an underlayer film was applied to the surface of the above-mentioned uneven substrate for evaluation under the conditions of 1000 rpm and 10 sec. Thereafter, the surfaces were heated at 300°C for 1 minute in a nitrogen atmosphere. As a result, a resist underlayer film was formed.

The cross section of the substrate was observed by SEM as described in the above [Evaluation of embedding property] and [Evaluation of flatness] described above. As a result, the mixture of the polymer 5 and the naphthol aralkyl resin in the material for forming an underlayer film was uniformly embedded in the groove having a narrow line width of 40 nm (height 200 nm) between the projections without defects such as voids. Further, $H_{av}$ was 245 nm, $H_{max}$ was 245 nm, $H_{min}$ was 244 nm, and the flatness (ΔFT) was 0.4%. That is, the embedding property and flatness were very good.

Further, the residual film rate measured as described in the above [Measurement of residual film rate] using the obtained material for forming an underlayer film was 100%. That is, the residual film rate was good.

[Example 9]

(Preparation of material for forming underlayer film)

Polymer 4 and naphthol aralkyl resin (manufactured by NIPPON STEEL Chemical & Material Co., Ltd., trade names SN-485, Mw = 480, Mw/Mn = 1.84) were dissolved in a mixed solvent of PGMEA/CH = 5/5 (mass ratio) at a mass ratio of polymer 4/naphthol aralkyl resin of 80/20 to prepare a solution. The amount of the mixed solvent was adjusted so that the concentration was 10% by mass. As a result, a material for forming an underlayer film was obtained.
The obtained material for forming an underlayer film was spin-coated on a silicon substrate without a pattern under the conditions of 1000 rpm and 10 sec, and dried at 120°C for 1 minute in a nitrogen atmosphere to form a film. The glass transition temperature was measured using a white powder obtained by scraping a part of this film with a spatula as a sample. The glass transition temperature was 119°C.
The obtained material for forming an underlayer film was spin-coated on a silicon substrate without a pattern under the conditions of 1000 rpm and 10 sec, and heated at 300°C for 1 minute in a nitrogen atmosphere to form a film. Elemental analysis was performed using a white powder obtained by scraping a part of this film with a spatula as a sample.
The elemental analysis values were C = 89.2% by mass, H = 7.3% by mass, and O = 3.3% by mass, and the elemental composition ratio (Re and Re') calculated from the elemental analysis values was 2.1.

(Evaluation)

The obtained material for forming an underlayer film was applied to the surface of the above-mentioned uneven substrate for evaluation under the conditions of 1000 rpm and 10 sec. Thereafter, the surfaces were heated at 300°C for 1 minute in a nitrogen atmosphere. As a result, a resist underlayer film was formed.
The cross section of the substrate was observed by SEM as described in the above [Evaluation of embedding property] and [Evaluation of flatness] described above. As a result, the mixture of the polymer 4 and the naphthol aralkyl resin in the material for forming an underlayer film was uniformly embedded in the groove having a narrow line width of 40 nm (height 200 nm) between the projections without defects such as voids. Further, $H_{av}$ was 240 nm, $H_{max}$ was 240 nm, $H_{min}$ was 239 nm, and the flatness ($\Delta$FT) was 0.4%. That is, the embedding property and flatness were very good.
Further, the residual film rate measured as described in the above [Measurement of residual film rate] using the obtained material for forming an underlayer film was 91%. That is, the residual film rate was good.

[Example 10]

(Preparation of material for forming underlayer film)

Novolac resin (manufactured by MEIWA PLASTIC INDUSTRIES, LTD., trade name MER-44S, Mw = 5100, Mw/Mn = 3.55) and naphthol aralkyl resin (manufactured by NIPPON STEEL Chemical & Material Co., Ltd., trade name SN-485, Mw = 480, Mw/Mn = 1.84) were dissolved in a mixed solvent of PGMEA/CH = 5/5 (mass ratio) at a mass ratio of novolac resin/naphthol aralkyl resin of 95/5 to prepare a solution. The amount of the mixed solvent was adjusted so that the concentration was 10% by mass. As a result, a material for forming an underlayer film was obtained.
The obtained material for forming an underlayer film was spin-coated on a silicon substrate without a pattern under the conditions of 1000 rpm and 10 sec, and dried at 120°C for 1 minute in a nitrogen atmosphere to form a film. The glass transition temperature was measured using a white powder obtained by scraping a part of this film with a spatula as a sample. The glass transition temperature was 119°C.
The obtained material for forming an underlayer film was spin-coated on a silicon substrate without a pattern under the conditions of 1000 rpm and 10 sec, and heated at 300°C for 1 minute in a nitrogen atmosphere to form a film. Elemental analysis was performed using a white powder obtained by scraping a part of this film with a spatula as a sample.
The elemental analysis values were C = 80.6% by mass, H = 6.8% by mass, and O = 12.5% by mass, and the elemental composition ratio (Re and Re') calculated from the elemental analysis values was 2.4.

(Evaluation)

The obtained material for forming an underlayer film was applied to the surface of the above-mentioned uneven substrate for evaluation under the conditions of 1000 rpm and 10 sec. Thereafter, the surfaces were heated at 300°C for 1 minute in a nitrogen atmosphere. As a result, a resist underlayer film was formed.
The cross section of the substrate was observed by SEM as described in the above [Evaluation of embedding property] and [Evaluation of flatness] described above. As a result, the mixture of the novolac resin and the naphthol aralkyl resin in the material for forming an underlayer film was uniformly embedded in the groove having a narrow line

width of 40 nm (height 200 nm) between the projections without defects such as voids. Further, $H_{av}$ was 280 nm, $H_{max}$ was 281 nm, $H_{min}$ was 279 nm, and the flatness (ΔFT) was 0.7%. That is, the embedding property and flatness were very good.

Further, the residual film rate measured as described in the above [Measurement of residual film rate] using the obtained material for forming an underlayer film was 100%. That is, the residual film rate was good.

[Example 11]

(Preparation of material for forming underlayer film)

Novolac resin (manufactured by MEIWA PLASTIC INDUSTRIES, LTD., trade name MER-44S, Mw = 5100, Mw/Mn = 3.55) and naphthol aralkyl resin (manufactured by NIPPON STEEL Chemical & Material Co., Ltd., trade name SN-485, Mw = 480, Mw/Mn = 1.84) were dissolved in a mixed solvent of PGMEA/CH = 5/5 (mass ratio) at a mass ratio of the novolac resin/naphthol aralkyl resin of 80/20 to prepare a solution. The amount of the mixed solvent was adjusted so that the concentration was 10% by mass. As a result, a material for forming an underlayer film was obtained.

The obtained material for forming an underlayer film was spin-coated on a silicon substrate without a pattern under the conditions of 1000 rpm and 10 sec, and dried at 120°C for 1 minute in a nitrogen atmosphere to form a film. The glass transition temperature was measured using a white powder obtained by scraping a part of this film with a spatula as a sample. The glass transition temperature was 117°C.

The obtained material for forming an underlayer film was spin-coated on a silicon substrate without a pattern under the conditions of 1000 rpm and 10 sec, and heated at 300°C for 1 minute in a nitrogen atmosphere to form a film. Elemental analysis was performed using a white powder obtained by scraping a part of this film with a spatula as a sample.

The elemental analysis values were C = 82.0% by mass, H = 6.3% by mass, O = 11.6% by mass, and the elemental composition ratio (Re and Re') calculated from the elemental analysis values was 2.3.

(Evaluation)

The obtained material for forming an underlayer film was applied to the surface of the above-mentioned uneven substrate for evaluation under the conditions of 1000 rpm and 10 sec. Thereafter, the surfaces were heated at 300°C for 1 minute in a nitrogen atmosphere. As a result, a resist underlayer film was formed.

The cross section of the substrate was observed by SEM as described in the above [Evaluation of embedding property] and [Evaluation of flatness] described above. As a result, the mixture of the novolac resin and the naphthol aralkyl resin in the material for forming an underlayer film was uniformly embedded in the groove having a narrow line width of 40 nm (height 200 nm) between the projections without defects such as voids. Further, $H_{av}$ was 244 nm, $H_{max}$ was 245 nm, $H_{min}$ was 243 nm, and the flatness (ΔFT) was 0.8%. That is, the embedding property and flatness were very good.

Further, the residual film rate measured as described in the above [Measurement of residual film rate] using the obtained material for forming an underlayer film was 100%. That is, the residual film rate was good.

[Example 12]

(Preparation of material for forming underlayer film)

Novolac resin (manufactured by MEIWA PLASTIC INDUSTRIES, LTD., trade name MER-44S, Mw = 5100, Mw/Mn = 3.55) and naphthol aralkyl resin (manufactured by NIPPON STEEL Chemical & Material Co., Ltd., trade name SN-485, Mw = 480, Mw/Mn = 1.84) were dissolved in a mixed solvent of PGMEA/CH = 5/5 (mass ratio) at a mass ratio of the novolac resin/naphthol aralkyl resin of 20/80 to prepare a solution. The amount of the mixed solvent was adjusted so that the concentration was 10% by mass. As a result, a material for forming an underlayer film was obtained.

The obtained material for forming an underlayer film was spin-coated on a silicon substrate without a pattern under the conditions of 1000 rpm and 10 sec, and dried at 120°C for 1 minute in a nitrogen atmosphere to form a film. The glass transition temperature was measured using a white powder obtained by scraping a part of this film with a spatula as a sample. The glass transition temperature was 106°C.

The obtained material for forming an underlayer film was spin-coated on a silicon substrate without a pattern under the conditions of 1000 rpm and 10 sec, and heated at 300°C for 1 minute in a nitrogen atmosphere to form a film. Elemental analysis was performed using a white powder obtained by scraping a part of this film with a spatula as a sample.

The elemental analysis values were C = 85.9% by mass, H = 5.7% by mass, and O = 8.0% by mass, and the elemental composition ratio (Re) calculated from the elemental analysis values was 2.0.

(Evaluation)

The obtained material for forming an underlayer film was applied to the surface of the above-mentioned uneven substrate for evaluation under the conditions of 1000 rpm and 10 sec. Thereafter, the surfaces were heated at 300°C for 1 minute in a nitrogen atmosphere. As a result, a resist underlayer film was formed.
The cross section of the substrate was observed by SEM as described in the above [Evaluation of embedding property] and [Evaluation of flatness] described above. As a result, the mixture of the novolac resin and the naphthol aralkyl resin in the material for forming an underlayer film was uniformly embedded in the groove having a narrow line width of 40 nm (height 200 nm) between the projections without defects such as voids. Further, $H_{av}$ was 256 nm, $H_{max}$ was 257 nm, $H_{min}$ was 255 nm, and the flatness (ΔFT) was 0.8%. That is, the embedding property and flatness were very good.
Further, the residual film rate measured as described in the above [Measurement of residual film rate] using the obtained material for forming an underlayer film was 100%. That is, the residual film rate was good.

[Example 13]

(Preparation of material for forming underlayer film)

Novolac resin (manufactured by MEIWA PLASTIC INDUSTRIES, LTD., trade name MER-44S, Mw = 5100, Mw/Mn = 3.55) and naphthol aralkyl resin (manufactured by NIPPON STEEL Chemical & Material Co., Ltd., trade name SN-485, Mw = 480, Mw/Mn = 1.84) were dissolved in a mixed solvent of PGMEA/CH = 5/5 (mass ratio) at a mass ratio of the novolac resin/naphthol aralkyl resin of 5/95 to prepare a solution. The amount of the mixed solvent was adjusted so that the concentration was 10% by mass. As a result, a material for forming an underlayer film was obtained.
The obtained material for forming an underlayer film was spin-coated on a silicon substrate without a pattern under the conditions of 1000 rpm and 10 sec, and dried at 120°C for 1 minute in a nitrogen atmosphere to form a film. The glass transition temperature was measured using a white powder obtained by scraping a part of this film with a spatula as a sample. The glass transition temperature was 104°C.
The obtained material for forming an underlayer film was spin-coated on a silicon substrate without a pattern under the conditions of 1000 rpm and 10 sec, and heated at 300°C for 1 minute in a nitrogen atmosphere to form a film. Elemental analysis was performed using a white powder obtained by scraping a part of this film with a spatula as a sample.
The elemental analysis values were C = 87.2% by mass, H = 5.8% by mass, and O = 6.8% by mass, and the elemental composition ratio (Re) calculated from the elemental analysis values was 2.0.

(Evaluation)

The obtained material for forming an underlayer film was applied to the surface of the above-mentioned uneven substrate for evaluation under the conditions of 1000 rpm and 10 sec. Thereafter, the surfaces were heated at 300°C for 1 minute in a nitrogen atmosphere. As a result, a resist underlayer film was formed.
The cross section of the substrate was observed by SEM as described in the above [Evaluation of embedding property] and [Evaluation of flatness] described above. As a result, the mixture of the novolac resin and the naphthol aralkyl resin in the material for forming an underlayer film was uniformly embedded in the groove having a narrow line width of 40 nm (height 200 nm) between the projections without defects such as voids. Further, $H_{av}$ was 277 nm, $H_{max}$ was 278 nm, $H_{min}$ was 276 nm, and the flatness (ΔFT) was 0.7%. That is, the embedding property and flatness were very good.
Further, the residual film rate measured as described in the above [Measurement of residual film rate] using the obtained material for forming an underlayer film was 100%. That is, the residual film rate was good.

[Example 14]

(Preparation of material for forming underlayer film)

Polymer 4 and novolac resin (manufactured by MEIWA PLASTIC INDUSTRIES, LTD., trade name MER-44S, Mw = 5100, Mw/Mn = 3.55) were dissolved in a mixed solvent of PGMEA/CH = 5/5 (mass ratio) at a mass ratio of polymer 4/novolac resin of 80/20 to prepare a solution. The amount of the mixed solvent was adjusted so that the concentration was 10% by mass. As a result, a material for forming an underlayer film was obtained.
The obtained material for forming an underlayer film was spin-coated on a silicon substrate without a pattern under the conditions of 1000 rpm and 10 sec, and dried at 120°C for 1 minute in a nitrogen atmosphere to form a film. The glass transition temperature was measured using a white powder obtained by scraping a part of this film with a

spatula as a sample. The glass transition temperature was 116°C.

The obtained material for forming an underlayer film was spin-coated on a silicon substrate without a pattern under the conditions of 1000 rpm and 10 sec, and heated at 300°C for 1 minute in a nitrogen atmosphere to form a film. Elemental analysis was performed using a white powder obtained by scraping a part of this film with a spatula as a sample.

The elemental analysis values were C = 87.4% by mass, H = 7.5% by mass, and O = 4.8% by mass, and the elemental composition ratio (Re and Re') calculated from the elemental analysis values was 2.2.

(Evaluation)

The obtained material for forming an underlayer film was applied to the surface of the above-mentioned uneven substrate for evaluation under the conditions of 1000 rpm and 10 sec. Thereafter, the surfaces were heated at 300°C for 1 minute in a nitrogen atmosphere. As a result, a resist underlayer film was formed.

The cross section of the substrate was observed by SEM as described in the above [Evaluation of embedding property] and [Evaluation of flatness] described above. As a result, the mixture of the polymer 4 and the novolac resin in the material for forming an underlayer film was uniformly embedded in the groove having a narrow line width of 40 nm (height 200 nm) between the projections without defects such as voids. Further, $H_{av}$ was 236 nm, $H_{max}$ was 237 nm, $H_{min}$ was 236 nm, and the flatness (ΔFT) was 0.4%. That is, the embedding property and flatness were very good.

Further, the residual film rate measured as described in the above [Measurement of residual film rate] using the obtained material for forming an underlayer film was 93%. That is, the residual film rate was good.

[Example 15]

(Preparation of material for forming underlayer film)

Polymer 4 and novolac resin (manufactured by MEIWA PLASTIC INDUSTRIES, LTD., trade name MER-44S, Mw = 5100, Mw/Mn = 3.55) were dissolved in a mixed solvent of PGMEA/CH = 5/5 (mass ratio) at a mass ratio of polymer 4/novolac resin of 20/80 to prepare a solution. The amount of the mixed solvent was adjusted so that the concentration was 10% by mass. As a result, a material for forming an underlayer film was obtained.

The obtained material for forming an underlayer film was spin-coated on a silicon substrate without a pattern under the conditions of 1000 rpm and 10 sec, and dried at 120°C for 1 minute in a nitrogen atmosphere to form a film. The glass transition temperature was measured using a white powder obtained by scraping a part of this film with a spatula as a sample. The glass transition temperature was 107°C.

The obtained material for forming an underlayer film was spin-coated on a silicon substrate without a pattern under the conditions of 1000 rpm and 10 sec, and heated at 300°C for 1 minute in a nitrogen atmosphere to form a film. Elemental analysis was performed using a white powder obtained by scraping a part of this film with a spatula as a sample.

The elemental analysis values were C = 81.6% by mass, H = 6.9% by mass, O = 11.0% by mass, and the elemental composition ratio (Re and Re') calculated from the elemental analysis values was 2.4.

(Evaluation)

The obtained material for forming an underlayer film was applied to the surface of the above-mentioned uneven substrate for evaluation under the conditions of 1000 rpm and 10 sec. Thereafter, the surfaces were heated at 300°C for 1 minute in a nitrogen atmosphere. As a result, a resist underlayer film was formed.

The cross section of the substrate was observed by SEM as described in the above [Evaluation of embedding property] and [Evaluation of flatness] described above. As a result, the mixture of the polymer 4 and the novolac resin in the material for forming an underlayer film was uniformly embedded in the groove having a narrow line width of 40 nm (height 200 nm) between the projections without defects such as voids. Further, $H_{av}$ was 255 nm, $H_{max}$ was 255 nm, $H_{min}$ was 254 nm, and the flatness (ΔFT) was 0.4%. That is, the embedding property and flatness were very good.

Further, the residual film rate measured as described in the above [Measurement of residual film rate] using the obtained material for forming an underlayer film was 100%. That is, the residual film rate was good.

[Example 16]

(Synthesis of cyclic olefin polymer)

In a 125 mL glass autoclave provided with a magnetic stirrer in a nitrogen atmosphere, 17.1 g (0.071 mol) of 2-phenyl-3a,4,7,7a-tetrahydro-1H-methanoisoindole-1,3(2H)-dione and 0.65 g (0.008 mol) of 1,5-hexadiene were dissolved in 50.9 g of THF, and the solution was stirred.

As a ring opening metathesis polymerization catalyst, 10.8 mg (0.014 mmol) of Mo(N-2,6-$Pr^i_2C_6H_3$)($CHCMe_2Ph$)($OCMe(CF_3)_2$)$_2$ was added thereto to cause a reaction at 60°C for 1 hour. Then, 3.06 mg (0.04 mmol) of n-butyraldehyde was added, and the mixture was further heated at 60°C for 30 minutes.

Then, the mixture was cooled to obtain 67.8 g of a ring opening metathesis polymer solution. The obtained polymer had a polymerization rate of 100%, Mw = 5200, and Mw/Mn = 2.35.

Next, the cyclic olefin polymer was precipitated from the obtained ring opening metathesis polymer solution using methanol and dried at 80°C under reduced pressure, thereby obtaining a white powder solid (polymer 6).

The polymer 6 contains the structural unit represented by the general formula (7) described above.

The glass transition temperature of the polymer 6 was 126°C.

(Preparation of material for forming underlayer film)

The obtained polymer 6 was dissolved in a mixed solvent having a mass ratio of PGMEA and CH of PGMEA/CH = 5/5 to prepare a solution having a concentration of 10% by mass. As a result, a material for forming an underlayer film was obtained.

The obtained material for forming an underlayer film was spin-coated on a silicon substrate without a pattern under the conditions of 1000 rpm and 10 sec, and heated at 300°C for 1 minute in a nitrogen atmosphere to form a film. Elemental analysis was performed using a white powder obtained by scraping a part of this film with a spatula as a sample. The elemental analysis values were C = 75.3% by mass, H = 5.5% by mass, N = 5.8% by mass, and O = 13.2% by mass, Re was 2.3, and Re' was 2.4.

(Evaluation)

The obtained material for forming an underlayer film was applied to the surface of the above-mentioned uneven substrate for evaluation under the conditions of 1000 rpm and 10 sec. Thereafter, the surfaces were heated at 300°C for 1 minute in a nitrogen atmosphere. As a result, a resist underlayer film was formed.

The cross section of the substrate was observed by SEM as described in the above [Evaluation of embedding property] and [Evaluation of flatness] described above. As a result, the polymer 2 in the material for forming an underlayer film was uniformly embedded in the groove having a narrow line width of 40 nm (height 200 nm) between the projections without defects such as voids. $H_{av}$ was 238 nm, $H_{max}$ was 239 nm, $H_{min}$ was 237 nm, and the flatness ($\Delta$FT) was 0.8%. That is, the embedding property and flatness were very good.

Further, the residual film rate measured as described in the above [Measurement of residual film rate] using the obtained material for forming an underlayer film was 96%. That is, the residual film rate was very good.

[Comparative Example 1]

(Synthesis of polymer)

In an autoclave provided with a magnetic stirrer in a nitrogen atmosphere, 100 g of PHS used in Example 5 was dissolved in 900 g of methyl isobutyrate. To this, 5 g of 2.0 wt% Pd/$ZrO_2$ catalyst was added, and a hydrogenation reaction was carried out under the conditions of a hydrogen pressure of 9 MPa and 180°C for 15 hours. The obtained polymer had a nuclear hydrogenation rate of 99% by mol, Mw = 5400, and Mw/Mn = 1.29.

Next, the polymer was precipitated and dried according to the same method as that in Example 1 to obtain a white powder solid (comparative polymer 1).

The glass transition temperature of the comparative polymer 1 was 172°C.

The elemental analysis values of the comparative polymer 1 were C = 76.0% by mass, H = 11.4% by mass, and O = 12.3% by mass, and the elemental composition ratio (Re and Re') calculated from the elemental analysis values was 3.3.

(Preparation of material for forming underlayer film)

The obtained comparative polymer 1 was dissolved in a mixed solvent having a mass ratio of PGMEA and CH of PGMEA/CH = 5/5 to prepare a solution having a concentration of 10% by mass. As a result, a material for forming an underlayer film was obtained.

(Evaluation)

The obtained material for forming an underlayer film was applied to the surface of the above-mentioned uneven

substrate for evaluation under the conditions of 1000 rpm and 10 sec. Thereafter, the surfaces were heated at 300°C for 1 minute in a nitrogen atmosphere. As a result, a resist underlayer film was formed.

The cross section of the substrate was observed by SEM as described in the above [Evaluation of embedding property] and [Evaluation of flatness] described above. As a result, the comparative polymer 1 in the material for forming an underlayer film was uniformly embedded in the groove having a narrow line width of 40 nm (height 200 nm) between the projections without defects such as voids. $H_{av}$ was 310 nm, $H_{max}$ was 316 nm, $H_{min}$ was 305 nm, and the flatness ($\Delta$FT) was 3.6%. That is, the embedding property was very good, and the flatness was also reasonably good.

Incidentally, the residual film rate measured as described in the above [Measurement of residual film rate] using the obtained material for forming an underlayer film was 11%. That is, the residual film rate was slightly inferior to that of Examples 1 to 5.

[Comparative Example 2]

(Preparation of material for forming underlayer film)

Polymethylmethacrylate was dissolved in a CH solution in an amount of 10% by mass to obtain a material for forming an underlayer film.

The obtained material for forming an underlayer film was spin-coated on a silicon substrate without a pattern under the conditions of 1000 rpm and 10 sec, and heated at 300°C for 1 minute in a nitrogen atmosphere to form a film.

Elemental analysis was performed using a white powder obtained by scraping a part of the film with a spatula. The elemental analysis values were C = 60.1% by mass, H = 8.3% by mass, N = 0.2% by mass, and O = 31.1% by mass, Re was 5.0, and Re' was 5.0.

(Evaluation)

The obtained material for forming an underlayer film was applied to the surface of the above-mentioned uneven substrate for evaluation under the conditions of 1000 rpm and 10 sec. Thereafter, the surfaces were heated at 300°C for 1 minute in a nitrogen atmosphere. In this way, the resist underlayer film was formed.

The cross section of the substrate was observed by SEM as described in the above [Evaluation of embedding property] and [Evaluation of flatness] described above. As a result, voids were generated in the groove having a narrow line width of 40 nm (height 200 nm) between the projections. $H_{av}$ was 250 nm, $H_{max}$ was 264 nm, $H_{min}$ was 233 nm, and the flatness ($\Delta$FT) was 12.4%. Further, the interface of the resist underlayer film with the atmosphere was distorted. That is, the embedding property and flatness were inferior to those of Example 1 and the like.

Further, the obtained material for forming an underlayer film was spin-coated on a 4-inch silicon wafer under the conditions of 1000 rpm and 10 sec. Next, the coated film was dried at 300°C for 1 minute in a nitrogen atmosphere. The residual film rate with respect to the mixed solvent of PGME/PGMEA = 7/3 (mass ratio) was 0%.

[Comparative Example 3]

(Preparation of material for forming underlayer film)

Naphthol aralkyl resin (manufactured by NIPPON STEEL Chemical & Material Co., Ltd., trade name SN-485, Mw = 480, Mw/Mn = 1.84) was dissolved in a mixed solvent a mass ratio of PGMEA/CH = 5/5 (mass ratio) to prepare a solution having a concentration of 10% by mass. As a result, a material for forming an underlayer film was obtained.

(Evaluation)

The obtained material for forming an underlayer film was applied to the surface of the above-mentioned uneven substrate for evaluation under the conditions of 1000 rpm and 10 sec. After that, the mixture was heated at 300°C for 1 minute in a nitrogen atmosphere, but the naphthol aralkyl resin aggregated on the substrate, a uniform film could not be obtained, and the cross section of the substrate could not be observed by SEM.

The residual film rate could not be measured because a uniform coating film could not be obtained on a 4-inch silicon wafer.

[Evaluation of plasma etching resistance]

First, the materials for forming an underlayer film obtained in Examples 1 to 16 and Comparative Examples 1 and 2 were each applied to a silicon wafer and heated at 300°C for 1 minute to obtain a resist underlayer film.

For reference, a material for forming an underlayer film having a concentration of 10% by mass, obtained by dissolving only PHS used in Example 5 in a mixed solvent of PGMEA/CH = 5/5 (mass ratio), was applied to a silicon wafer, and heated at 300°C for 1 minute to obtain a resist underlayer film.

Next, using each resist underlayer film, the etching rate (nm/sec) was calculated as described in the above [Plasma etching characteristic evaluation] and [Etching rate measurement method].

Etching resistance was evaluated by the value of "etching rate of reference resist underlayer film obtained by using PHS/etching rate of each underlayer film". The larger this value, the better the etching resistance. The etching resistance was 1.1 in Example 1 (polymer 1), 1.2 in Example 2 (polymer 2), 1.3 in Example 3 (polymer 3), 1.1 in Example 4 (polymer 4), 1.2 in Example. 5 (mixture of polymer 1 and PHS at a mass ratio of 90/10), 1.1 in Example 6 (mixture of novolac resin and naphthol aralkyl resin at a mass ratio of 58/42), 1.1 in Example 7 (mixture of polymer 5, novolac resin, and naphthol aralkyl resin at a mass ratio of 19/13/68), 1.2 in Example 8 (mixture of polymer 5 and naphthol aralkyl resin at a mass ratio of 12/88), 1.2 in Example 9 (mixture of polymer 4 and naphthol aralkyl resin at a mass ratio of 80/20), 1.1 in Example 10 (mixture of novolac resin and naphthol aralkyl resin at a mass ratio of 95/5), 1.1 in Example 11 (mixture of novolac resin and naphthol aralkyl resin at a mass ratio of 80/20), 1.2 in Example 12 (mixture of novolac resin and naphthol aralkyl resin at a mass ratio of 20/80), 1.3 in Example 13 (mixture of novolac resin and naphthol aralkyl resin at a mass ratio of 5/95), 1.2 in Example 14 (mixture of polymer 4 and novolac resin at a mass ratio of 80/20), 1.1 in Example 15 (mixture of polymer 4 and novolac resin at a mass ratio of 20/80), 1.1 in Example 16 (polymer 6), 0.7 in Comparative Example 1 (comparative polymer 1), 0.5 in Comparative Example 2.

The underlayer film forming materials of Examples 1 to 16 having an elemental composition ratio (Re or Re') larger than PHS all showed higher etching resistance than PHS. On the other hand, the underlayer film forming materials of Comparative Examples 1 and 2 having an elemental composition ratio (Re or Re') smaller than that of PHS had lower etching resistance than that of PHS.

This application claims priority on the basis of Japanese Patent Application No. 2019-020570 filed on February 7, 2019 and Japanese Patent Application No. 2019-165498 filed on September 11, 2019, the entire disclosure of which is incorporated herein by reference.

REFERENCE SIGNS LIST

1: Substrate
2: Resist underlayer film
3: Surface (surface of resist underlayer film on the side opposite to the substrate)
4: Film thickness (thickness of resist underlayer film 2)
5: Height (height of uneven structure 7)
6: Interval between projections
7: Uneven structure
10: Laminate

**Claims**

**1.** A material for forming an underlayer film used in a multi-layer resist process,
wherein a solid content of the material for forming an underlayer film satisfies the following (i) to (iii):

(i) an elemental composition ratio Re defined by the following mathematical formula (1) is 1.5 to 2.8;
(ii) a glass transition temperature is 30°C to 250°C; and
(iii) the solid content contains a resin having a structural unit represented by the following general formula (A) and a resin having a structural unit represented by the following general formula (B),

$$\mathrm{Re} = \frac{N_H + N_C + N_O}{N_C - N_O} \quad (1)$$

in the mathematical formula (1),

$N_H$ is the number of hydrogen atoms in the solid content of the material for forming an underlayer film,

$N_C$ is the number of carbon atoms in the solid content of the material for forming an underlayer film, and $N_O$ is the number of oxygen atoms in the solid content of the material for forming an underlayer film,

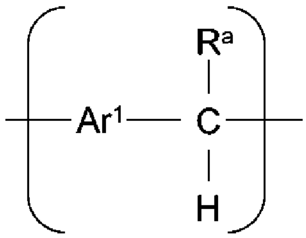
(A)

in the general formula (A),
$Ar^1$ represents a divalent aromatic group at least substituted with a hydroxy group and/or a glycidyloxy group, and $R^a$ represents any substituent selected from a hydrogen atom, an alkyl group having 1 to 10 carbon atoms, an aryl group having 6 to 10 carbon atoms, an aralkyl group having 7 to 10 carbon atoms, an alkoxyalkyl group having 2 to 10 carbon atoms, and an aryloxyalkyl group having 7 to 10 carbon atoms,

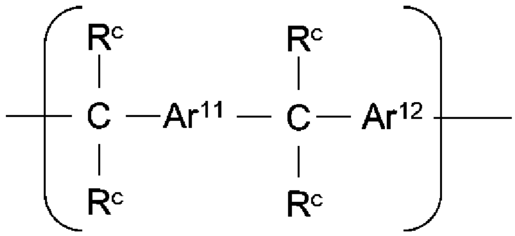
(B)

in the general formula (B),
each $R^c$ independently represents a hydrogen atom, an alkyl group having 1 to 10 carbon atoms, an aryl group having 6 to 10 carbon atoms, an aralkyl group having 7 to 10 carbon atoms, an alkoxyalkyl group having 2 to 10 carbon atoms, or an aryloxyalkyl group having 7 to 10 carbon atoms,
$Ar^{11}$ represents a divalent aromatic group which may be substituted or unsubstituted, and
$Ar^{12}$ represents any of structures represented by the following general formulas (B1) to (B3),

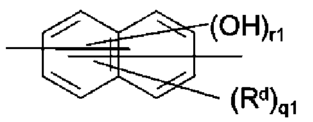
(B1)

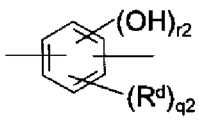
(B2)

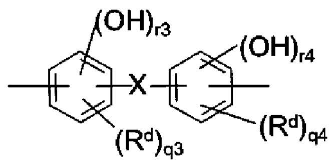
(B3)

in the general formulas (B1) to (B3),
in a case where a plurality of $R^d$ are present, each $R^d$ independently represents any selected from an alkyl group having 1 to 10 carbon atoms, an aryl group having 6 to 20 carbon atoms, an alkoxy group having 1 to 10 carbon atoms, an aryloxy group having 6 to 20 carbon atoms, an alkoxyalkyl group having 2 to 10 carbon atoms, an aryloxyalkyl group having 7 to 20 carbon atoms, an alkoxycarbonyl group having 2 to 20 carbon atoms, a dialkylaminocarbonyl group having 3 to 10 carbon atoms, an aryloxycarbonyl group having 7 to 20 carbon atoms, an alkylarylaminocarbonyl group having 8 to 20 carbon atoms, an alkoxycarbonylalkyl group having 3 to 20 carbon atoms, an alkoxycarbonylaryl group having 8 to 20 carbon atoms, an aryloxycarbonylalkyl group having 8 to 20 carbon atoms, an alkoxyalkyloxycarbonyl group having 3 to 20 carbon atoms, and an alkoxycarbonylalkyloxycarbonyl group having 4 to 20 carbon atoms,
r1 is 1 or more and (6-q1) or less,
q1 is 0 or more and 5 or less,
r2 is 1 or more and (4-q2) or less,
q2 is 0 or more and 3 or less,
r3 is 0 or more and 4 or less, r4 is 0 or more and 4 or less, provided that r3 + r4 is 1 or more,
q3 is 0 or more and 4 or less, q4 is 0 or more and 4 or less, provided that q3 + q4 is 7 or less, and

X represents a single bond or an alkylene group having 1 to 3 carbon atoms.

2. The material for forming an underlayer film according to claim 1,
wherein the elemental composition ratio Re' defined by the following mathematical formula (2) of the solid content of the material for forming an underlayer film is 1.5 to 2.8,

$$Re' = \frac{N_H + N_C + N_O + \frac{1}{2}N_N}{N_C - (N_O + \frac{1}{2}N_N)} \qquad (2)$$

in the mathematical formula (2),
$N_H$ is the number of hydrogen atoms in the solid content of the material for forming an underlayer film,
$N_C$ is the number of carbon atoms in the solid content of the material for forming an underlayer film,
$N_O$ is the number of oxygen atoms in the solid content of the material for forming an underlayer film, and
$N_N$ is the number of nitrogen atoms in the solid content of the material for forming an underlayer film.

3. The material for forming an underlayer film according to claim 1 or 2,
wherein the structural unit represented by the general formula (A) includes a structural unit represented by the following general formula (a1) or the general formula (a2):

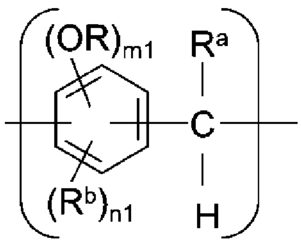
(a1)

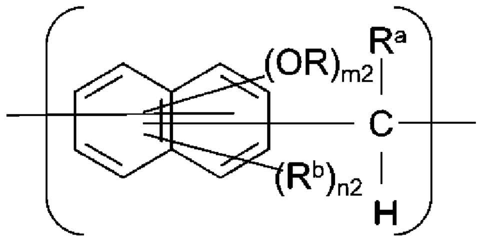
(a2)

in the general formulas (a1) and (a2),
m1 is 1 to 4, n1 is 0 to 3, provided that m1 + n1 is 1 or more and 4 or less,
m2 is 1 to 6, n2 is 0 to 5, provided that m2 + n2 is 1 or more and 6 or less,
in a case where a plurality of R are present, each R independently represents a hydrogen atom or a glycidyl group,
$R^a$ has the same definition as that in the formula (A),
in a case where a plurality of $R^b$ are present, each $R^b$ independently represents any selected from an alkyl group having 1 to 10 carbon atoms, an aryl group having 6 to 20 carbon atoms, an alkoxy group having 1 to 10 carbon atoms, an aryloxy group having 6 to 20 carbon atoms, an alkoxyalkyl group having 2 to 10 carbon atoms, an aryloxyalkyl group having 7 to 20 carbon atoms, an alkoxycarbonyl group having 2 to 20 carbon atoms, a dialkylaminocarbonyl group having 3 to 10 carbon atoms, an aryloxycarbonyl group having 7 to 20 carbon atoms, an alkylarylaminocarbonyl group having 8 to 20 carbon atoms, an alkoxycarbonylalkyl group having 3 to 20 carbon atoms, an alkoxycarbonylaryl group having 8 to 20 carbon atoms, an aryloxycarbonylalkyl group having 8 to 20 carbon atoms, an alkoxyalkyloxycarbonyl group having 3 to 20 carbon atoms, and an alkoxycarbonylalkyloxycarbonyl group having 4 to 20 carbon atoms, and
in a case where n is 2 or more, a plurality of $R^b$ may be bonded to each other to form a ring structure.

4. The material for forming an underlayer film according to any one of claims 1 to 3,
wherein the structural unit represented by the general formula (B) includes a structural unit represented by the following general formula (b):

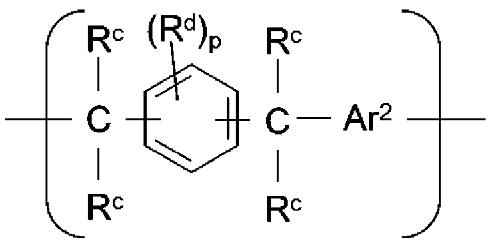

(b)

in the general formula (b),
$R^c$ has the same definition as $R^c$ in the general formula (B), in a case where a plurality of $R^d$ are present, each $R^d$ independently has the same definition as $R^d$ in the general formulas (B1) to (B3),
$Ar^2$ is a structure represented by the general formula (B1) or (B2), and
p is 0 to 4.

**5.** The material for forming an underlayer film according to any one of claims 1 to 4,
wherein the material for forming an underlayer film contains a resin having a structural unit represented by the following general formula (1) in addition to the resin having the structural unit represented by the general formula (A) and the resin having the structural unit represented by the general formula (B),

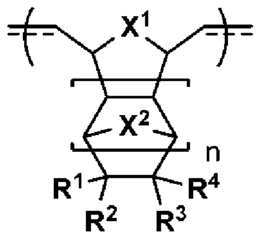

(1)

in the general formula (1),
$R^1$ to $R^4$ are each independently any group selected from the group consisting of a hydrogen atom, an aryl group having 6 to 20 carbon atoms, an aryloxy group having 6 to 20 carbon atoms, an aryloxyalkyl group having 7 to 20 carbon atoms, an aryloxycarbonyl group having 7 to 20 carbon atoms, an alkylarylaminocarbonyl group having 8 to 20 carbon atoms, an alkoxycarbonylaryl group having 8 to 30 carbon atoms, and an aryloxycarbonylalkyl group having 8 to 20 carbon atoms, at least one of $R^1$ to $R^4$ is a group other than a hydrogen atom, and $R^1$ to $R^4$ may be bonded to each other to form a ring structure,
n represents an integer of 0 to 2, and
$X^1$ and $X^2$ each independently represent $-CH_2-$ or -O-.

**6.** A material for forming an underlayer film used in a multi-layer resist process, wherein a solid content of the material for forming an underlayer film satisfies the following (i) to (iii):

(i) an elemental composition ratio Re defined by the following mathematical formula (1) is 1.5 to 2.8;
(ii) a glass transition temperature is 30°C to 250°C; and
(iii) the solid content contains a resin having a structural unit represented by the following general formula (1),

$$Re = \frac{N_H + N_C + N_O}{N_C - N_O} \qquad (1)$$

in the mathematical formula (1),
$N_H$ is the number of hydrogen atoms in the solid content of the material for forming an underlayer film,
$N_C$ is the number of carbon atoms in the solid content of the material for forming an underlayer film, and
$N_O$ is the number of oxygen atoms in the solid content of the material for forming an underlayer film,

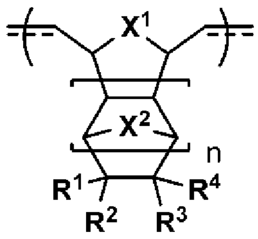

(1)

in the general formula (1),
$R^1$ to $R^4$ are each independently any group selected from the group consisting of a hydrogen atom, an aryl group having 6 to 20 carbon atoms, an aryloxy group having 6 to 20 carbon atoms, an aryloxyalkyl group having 7 to 20 carbon atoms, an aryloxycarbonyl group having 7 to 20 carbon atoms, an alkylarylaminocarbonyl group having 8 to 20 carbon atoms, an alkoxycarbonylaryl group having 8 to 30 carbon atoms, and an aryloxycarbonylalkyl group having 8 to 20 carbon atoms, at least one of $R^1$ to $R^4$ is a group other than a hydrogen atom, and $R^1$ to $R^4$ may be bonded to each other to form a ring structure, n represents an integer of 0 to 2, and$X^1$ and $X^2$ each independently represent $-CH_2-$ or -O-.

**7.** The material for forming an underlayer film according to claim 6,
wherein the elemental composition ratio Re' defined by the following mathematical formula (2) of the solid content of the material for forming an underlayer film is 1.5 to 2.8,

$$Re' = \frac{N_H + N_C + N_O + \frac{1}{2}N_N}{N_C - (N_O + \frac{1}{2}N_N)} \qquad (2)$$

in the mathematical formula (2),
$N_H$ is the number of hydrogen atoms in the solid content of the material for forming an underlayer film,
$N_C$ is the number of carbon atoms in the solid content of the material for forming an underlayer film,
$N_O$ is the number of oxygen atoms in the solid content of the material for forming an underlayer film, and
$N_N$ is the number of nitrogen atoms in the solid content of the material for forming an underlayer film.

**8.** The material for forming an underlayer film according to claim 6 or 7,
wherein the material for forming an underlayer film contains a resin having a structural unit represented by the following general formula (B) in addition to the resin having the structural unit represented by the general formula (1),

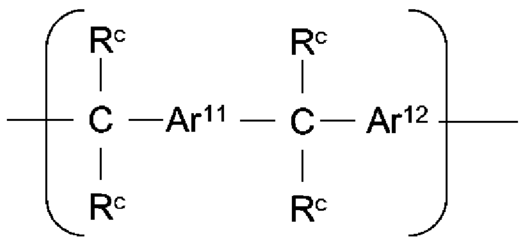

(B)

in the general formula (B),
each $R^c$ independently represents a hydrogen atom, an alkyl group having 1 to 10 carbon atoms, an aryl group having 6 to 10 carbon atoms, an aralkyl group having 7 to 10 carbon atoms, an alkoxyalkyl group having 2 to 10 carbon atoms, or an aryloxyalkyl group having 7 to 10 carbon atoms,
$Ar^{11}$ represents a divalent aromatic group which may be substituted or unsubstituted, and
$Ar^{12}$ represents any of structures represented by the following general formulas (B1) to (B3),

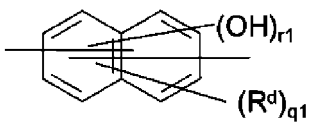

(B1)

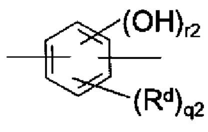

(B2)

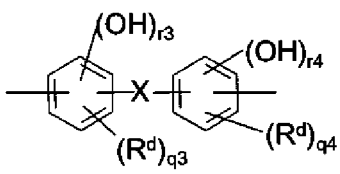

(B3)

in the general formulas (B1) to (B3),
in a case where a plurality of $R^d$ are present, each $R^d$ independently represents any selected from an alkyl group having 1 to 10 carbon atoms, an aryl group having 6 to 20 carbon atoms, an alkoxy group having 1 to 10 carbon atoms, an aryloxy group having 6 to 20 carbon atoms, an alkoxyalkyl group having 2 to 10 carbon atoms, an aryloxyalkyl group having 7 to 20 carbon atoms, an alkoxycarbonyl group having 2 to 20 carbon atoms, a dialkylaminocarbonyl group having 3 to 10 carbon atoms, an aryloxycarbonyl group having 7 to 20 carbon atoms, an alkylarylaminocarbonyl group having 8 to 20 carbon atoms, an alkoxycarbonylalkyl group having 3 to 20 carbon atoms, an alkoxycarbonylaryl group having 8 to 20 carbon atoms, an aryloxycarbonylalkyl group having 8 to 20 carbon atoms, an alkoxyalkyloxycarbonyl group having 3 to 20 carbon atoms, and an alkoxycarbonylalkyloxycarbonyl group having 4 to 20 carbon atoms,
r1 is 1 or more and (6-q1) or less,
q1 is 0 or more and 5 or less,
r2 is 1 or more and (4-q2) or less,
q2 is 0 or more and 3 or less,
r3 is 0 or more and 4 or less, r4 is 0 or more and 4 or less, provided that r3 + r4 is 1 or more,
q3 is 0 or more and 4 or less, q4 is 0 or more and 4 or less, provided that q3 + q4 is 7 or less, and
X represents a single bond or an alkylene group having 1 to 3 carbon atoms.

9. The material for forming an underlayer film according to claim 8, wherein the structural unit (B) includes a structural unit represented by the following general formula (b):

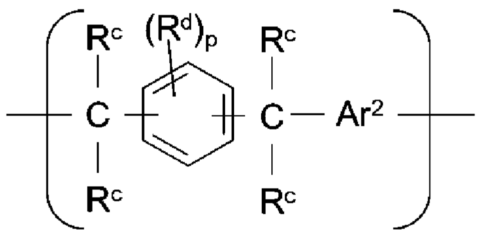

(b)

in the general formula (b),
$R^c$ has the same definition as $R^c$ in the general formula (B), in a case where a plurality of $R^d$ are present, each $R^d$ independently has the same definition as $R^d$ in the general formulas (B1) to (B3),
$Ar^2$ is a structure represented by the general formula (B1) or (B2), and
p is 0 to 4.

10. The material for forming an underlayer film according to claim 6 or 7,
wherein the material for forming an underlayer film contains a resin having a structural unit represented by the following general formula (A) in addition to the resin having the structural unit represented by the general formula (1),

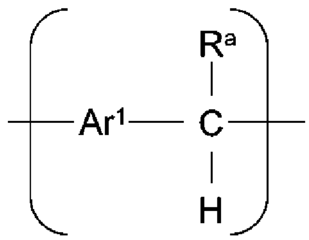

(A)

in the general formula (A),
$Ar^1$ represents a divalent aromatic group at least substituted with a hydroxy group and/or a glycidyloxy group, and $R^a$ represents any substituent selected from a hydrogen atom, an alkyl group having 1 to 10 carbon atoms, an aryl group having 6 to 10 carbon atoms, an aralkyl group having 7 to 10 carbon atoms, an alkoxyalkyl group having 2 to 10 carbon atoms, and an aryloxyalkyl group having 7 to 10 carbon atoms.

**11.** The material for forming an underlayer film according to claim 10, wherein the structural unit represented by the general formula (A) includes a structural unit represented by the following general formula (a1) or the general formula (a2):

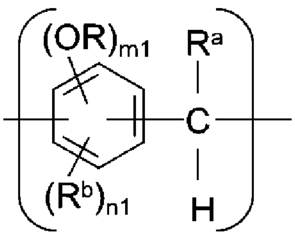
(a1)
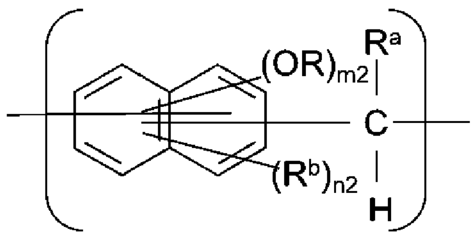
(a2)

in the general formulas (a1) and (a2),
m1 is 1 to 4, n1 is 0 to 3, provided that m1 + n1 is 1 or more and 4 or less,
m2 is 1 to 6, n2 is 0 to 5, provided that m2 + n2 is 1 or more and 6 or less,
in a case where a plurality of R are present, each R independently represents a hydrogen atom or a glycidyl group,
$R^a$ has the same definition as that in the formula (A),
in a case where a plurality of $R^b$ are present, each $R^b$ independently represents any selected from an alkyl group having 1 to 10 carbon atoms, an aryl group having 6 to 20 carbon atoms, an alkoxy group having 1 to 10 carbon atoms, an aryloxy group having 6 to 20 carbon atoms, an alkoxyalkyl group having 2 to 10 carbon atoms, an aryloxyalkyl group having 7 to 20 carbon atoms, an alkoxycarbonyl group having 2 to 20 carbon atoms, a dialkylaminocarbonyl group having 3 to 10 carbon atoms, an aryloxycarbonyl group having 7 to 20 carbon atoms, an alkylarylaminocarbonyl group having 8 to 20 carbon atoms, an alkoxycarbonylalkyl group having 3 to 20 carbon atoms, an alkoxycarbonylaryl group having 8 to 20 carbon atoms, an aryloxycarbonylalkyl group having 8 to 20 carbon atoms, an alkoxyalkyloxycarbonyl group having 3 to 20 carbon atoms, and an alkoxycarbonylalkyloxycarbonyl group having 4 to 20 carbon atoms, and
in a case where n is 2 or more, a plurality of $R^b$ may be bonded to each other to form a ring structure.

**12.** A resist underlayer film formed of the material for forming an underlayer film according to any one of claims 1 to 11.

**13.** A laminate comprising:

a substrate; and
a resist underlayer film formed of the material for forming an underlayer film according to any one of claims 1 to 11 on one surface of the substrate.

**14.** The laminate according to caim 13,

wherein a flatness $\Delta FT$ of a surface $\alpha$ of the resist underlayer film on a side opposite to the substrate which is calculated using the following mathematical formula is 0% to 5%,

$$\Delta FT = \{(H_{max} - H_{min})/H_{av}\} \times 100\ (\%)$$

in the mathematical formula,
$H_{av}$ is, when a film thickness of the resist underlayer film is measured at any 10 locations on the surface $\alpha$, an average value of the film thickness,
$H_{max}$ is a maximum value of the film thickness of the resist underlayer film, and
$H_{min}$ is a minimum value of the film thickness of the resist underlayer film.

**15.** The laminate according to claim 13 or 14,

wherein the average value of the film thickness $H_{av}$ when the film thickness of the resist underlayer film is measured at any 10 locations on the surface $\alpha$ of the resist underlayer film is 5 to 500 nm.

**16.** The laminate according to any one of claims 13 to 15,

wherein the substrate has an uneven structure on at least one surface thereof,
the resist underlayer film is formed on the uneven structure, and
the uneven structure has a height of 5 to 500 nm, and an interval between projections is 1 nm to 10 mm.

Fig.1

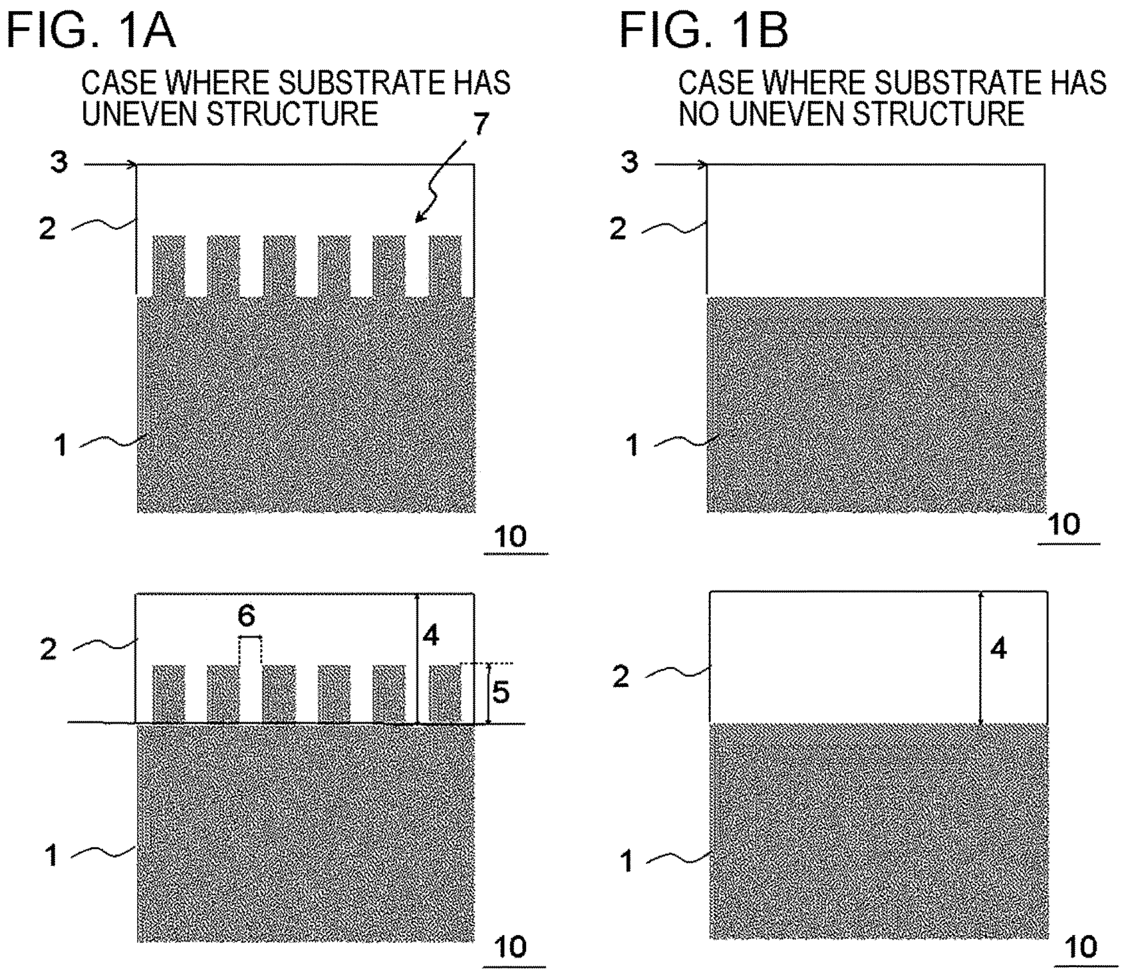
FIG. 1A
CASE WHERE SUBSTRATE HAS UNEVEN STRUCTURE
7
3
2
1
10
6
4
2
5
1
10
FIG. 1B
CASE WHERE SUBSTRATE HAS NO UNEVEN STRUCTURE
3
2
1
10
4
2
1
10

## INTERNATIONAL SEARCH REPORT

International application No. PCT/JP2020/002157

A. CLASSIFICATION OF SUBJECT MATTER
Int. Cl. B32B27/06(2006.01)i, C08G61/06(2006.01)i, G03F7/11(2006.01)i, G03F7/26(2006.01)i, H01L21/027(2006.01)i, B32B7/027(2019.01)i, B32B3/30(2006.01)i
FI: G03F7/11 503, G03F7/26 511, H01L21/30 573, B32B3/30, B32B27/06, B32B7/027, C08G61/06

According to International Patent Classification (IPC) or to both national classification and IPC

B. FIELDS SEARCHED
Minimum documentation searched (classification system followed by classification symbols)
Int. Cl. B32B3/30, B32B27/06, C08G61/06, G03F7/11, G03F7/26, H01L21/027, B32B7/027

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)
CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | WO 2017/141612 A1 (JSR CORP.) 24 August 2017, claims, example 17, claims, example 17, claims, example 17 | 1-2, 12-13, 15<br>1-4, 12-16<br>5 |
| Y<br>A | WO 2018/221575 A1 (MITSUI CHEMICALS, INC.) 06 December 2018, claims, example 1, claims, example 1 | 6-16<br>5 |
| Y | WO 2013/054702 A1 (JSR CORP.) 18 April 2013, claims, example 1 | 1-4, 6-16 |
| Y | WO 2017/183612 A1 (NISSAN CHEMICAL INDUSTRIES, LTD.) 26 October 2017, claims | 3-4, 8-11 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 10.03.2020 | 07.04.2020 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2020/002157

C (Continuation). DOCUMENTS CONSIDERED TO BE RELEVANT

| Category* | Citation of document, with indication, where appropriate, of the relevant passages | Relevant to claim No. |
|---|---|---|
| A | JP 2017-102420 A (SHIN-ETSU CHEMICAL CO., LTD.) 08 June 2017, claims | 1-16 |
| A | JP 2008-26600 A (SHIN-ETSU CHEMICAL CO., LTD.) 07 February 2008, claims | 1-16 |
| A | JP 2014-174428 A (SHIN-ETSU CHEMICAL CO., LTD.) 22 September 2014, example 5 | 1-16 |

Form PCT/ISA/210 (continuation of second sheet) (January 2015)

**INTERNATIONAL SEARCH REPORT**

International application No.
PCT/JP2020/002157

The International Searching Authority has found that this international application has two or more inventions, as shall be explained below.

Document 1 WO 2018/221575 A1 (MITSUI CHEMICALS INC.) 06 December 2018, claims, embodiments & TW 201904951 A

The claims are classified into the following two inventions.

(Invention 1) Claims 1-5, claims 12-16 citing claims 1-5

Claims 1-5 have the special technical feature of the underlayer film-forming material set forth in claim 1, and are therefore classified as invention 1.

(Invention 2) Claims 6-11, claims 12-16 citing claims 6-11

Claim 6 shares with claim 1 classified as invention 1 the feature of an underlayer film-forming material that satisfies (i) and (ii) stipulated in claim 1 of the present application.

However, this feature does not make a contribution over the prior art in the light of the content disclosed in document 1, and thus this feature cannot be said to be a special technical feature. Moreover, no other identical or corresponding special technical feature exists between these inventions.

In addition, claim 6 is not a dependent claim of claim 1. Furthermore, claim 6 is not substantially identical to or similarly closely related to any of the claims classified as invention 1.

As such, claim 6 cannot be classified as invention 1.

Claims 6-11 do have a feature of an underlayer film-forming material set forth in claim 6, and are therefore classified as invention 2.

Form PCT/ISA/210 (extra sheet) (January 2015)

**INTERNATIONAL SEARCH REPORT**
Information on patent family members

International application No.
PCT/JP2020/002157

| Patent Documents referred to in the Report | Publication Date | Patent Family | Publication Date |
|---|---|---|---|
| WO 2017/141612 A1 | 24.08.2017 | US 2018/0348633 A1 claims, examples, line 7<br>KR 10-2018-0108654 A<br>TW 201800862 A | |
| WO 2018/221575 A1 | 06.12.2018 | TW 201904951 A | |
| WO 2013/054702 A1 | 18.04.2013 | US 2014/0220783 A1 claims, examples<br>KR 10-2014-0090150 A<br>TW 201321901 A | |
| WO 2017/183612 A1 | 26.10.2017 | US 2019/0302616 A1 claims<br>CN 108885403 A<br>KR 10-2018-0135887 A<br>TW 201807503 A | |
| JP 2017-102420 A | 08.06.2017 | US 2016/0342088 A1 claims<br>KR 10-2016-0135669 A<br>TW 201704277 A | |
| JP 2008-26600 A | 07.02.2008 | (Family: none) | |
| JP 2014-174428 A | 22.09.2014 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004177668 A
- WO 2009008446 A
- WO 2018221575 A
- WO 2017183612 A
- JP 2019020570 A
- JP 2019165498 A


### Non-patent literature cited in the description


- **H. GOKAN ; S. ESHO ; Y. OHNISHI.** *J. Electrochem. Soc.: SOLID-STATE SCIENCE AND TECHNOLOGY,* 1983, 143-146
- **SPIE.** *Advances in Resist Technology,* 1984, vol. 469, 72-79